# EUROPEAN PATENT APPLICATION

(11) **EP 4 614 740 A1**
(43) Date of publication of application: **10.09.2025**
(21) Application number: 23885280.0
(22) Date of filing: 09.02.2023
(51) Int. Cl.: H01S 5/183

(54) **SURFACE-EMITTING LASER**

(30) Priority: 01.11.2022 JP 2022175664
(71) Applicant: Sony Semiconductor Solutions Corporation, Atsugi-shi, Kanagawa 243-0014 (JP)
(72) Inventor: NARUSE, Terukazu, Atsugi-shi, Kanagawa 243-0014 (JP); WATANABE, Yoshiaki, Atsugi-shi, Kanagawa 243-0014 (JP); IMAIZUMI, Satoshi, Kikuchi-gun, Kumamoto 869-1102 (JP); KUDO, Hiroki, Kikuchi-gun, Kumamoto 869-1102 (JP); YAMAUCHI, Yoshinori, Atsugi-shi, Kanagawa 243-0014 (JP); TSUHARA, Daiki, Kikuchi-gun, Kumamoto 869-1102 (JP); WATANABE, Yoshiaki, Atsugi-shi, Kanagawa 243-0014 (JP)
(74) Representative: D Young & Co LLP
(86) International application number: PCT/JP2023/004352
(87) International publication number: WO 2024/095504

(57) **Abstract**

To provide a surface emitting laser capable of stabilizing a lateral mode while suppressing a decrease in productivity.

A surface emitting laser according to the present technology includes a first structure including a substrate, and a second structure provided on the first structure. The second structure includes a first reflector, a second reflector, an active layer disposed between the first and second reflectors, and an optical confinement layer disposed between a surface of the second reflector on a side opposite to the active layer side and the active layer. The optical confinement layer has a high refractive index region and a low refractive index region and surrounding the high refractive index region. Each of the second structure and the high refractive index region has a longitudinal direction and a lateral direction in plan view. A first ratio that is a ratio of a length in a longitudinal direction to a length in a lateral direction of the high refractive index region and a second ratio that is a ratio of a length in a longitudinal direction to a length in a lateral direction of the second structure are both more than 1.00 and less than 2.00. The first ratio is larger than the second ratio.

## Description

### TECHNICAL FIELD

The technology according to the present disclosure (hereinafter also referred to as "the present technology") relates to a surface emitting laser.

### BACKGROUND ART

Conventionally, vertical cavity surface emitting lasers (VCSEL) are known.

Among the surface emitting lasers, there is a surface emitting laser in which a resonator having shape anisotropy is provided on a substrate to stabilize a lateral mode (see, for example, Patent Documents 1 and 2).

For example, in the surface emitting lasers described in Patent Documents 1 and 2, both a resonator and an aperture (high refractive index region) of an optical confinement layer included in the resonator have relatively large shape anisotropy.

### CITATION LIST

### PATENT DOCUMENT

Patent Document 1: Japanese Patent Application Laid-Open No. 2021-22679
Patent Document 2: Japanese Patent Application Laid-Open No. 2019-212669

### SUMMARY OF THE INVENTION

### PROBLEMS TO BE SOLVED BY THE INVENTION

However, for example, in the surface emitting lasers described in Patent Documents 1 and 2, there is room for improvement regarding stabilization of the lateral mode while suppressing a decrease in productivity.

Therefore, a main object of the present technology is to provide a surface emitting laser capable of stabilizing the lateral mode while suppressing a decrease in productivity.

### SOLUTIONS TO PROBLEMS

The present technology provides a surface emitting laser including:
a first structure including a substrate; and
a second structure provided on the first structure, in which
the second structure includes:
   at least a part of a first reflector;
   a second reflector stacked with the first reflector;
   an active layer disposed between the first and second reflectors; and
   an optical confinement layer disposed between a surface of the first reflector on a side opposite to the active layer side and the active layer and/or between a surface of the second reflector on a side opposite to the active layer side and the active layer,
   the optical confinement layer has a high refractive index region having a relatively high refractive index and a low refractive index region having a relatively low refractive index and surrounding the high refractive index region,
   each of the second structure and the high refractive index region has a longitudinal direction and a lateral direction in plan view,
   a first ratio that is a ratio of a length in a longitudinal direction to a length in a lateral direction of the high refractive index region and a second ratio that is a ratio of a length in a longitudinal direction to a length in a lateral direction of the second structure are both more than 1.00 and less than 2.00, and
   the first ratio is larger than the second ratio.

The first ratio may be 1.75 or less.

The first ratio may be 1.15 or more.

The first ratio may be 1.15 or more and 1.75 or less.

The second ratio may be 1.50 or less.

The second ratio may be 1.05 or more.

The second ratio may be 1.05 or more and 1.50 or less.

The high refractive index region may have a symmetrical shape with respect to each of a longitudinal direction and a lateral direction of the high refractive index region in plan view.

The second structure may have a symmetrical shape with respect to each of a longitudinal direction and a lateral direction of the second structure in plan view.

A longitudinal direction or a lateral direction of the second structure may extend in a direction along a crystal orientation <0 1 -1> of the substrate.

Area centroids of the second structure and the high refractive index region may not coincide with each other.

A first shift amount that is a shift amount of area centroids of the second structure and the high refractive index region in a longitudinal direction of the second structure may be larger than a second shift amount that is a shift amount of area centroids of the second structure and the high refractive index region in the lateral direction of the second structure.

The first shift amount may be 0.20 µm or more, and the second shift amount may be 0.10 µm or less.

A cross section of the second structure may not have a straight line portion and/or a top portion.

An angle formed by the second structure and the high refractive index region in a longitudinal direction in plan view may be 10° or less.

A high resistance region surrounding the high refractive index region may be provided in the second structure and/or the first structure.

An inner edge of the high resistance region may have a longitudinal direction and a lateral direction in plan view, and a ratio of a length in a longitudinal direction to a length in a lateral direction of the inner edge may be more than 1.00 and 1.10 or less.

A low dielectric constant region surrounding the second structure may be further included.

The low dielectric constant region may include a circumferential-shaped first portion surrounding the second structure, and a second portion having a circling portion disposed on the second structure. An inner edge of the circling portion may have a longitudinal direction and a lateral direction in plan view. A ratio of a length in a longitudinal direction to a length in a lateral direction of the inner edge may be more than 1.00 and 1.10 or less.

The optical confinement layer may be an oxidation constriction layer.

### BRIEF DESCRIPTION OF DRAWINGS

Figs. 1A and 1B are cross-sectional views (Part 1 and Part 2) of a surface emitting laser according to Example 1 of a first embodiment of the present technology, respectively.
Fig. 2 is a plan view of a surface emitting laser according to Example 1 of the first embodiment of the present technology.
Fig. 3 is a flowchart for explaining an example of a method for manufacturing the surface emitting laser in Fig. 1A to Fig. 2.
Figs. 4A and 4B are cross-sectional views (Part 1 and Part 2) for each process of the example of the method for manufacturing the surface emitting laser in Fig. 1A to Fig. 2.
Figs. 5A and 5B are cross-sectional views (Part 1 and Part 2) for each process of the example of the method for manufacturing the surface emitting laser in Fig. 1A to Fig. 2.
Figs. 6A and 6B are cross-sectional views (Part 1 and Part 2) for each process of the example of the method for manufacturing the surface emitting laser in Fig. 1A to Fig. 2.
Figs. 7A and 7B are cross-sectional views (Part 1 and Part 2) for each process of the example of the method for manufacturing the surface emitting laser in Fig. 1A to Fig. 2.
Figs. 8A and 8B are cross-sectional views (Part 1 and Part 2) for each process of the example of the method for manufacturing the surface emitting laser in Fig. 1A to Fig. 2.
Figs. 9A and 9B are cross-sectional views (Part 1 and Part 2) for each process of the example of the method for manufacturing the surface emitting laser in Fig. 1A to Fig. 2.
Figs. 10A and 10B are cross-sectional views (Part 1 and Part 2) for each process of the example of the method for manufacturing the surface emitting laser in Fig. 1A to Fig. 2.
Fig. 11 is a plan view of a surface emitting laser according to Example 2 of the first embodiment of the present technology.
Fig. 12 is a plan view of a surface emitting laser according to Example 3 of the first embodiment of the present technology.
Fig. 13 is a plan view of a surface emitting laser according to Example 4 of the first embodiment of the present technology.
Fig. 14 is a plan view of a surface emitting laser according to Example 5 of the first embodiment of the present technology.
Fig. 15 is a plan view of a surface emitting laser according to Example 6 of the first embodiment of the present technology.
Fig. 16 is a plan view of a surface emitting laser according to Example 7 of the first embodiment of the present technology.
Fig. 17 is a plan view of a surface emitting laser according to Example 8 of the first embodiment of the present technology.
Fig. 18 is a plan view of a surface emitting laser according to Example 9 of the first embodiment of the present technology.
Fig. 19 is a plan view of a surface emitting laser according to Example 10 of the first embodiment of the present technology.
Fig. 20 is a plan view of a surface emitting laser according to Example 11 of the first embodiment of the present technology.
Fig. 21 is a cross-sectional view (Part 1) of a surface emitting laser according to Example 1 of a second embodiment of the present technology.
Fig. 22 is a cross-sectional view (Part 2) of the surface emitting laser according to Example 1 of the second embodiment of the present technology.
Fig. 23 is a cross-sectional view (Part 3) of the surface emitting laser according to Example 1 of the second embodiment of the present technology.
Fig. 24 is a plan view of the surface emitting laser according to Example 1 of the second embodiment of the present technology.
Fig. 25 is a flowchart for explaining an example of a method for manufacturing the surface emitting laser in Fig. 21 to Fig. 24.
Figs. 26A and 26B are cross-sectional views for each process of the example of the method for manufacturing the surface emitting laser in Fig. 21 to Fig. 24.
Figs. 27A and 27B are cross-sectional views for each process of the example of the method for manufacturing the surface emitting laser in Fig. 21 to Fig. 24.
Figs. 28A and 28B are cross-sectional views for each process of the example of the method for manufacturing the surface emitting laser in Fig. 21 to Fig. 24.
Figs. 29A and 29B are cross-sectional views for each process of the example of the method for manufacturing the surface emitting laser in Fig. 21 to Fig. 24.
Figs. 30A and 30B are cross-sectional views for each process of the example of the method for manufacturing the surface emitting laser in Fig. 21 to Fig. 24.
Fig. 31 is a cross-sectional view for each process of the example of the method for manufacturing the surface emitting laser illustrated in Fig. 21 to Fig. 24.
Figs. 32A and 32B are cross-sectional views (Part 1 and Part 2) for each process of the example of the method for manufacturing the surface emitting laser in Fig. 21 to Fig. 24.
Figs. 33A and 33B are cross-sectional views for each process of the example of the method for manufacturing the surface emitting laser in Fig. 21 to Fig. 24.
Figs. 34A and 34B are cross-sectional views for each process of the example of the method for manufacturing the surface emitting laser in Fig. 21 to Fig. 24.
Figs. 35A and 35B are cross-sectional views for each process of the example of the method for manufacturing the surface emitting laser in Fig. 21 to Fig. 24.
Fig. 36 is a plan view of the surface emitting laser according to Example 2 of the second embodiment of the present technology.
Fig. 37 is a cross-sectional view (Part 1) of the surface emitting laser according to Example 3 of the second embodiment of the present technology.
Fig. 38 is a cross-sectional view (Part 2) of the surface emitting laser according to Example 3 of the second embodiment of the present technology.
Fig. 39 is a plan view of the surface emitting laser according to Example 3 of the second embodiment of the present technology.
Fig. 40A is a plan view of a surface emitting laser according to Example 4 of the second embodiment of the present technology. Fig. 40B is a bottom view of the surface emitting laser according to Example 4 of the second embodiment of the present technology.
Figs. 41A and 41B are cross-sectional views (Part 1 and Part 2) of a surface emitting laser according to a first modification of the first embodiment of the present technology.
Figs. 42A and 42B are cross-sectional views (Part 1 and Part 2) of a surface emitting laser according to a second modification of the first embodiment of the present technology.
Figs. 43A and 43B are cross-sectional views (Part 1 and Part 2) of a surface emitting laser according to a third modification of the first embodiment of the present technology.
Figs. 44A and 44B are cross-sectional views (Part 1 and Part 2) of a surface emitting laser according to a fourth modification of the first embodiment of the present technology.
Figs. 45A and 45B are cross-sectional views (Part 1 and Part 2) of a surface emitting laser according to a fifth modification of the first embodiment of the present technology.
Figs. 46A and 46B are cross-sectional views (Part 1 and Part 2) of a surface emitting laser according to a sixth modification of the first embodiment of the present technology.
Figs. 47A and 47B are cross-sectional views (Part 1 and Part 2) of a surface emitting laser according to a seventh modification of the first embodiment of the present technology.
Figs. 48A and 48B are cross-sectional views (Part 1 and Part 2) of a surface emitting laser according to an eighth modification of the first embodiment of the present technology.
Figs. 49A and 49B are cross-sectional views (Part 1 and Part 2) of a surface emitting laser array according to a ninth modification of the first embodiment of the present technology.
Fig. 50 is a plan view of the surface emitting laser array according to the ninth modification of the first embodiment of the present technology.
Fig. 51 is a cross-sectional view (Part 1) of a surface emitting laser according to a first modification of the second embodiment of the present technology.
Fig. 52 is a cross-sectional view (Part 2) of the surface emitting laser according to the first modification of the second embodiment of the present technology.
Fig. 53 is a plan view of the surface emitting laser according to the first modification of the second embodiment of the present technology.
Fig. 54 is a flowchart for explaining an example of a method for manufacturing the surface emitting laser in Fig. 51 to Fig. 53.
Figs. 55A and 55B are cross-sectional views for each process of the example of the method for manufacturing the surface emitting laser in Fig. 51 to Fig. 53.
Figs. 56A and 56B are cross-sectional views for each process of the example of the method for manufacturing the surface emitting laser in Fig. 51 to Fig. 53.
Figs. 57A and 57B are cross-sectional views for each process of the example of the method for manufacturing the surface emitting laser in Fig. 51 to Fig. 53.
Fig. 58 is a cross-sectional view for each process of the example of the method for manufacturing the surface emitting laser illustrated in Fig. 51 to Fig. 53.
Figs. 59A and 59B are cross-sectional views for each process of the example of the method for manufacturing the surface emitting laser in Fig. 51 to Fig. 53.
Figs. 60A and 60B are cross-sectional views for each process of the example of the method for manufacturing the surface emitting laser in Fig. 51 to Fig. 53.
Fig. 61 is a cross-sectional view (Part 1) of a surface emitting laser according to a second modification of the second embodiment of the present technology.
Fig. 62 is a cross-sectional view (Part 2) of the surface emitting laser according to the second modification of the second embodiment of the present technology.
Fig. 63 is a plan view of the surface emitting laser according to the second modification of the second embodiment of the present technology.
Fig. 64 is a plan view of a surface emitting laser according to a third modification of the second embodiment of the present technology.
Fig. 65 is a graph illustrating a relationship between a mesa rotation angle and RIN.

### MODE FOR CARRYING OUT THE INVENTION

Hereinafter, preferred embodiments of the present technology will be described in detail with reference to the accompanying drawings. Note that, in the present specification and the drawings, components having substantially the same functional configurations are denoted by the same reference signs, and redundant descriptions are omitted. The embodiments described below illustrate representative embodiments of the present technology, and the scope of the present technology is not narrowly interpreted by these embodiments. In the present specification, even in a case where it is described that a surface emitting laser according to the present technology exhibits a plurality of effects, it is sufficient if the surface emitting laser according to the present technology exhibits at least one effect. The effects described in the present specification are merely examples and are not limited, and other effects may be exerted.

Furthermore, the description will be given in the following order.
0. Introduction
1. Surface Emitting Laser according to Example 1 of First Embodiment of Present Technology
2. Surface Emitting Laser according to Example 2 of First Embodiment of Present Technology
3. Surface Emitting Laser according to Example 3 of First Embodiment of Present Technology
4. Surface Emitting Laser according to Example 4 of First Embodiment of Present Technology
5. Surface Emitting Laser according to Example 5 of First Embodiment of Present Technology
6. Surface Emitting Laser according to Example 6 of First Embodiment of Present Technology
7. Surface Emitting Laser according to Example 7 of First Embodiment of Present Technology
8. Surface Emitting Laser according to Example 8 of First Embodiment of Present Technology
9. Surface Emitting Laser according to Example 9 of First Embodiment of Present Technology
10. Surface Emitting Laser according to Example 10 of First Embodiment of Present Technology
11. Surface Emitting Laser according to Example 11 of First Embodiment of Present Technology
12. Surface Emitting Laser according to Example 1 of Second Embodiment of Present Technology
13. Surface Emitting Laser according to Example 2 of Second Embodiment of Present Technology
14. Surface Emitting Laser according to Example 3 of Second Embodiment of Present Technology
15. Surface Emitting Laser according to Example 4 of Second Embodiment of Present Technology
16. Modifications of Present Technology

### <0. Introduction>

Conventionally, for example, a surface emitting laser in which a plurality of components including a first multilayer film reflector, an active layer, an oxidation constriction layer for setting a current injection region (light emitting region) of the active layer, and a second multilayer film reflector for generating optical resonance with the first multilayer film reflector are stacked on a substrate is known.

In this surface emitting laser, a multilayer body in which the first multilayer film reflector, the active layer, an oxidized layer which is a material of the oxidation constriction layer, and the second multilayer film reflector are stacked on the substrate is etched to form a mesa that exposes a side surface of the oxidized layer, and the oxidized layer is partially oxidized from an outer periphery of the mesa to form an oxidation constriction layer that surrounds a non-oxidized region in an oxidized region. In this surface emitting laser, current is injected into a current injection region set in the oxidation constriction layer via an electrode to cause the active layer to emit light by current excitation, and laser oscillation occurs in a resonator including the first and second multilayer film reflectors and the active layer.

In such a surface emitting laser, the oxidized region in the peripheral portion becomes a region having a refractive index lower than that of the non-oxidized region in the central portion in the oxidation constriction layer with a decrease in refractive index in a process in which the oxidized layer as a material is oxidized. The lateral distribution of the refractive index has a structure in which light is confined in a region having a high refractive index in the central portion of the mesa, and realizes high optical confinement to the active layer three-dimensionally together with a resonator that confines light in the longitudinal direction. For this reason, oscillation in various lateral modes occurs, but since the fluctuation of the lateral mode is greatly involved in the transmission characteristics, stabilization of the lateral mode is emphasized in the surface emitting laser.

In order to stabilize the lateral mode, conventionally, for example, as disclosed in Patent Document 1, the mesa shape is formed into an elliptical shape (the mesa cross-sectional shape has a major axis and a minor axis orthogonal to each other, and the ratio of the lengths of the major axis and the minor axis is twice or more) having extreme shape anisotropy, or as disclosed in Patent Document 2, the mesa cross-sectional shape is formed into a semi-cylindrical shape having extreme anisotropy, so that the refractive index distribution for optical confinement has anisotropy to stabilize the lateral mode.

However, since a surface emitting laser having a mesa having such extreme shape anisotropy causes a large asymmetric phenomenon in its manufacturing process, variations in characteristics due to variations in height around the mesa, variations in film thickness of a layer constituting the mesa, and the like increase. Therefore, reliability is lowered, and consequently productivity (yield) is lowered.

Therefore, after intensive studies, the inventors have developed the surface emitting laser according to the present technology as a surface emitting laser capable of stabilizing the lateral mode while suppressing a decrease in productivity.

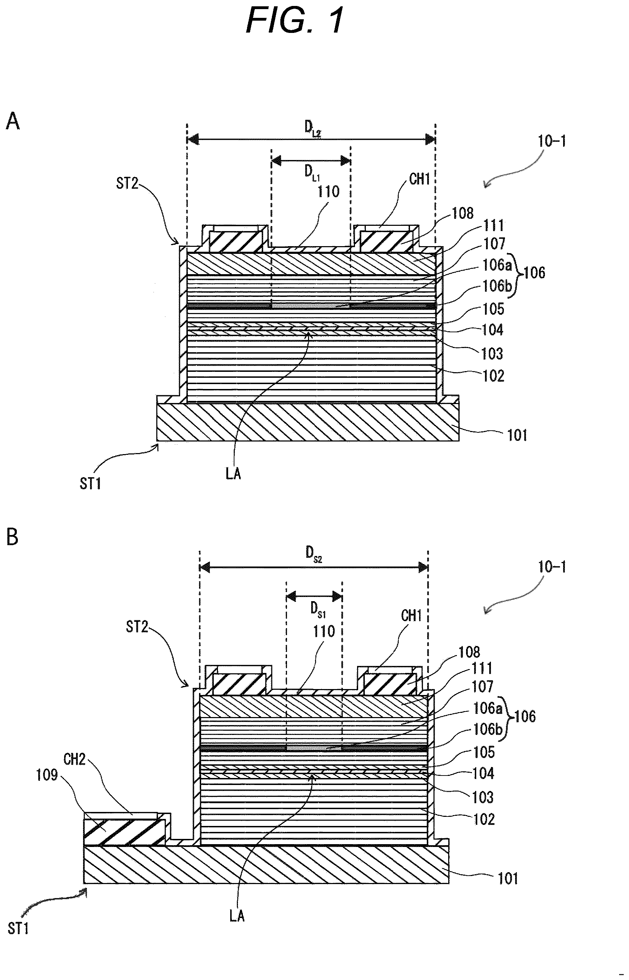

Hereinafter, some embodiments of a surface emitting laser according to the present technology will be described. Hereinafter, for the sake of convenience, the upper part in the cross-sectional view of Fig. 1 and the like will be described as an upper side, and the lower part in the cross-sectional view of Fig. 1 and the like will be described as a lower side.

### <1. Surface Emitting Laser according to Example 1 of First Embodiment of Present Technology>

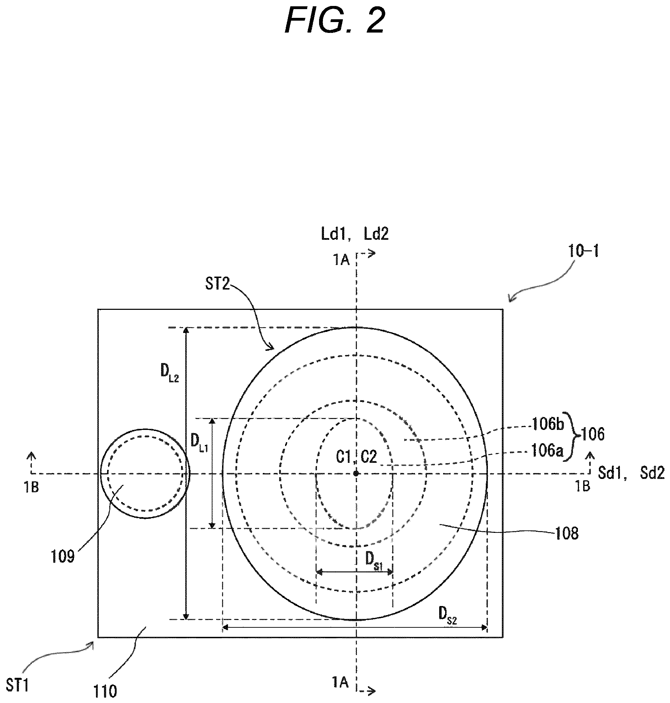

Figs. 1A and 1B are cross-sectional views (Part 1 and Part 2) of a surface emitting laser 10-1 according to Example 1 of a first embodiment of the present technology, respectively. Fig. 2 is a plan view of the surface emitting laser 10-1. Fig. 1A is a cross-sectional view taken along line 1A-1A in Fig. 2. Fig. 1B is a cross-sectional view taken along line 1B-1B in Fig. 2.

### <<Configuration of Surface Emitting Laser>>

### (Overall Configuration)

The surface emitting laser 10-1 according to Example 1 of the first embodiment of the present technology is a vertical cavity surface emitting laser (VCSEL). The surface emitting laser 10-1 is driven by, for example, a laser driver.

As an example, as illustrated in Figs. 1A, 1B, and 2, the surface emitting laser 10-1 includes a first structure ST1 including a substrate 101 and a second structure ST2 provided (stacked) on the first structure ST1. Hereinafter, a direction in which the first and second structures ST1 and ST2 are stacked (vertical direction) is also referred to as a "layering direction".

As an example, the first structure ST1 includes the substrate 101. As an example, the second structure ST2 is a mesa structure provided on the substrate 101. Note that the first structure ST1 may have a buffer layer on the substrate 101.

The second structure ST2 includes a first reflector 102, a second reflector 107 stacked with the first reflector 102, an active layer 104 disposed between the first and second reflectors 102 and 107, and an oxidation constriction layer 106 as an optical confinement layer disposed between a surface of the second reflector 107 on a side opposite to the active layer 104 side and the active layer 104. As an example, the oxidation constriction layer 106 is provided inside the second reflector 107.

That is, the surface emitting laser 10-1 include a resonator in which the active layer 104 is sandwiched between the first and second reflectors 102 and 107 stacked on each other.

The second structure ST2 further includes, as an example, a first cladding layer 103 disposed between the first reflector 102 and the active layer 104, a second cladding layer 105 disposed between the active layer 104 and the second reflector 107, and a contact layer 111 disposed on the second reflector 107. A ring-shaped (annular) anode electrode 108 is provided on the contact layer 111. A cathode electrode 109 is provided on a region around the second structure ST2 on the upper surface (surface on the second structure ST2 side) of the substrate 101. Note that a highly doped semiconductor layer (for example, a highly doped n-GaAs layer) as a contact layer may be provided between the substrate 101 and the cathode electrode 109.

Each of the substrate 101, the second structure ST2, the anode electrode 108, and the cathode electrode 109 is at least partially covered with an insulation film 110. A contact hole CH1 for exposing the anode electrode 108 is provided in a portion of the insulation film 110 corresponding to the anode electrode 108. A contact hole CH2 for exposing the cathode electrode 109 is provided in a portion of the insulation film 110 corresponding to the cathode electrode 109.

### (Substrate)

As an example, the substrate 101 includes a conductive GaAs substrate (n-GaAs substrate).

### (First Reflector)

The first reflector 102 is, for example, a semiconductor multilayer film reflector. The multilayer film reflector is also referred to as a distributed Bragg reflector (DBR). The first reflector 102 is a semiconductor multilayer film reflector (semiconductor multilayer film reflector including an impurity semiconductor) of a first conductivity type (for example, n-type). As an example, the first reflector 102 includes a compound semiconductor (GaAs-based compound semiconductor) lattice-matched with GaAs. More specifically, the first reflector 102 has, as an example, a stacked structure in which a high refractive index layer (for example, n-GaAs) and a low refractive index layer (for example, n-AlGaAs) are alternately stacked. The optical thickness of each refractive index layer is 1/4 of the oscillation wavelength λ of the surface emitting laser 10-1.

### (First Cladding Layer)

As an example, the first cladding layer 103 includes a GaAs-based compound semiconductor (for example, n-AlGaAs) of the first conductivity type (for example, n-type). The "cladding layer" is also referred to as a "spacer layer".

### (Active Layer)

As an example, the active layer 104 has a quantum well structure including a barrier layer including a GaAs-based compound semiconductor (for example, InGaAs) and a quantum well layer designed to have an emission wavelength of 780 to 950 nm. This quantum well structure may be a single quantum well structure (QW structure) or a multiple quantum well structure (MQW structure). Note that the active layer 104 may have multiple QW structures or multiple MQW structures stacked via tunnel junctions. In the active layer 104, a region (for example, a central region) corresponding to a high refractive index region 106a of the oxidation constriction layer 106 to be described later is a light emitting region LA (current injection region). The active layer 104 is preferably disposed at a position of an antinode of a standing wave generated in the resonator or in the vicinity thereof (a position where light intensity is high).

### (Second Cladding Layer)

The second cladding layer 105 is formed by a GaAs-based compound semiconductor (for example, p-AlGaAs) of a second conductivity type (for example, p-type). The "cladding layer" is also referred to as a "spacer layer".

### (Second Reflector)

The second reflector 107 is, for example, a semiconductor multilayer film reflector. The second reflector 107 is a semiconductor multilayer film reflector (semiconductor multilayer film reflector including an impurity semiconductor) of the second conductivity type (for example, p-type). As an example, the second reflector 107 includes a compound semiconductor (GaAs-based compound semiconductor) lattice-matched with GaAs. The second reflector 107 has a stacked structure in which a high refractive index layer (for example, p-GaAs) and a low refractive index layer (for example, p-AlGaAs) are alternately stacked. The optical thickness of each refractive index layer is, for example, 1/4 of the oscillation wavelength λ. The reflectivity of the second reflector 107 is set slightly lower than that of the first reflector 102. That is, as an example, the surface emitting laser 10-1 is a front-surface emitting type of surface emitting laser that emits laser light toward the front surface (upper surface) of the substrate 101. Note that, by setting the reflectivity of the second reflector 107 to be slightly higher than the reflectivity of the first reflector 102, it is also possible to configure a back-surface emitting type of surface emitting laser that emits laser light to the back surface (lower surface) side of the substrate 101.

### (Optical Confinement Layer)

The oxidation constriction layer 106 as an optical confinement layer has a high refractive index region 106a having a relatively high refractive index and a low refractive index region 106b surrounding the high refractive index region 106a and having a relatively low refractive index. The high refractive index region 106a is, for example, a non-oxidized region (for example, an AlAs layer or an AlGaAs layer). The low refractive index region 106b is, for example, an oxidized region (for example, an AlₓO_{y} layer). Since the oxidized region as the low refractive index region 106b has higher resistance than the non-oxidized region as the high refractive index region 106a, the oxidation constriction layer 106 also functions as a current confinement layer (current constriction layer) that sets a light emitting region (current injection region) of the active layer 104. That is, the non-oxidized region as the high refractive index region 106a is also a low resistance region having a relatively low resistance, and the oxidized region as the low refractive index region 106b is also a high resistance region having a relatively high resistance. The oxidation constriction layer 106 is preferably disposed at a position of a node of a standing wave generated in the resonator or in the vicinity thereof (a position with low light intensity).

### (Contact Layer)

The contact layer 111 has a function (current injection efficiency improvement function) of easily injecting the current flowing into the second structure ST2 through the anode electrode 108 into the active layer 104. The contact layer 111 is also referred to as a "current injection layer". The contact layer 111 is a highly doped layer (low resistance layer having high carrier conductivity), which is a compound semiconductor layer highly doped with impurities. Here, the contact layer 111 includes p-GaAs doped with a p-type impurity (for example, C) at a high concentration.

### (Insulation Film)

The insulation film 110 is a protective film (passivation film) including a dielectric such as SiO2, SiN, or SiON.

### (Anode Electrode)

The anode electrode 108 is provided in a ring shape (annular shape) on the second structure ST2 (specifically, on the contact layer 111) so as to surround the light emitting region LA of the active layer 104 in plan view (hereinafter, also referred to as "viewed from the layering direction"). As an example, the anode electrode 108 has a stacked structure of AuGe/Ni/Au. In the stacked structure, AuGe, Ni, and Au have film thicknesses of 150 nm, 50 nm, and 200 nm, respectively, as an example. Note that the anode electrode 108 may have a single-layer structure. Here, the inner diameter of the anode electrode 108 is set to 12.6 µm, and the outer diameter is set to 18.0 µm. An inner diameter side of the anode electrode 108 is an emission port. A portion of the anode electrode 108 exposed through the contact hole CH1 is connected to the anode side of the laser driver.

### (Cathode Electrode)

As an example, the cathode electrode 109 is provided on the substrate 101 in a substantially circular shape in plan view. The cathode electrode 109 has a stacked structure of Ti/Pt/Au. In the stacked structure, Ti, Pt, and Au have film thicknesses of 50 nm, 100 nm, and 200 nm, respectively, as an example. Note that the cathode electrode 109 may have a single-layer structure. A portion of the cathode electrode 109 exposed through the contact hole CH2 is connected to the cathode side of the laser driver.

### (Details of Second Structure and Optical Confinement Layer)

As illustrated in Figs. 1A, 1B, and 2, each of the second structure ST2 and the high refractive index region 106a of the oxidation constriction layer 106 has a longitudinal direction and a lateral direction in plan view. That is, both the second structure ST2 and the high refractive index region 106a have shape anisotropy (asymmetry) in plan view.

The second structure ST2 has a symmetrical shape (for example, a closed curve shape) with respect to each of the longitudinal direction and the lateral direction of the second structure ST2 in plan view. In this case, since the second structure ST2 has extremely low shape nonuniformity (asymmetry) in each of the longitudinal direction and the lateral direction, it is possible to suppress variations in height around the mesa, variations in film thickness on the mesa side surface of the insulation film 110, and the like in the manufacturing process.

The high refractive index region 106a has a symmetrical shape (for example, a closed curve shape) with respect to each of the longitudinal direction and the lateral direction of the high refractive index region 106a in plan view. Such an axisymmetric shape is resistant to shape variations due to the manufacturing process and enables stable manufacturing.

More specifically, each of the second structure ST2 and the high refractive index region 106a has an elliptical shape in plan view. More specifically, the second structure ST2 has an elliptical columnar shape and has a major axis and a minor axis. The high refractive index region 106a has an elliptical plate shape and has a major axis and a minor axis.

Both the second structure ST2 and the high refractive index region 106a have relatively small shape anisotropy (asymmetry). Specifically, both a first ratio r1, which is the ratio D_{L1}/D_{S1} of a length D_{L1} in a longitudinal direction Ld1 to a length D_{S1} in a lateral direction Sd1 of the high refractive index region 106a, and a second ratio r2, which is the ratio D_{L2}/D_{S2} of a length D_{L2} in a longitudinal direction Ld2 to a length D_{S2} in a lateral direction Sd2 of the second structure ST2, are more than 1.00 and less than 2.00. The high refractive index region 106a has larger shape anisotropy than the second structure ST2. Specifically, the first ratio r1 is larger than the second ratio r2.

Here, an area centroid C1 of the high refractive index region 106a and an area centroid C2 of the second structure ST2 coincide with each other. The area centroids C1 and C2 coincide with the center of the anode electrode 108 in plan view. Here, the second structure ST2 and the high refractive index region 106a have the same longitudinal direction (major axis direction) and the same lateral direction (minor axis direction) in plan view.

Normally, in the oxidation processing of forming the oxidation constriction layer on the (100) substrate, since the oxidized layer, which is a material, is oxidized at a substantially uniform oxidation rate (oxidation rate) from all directions, that is, there is no anisotropy in the oxidation rate, the first ratio r1 increases as the second ratio r2 increases. Conversely, there is a premise that the second ratio r2 increases as the first ratio r1 increases.

The inventors have found that the larger the shape anisotropy (specifically, the first and second ratios r1 and r2) of the second structure ST2 and the high refractive index region 106a is, the more the lateral mode can be stabilized, but since an asymmetric phenomenon occurs largely in the manufacturing process, a variation in characteristics due to a variation in height around the mesa structure as the second structure ST2, a variation in film thickness of a layer constituting the mesa structure, or the like becomes large, leading to deterioration of productivity (yield). That is, the inventors have found that there is a trade-off relationship between the lateral mode stabilization and the suppression of decrease in productivity with respect to the magnitude of the shape anisotropy (asymmetry). The inventors have intensively studied the magnitude of shape anisotropy of the second structure ST2 and the high refractive index region 106a on the basis of this new finding, and have concluded that it is difficult to substantially suppress a decrease in productivity when at least one of the first and second ratios r1 and r2 is 2.00 or more.

The inventors have obtained confidence that the lateral mode can be stabilized while suppressing the decrease in productivity by setting both the first and second ratios r1 and r2 to more than 1.00 and less than 2.00 as described above. Moreover, the inventors have intensively studied the magnitude relationship of the shape anisotropy of the second structure ST2 and the high refractive index region 106a, and as described above, it is possible to relatively increase the shape anisotropy (asymmetry) of the high refractive index region 106a while relatively reducing the shape anisotropy (asymmetry) of the second structure ST2 by making the first ratio r1 larger than the second ratio r2, and the inventors have succeeded in stabilizing the lateral mode (achieving both lateral mode stabilization and suppression of decrease in productivity) while suppressing decrease in productivity (yield).

### (Regarding First Ratio)

The first ratio r1 is preferably 1.75 or less, and more preferably 1.50 or less. As the first ratio r1 is smaller, the second ratio r2 is also smaller, and the suppression of decrease in productivity can be promoted.

The first ratio r1 is preferably 1.15 or more, and more preferably 1.25 or more. As the first ratio r1 is larger, the lateral mode stabilization can be promoted.

The first ratio r1 is preferably 1.15 or more and 1.75 or less. Therefore, this makes it possible to achieve both lateral mode stabilization and suppression of decrease in productivity at a high level.

The first ratio r1 may be 1.15 or more and 1.50 or less in order to achieve both the lateral mode stabilization and the suppression of decrease in productivity at a high level while focusing on the suppression of decrease in productivity.

The first ratio r1 may be 1.25 or more and 1.75 or less in order to achieve both the lateral mode stabilization and the suppression of decrease in productivity at a high level while focusing on the lateral mode stabilization.

The first ratio r1 is preferably 1.25 or more and 1.50 or less. Therefore, this makes it possible to achieve both lateral mode stabilization and suppression of decrease in productivity at a higher level.

Here, as an example, the major axis length and the minor axis length of the high refractive index region 106a are set to 8.5 µm and 6.5 µm, respectively, and the first ratio r1 is 1.31. Note that, in consideration of variations in the oxidation rate when the oxidation constriction layer 106 is formed, any of the major axis length and the minor axis length of the high refractive index region 106a can be set to a suitable value as long as the error from the set value is within a range of ±0.50 µm.

### (Regarding Second Ratio)

The second ratio r2 is preferably 1.75 or less, and more preferably 1.50 or less. As the second ratio r2 is smaller, the suppression of decrease in productivity can be promoted.

The second ratio r2 is preferably 1.05 or more, and more preferably 1.08 or more. As the second ratio r2 is larger, the first ratio r1 is also larger, and the lateral mode stabilization can be promoted.

The second ratio r2 is preferably 1.05 or more and 1.75 or less. Therefore, this makes it possible to achieve both lateral mode stabilization and suppression of decrease in productivity at a high level.

The second ratio r2 may be 1.05 or more and 1.50 or less in order to achieve both the lateral mode stabilization and the suppression of decrease in productivity at a high level while focusing on the suppression of decrease in productivity.

The second ratio r2 may be 1.08 or more and 1.75 or less in order to achieve both the lateral mode stabilization and the suppression of decrease in productivity at a high level while focusing on the lateral mode stabilization.

The second ratio r2 is preferably 1.08 or more and 1.50 or less. Therefore, this makes it possible to achieve both lateral mode stabilization and suppression of decrease in productivity at a higher level.

Here, as an example, the length of the major axis of the second structure ST2 is set to 22 µm, the length of the minor axis is set to 20 µm, and the second ratio r1 is 1.10.

### (Regarding Shape of Cross Section of Second Structure)

The cross section (cross section perpendicular to the layering direction) of the second structure ST2 has an elliptical shape and does not have a straight portion and a top portion. Therefore, the film thickness uniformity and step coverage of the insulation film 110 as a protective film covering the mesa structure as the second structure ST2 are excellent, and it is possible to suppress defects (lack of cover and cracks) of the insulation film 110. As a result, a decrease in reliability can be suppressed, and eventually, the suppression of decrease in productivity can be promoted.

### <<Operation of Surface Emitting Laser>>

Hereinafter, the operation of the surface emitting laser 10-1 will be simply described. In the surface emitting laser 10-1, for example, the current supplied from the anode side of the laser driver and flowing in from the anode electrode 108 is injected into the light emitting region LA (current injection region) which is the central region of the active layer 104 via the contact layer 111, the second reflector 107 in which the oxidation constriction layer 106 is disposed, and the second cladding layer 105 in this order (narrowed in the oxidation constriction layer 106). At this time, the active layer 104 emits light, the light is confined between the first and second reflectors 102 and 107 by the oxidation constriction layer 106 and reciprocates while being amplified by the active layer 104, and when the oscillation condition is satisfied, the light is emitted as laser light from the emission port on the inner diameter side of the anode electrode 108. This laser light is in a stable lateral mode due to the effect of the asymmetry of the oxidation constriction layer 106. The current that has passed through the active layer 104 reaches the cathode electrode 109 through the first cladding layer 103, the first reflector 102, and the substrate 101 in this order, and flows out from the cathode electrode 109 to, for example, the cathode side of the laser driver.

### <<Method for Manufacturing Surface Emitting Laser>>

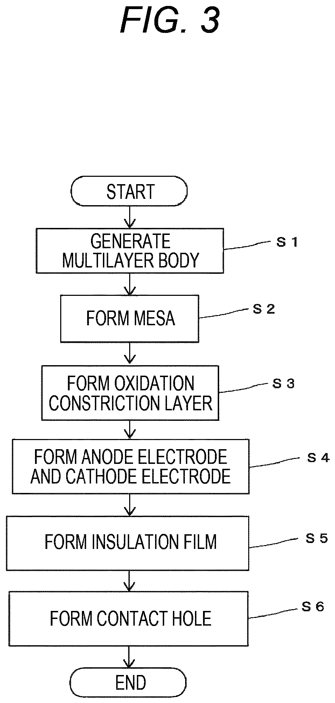

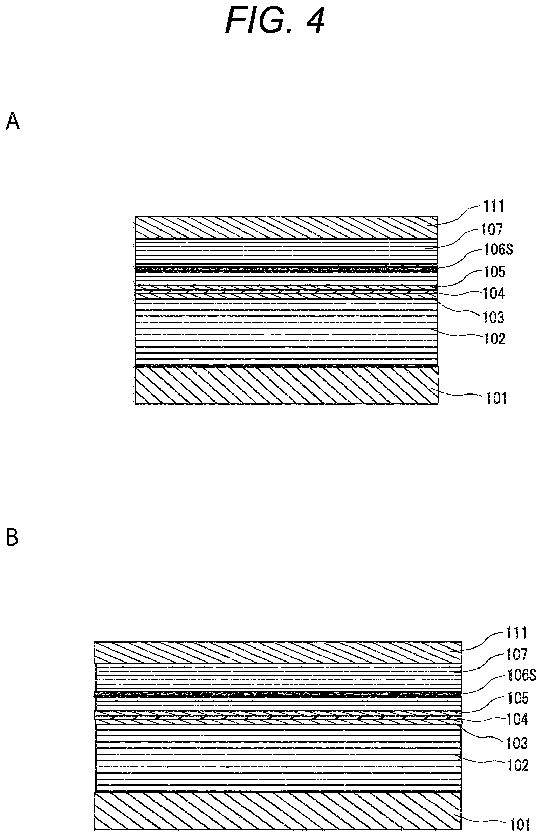

Hereinafter, a method for manufacturing the surface emitting laser 10-1 will be described with reference to the flowchart of Fig. 3 and the cross-sectional views of Figs. 4A to 10B. Fig. 4A, Fig. 5A, Fig. 6A, Fig. 7A, Fig. 8A, Fig. 9A, and Fig. 10A are all cross-sectional views corresponding to the cross section taken along line 1A-1A in Fig. 2. Fig. 4B, Fig. 5B, Fig. 6B, Fig. 7B, Fig. 8B, Fig. 9B, and Fig. 10B are all cross-sectional views corresponding to the cross section taken along line 1B-1B in Fig. 2.

Here, as an example, multiple surface emitting lasers 10-1 are simultaneously generated on one wafer (hereinafter also referred to as a "substrate 101" for convenience) which is a base material of the substrate 101 by a semiconductor manufacturing method using a semiconductor manufacturing apparatus. Next, the multiple continuous and integrated surface emitting lasers 10-1 are separated from each other to obtain multiple chip-shaped surface emitting lasers 10-1.

In the first step S1, a multilayer body is generated (see Figs. 4A and 4B). Specifically, for example, the first reflector 102, the first cladding layer 103, the active layer 104, the second cladding layer 105, the second reflector 107 in which an oxidized layer 106S (for example, an AlAs layer or an AlGaAs layer) which is a material of the oxidation constriction layer 106 is disposed, and the contact layer 111 are stacked in this order (for example, epitaxially grown at a growth temperature of 605°C) on the substrate 101 (for example, an n-GaAs substrate) as a growth substrate by a metal organic chemical vapor deposition (MOCVD) method to generate a multilayer body. Note that, when the MOCVD is performed, for example, trimethylgallium ((CH₃)₃Ga) is used as a source gas of gallium, for example, trimethylaluminum ((CH₃)₃A1) is used as a source gas of aluminum, for example, trimethylindium ((CH₃)₃In) is used as a source gas of indium, and for example, trimethylarsenic (((CH₃)₃As) is used as a source gas of As. Furthermore, as a source gas of silicon, for example, monosilane (SiH₄) is used, and as a source gas of carbon, for example, carbon tetrabromide (CBr₄) is used.

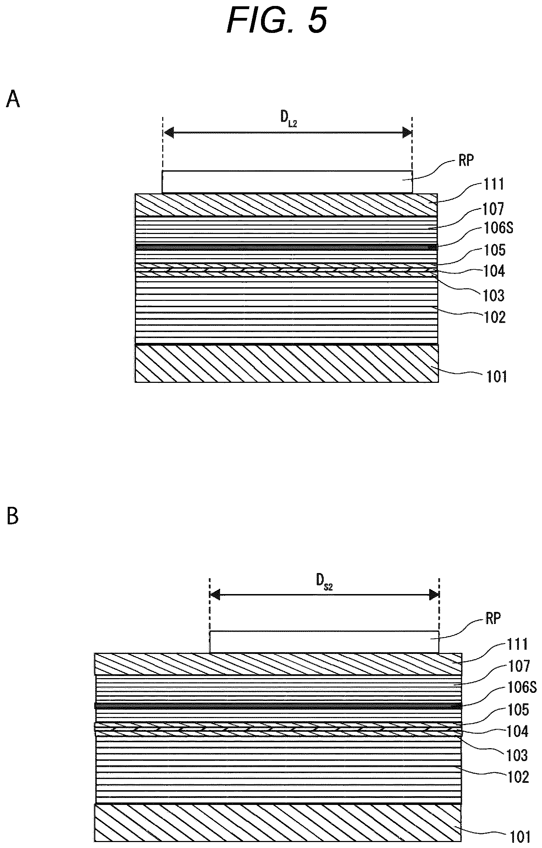

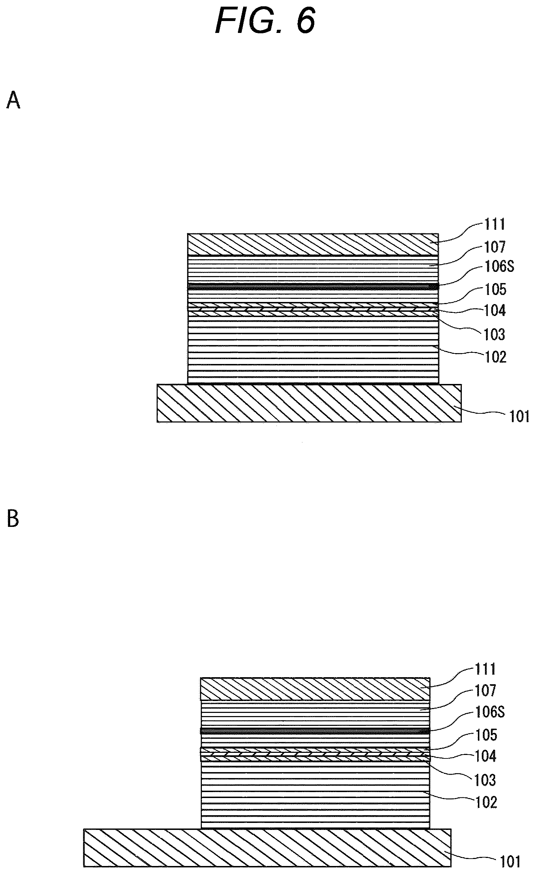

In the next step S2, a mesa to be the second structure ST2 is formed. Specifically, first, a resist pattern RP having an elliptical shape in plan view is formed by photolithography to cover a portion where the second structure ST2 is to be formed on the front surface (upper surface) of the multilayer body on the second reflector 107 side (see Figs. 5A and 5B). Next, using the resist pattern RP as a mask, the multilayer body is etched by inductively coupled plasma (ICP) dry etching using, for example, Cl₂, SiCl₄, or Ar until the substrate 101 is exposed, and a mesa having an elliptical shape (for example, an elliptical shape having a major axis length of 22 µm and a minor axis length of 20 µm) in plan view is formed on the substrate 101 (Figs. 6A and 6B). Thereafter, the resist pattern RP is removed.

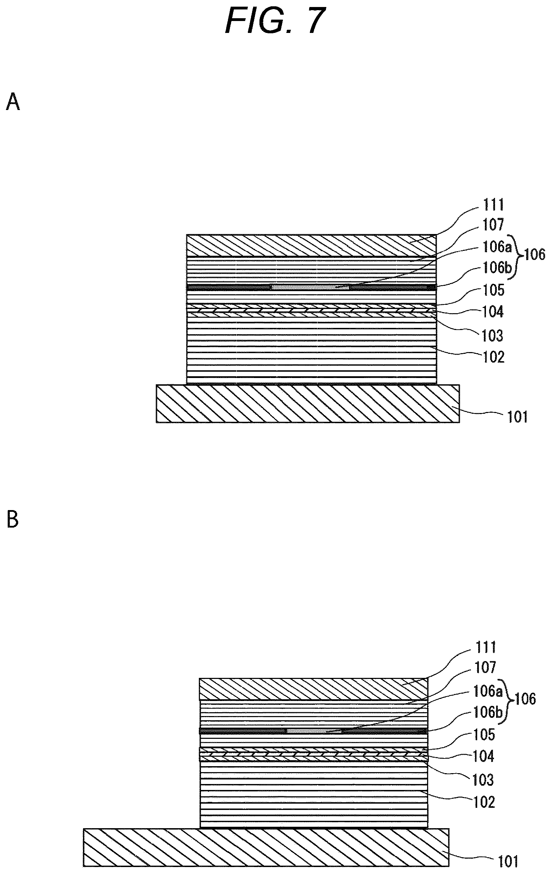

In the next step S3, the oxidation constriction layer 106 as an optical confinement layer is formed (see Figs. 7A and 7B). Specifically, the mesa having an elliptical shape in plan view formed in step S2 is exposed to a high-temperature water vapor atmosphere, and the oxidized layer 106S having a large Al composition is oxidized by a predetermined distance (for example, 6.75 µm) from the outer peripheral side toward the center side. As a result, the oxidation constriction layer 106 in which the non-oxidized region having an elliptical shape (for example, an elliptical shape having a major axis length of 8.5 µm and a minor axis length of 6.5 µm) in plan view as the high refractive index region 106a is surrounded by the oxidized region as the low refractive index region 106b is formed.

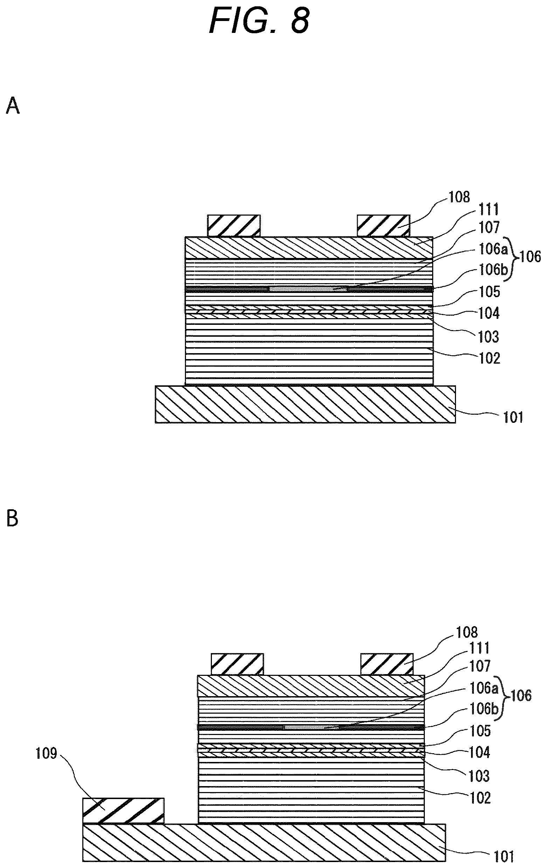

In the next step S4, the anode electrode 108 and the cathode electrode 109 are formed (see Figs. 8A and 8B). Specifically, for example, using a lift-off method, the anode electrode 108 is formed in a ring shape (for example, an inner diameter is 12.6 µm and an outer diameter is 18.0 µm) on the top portion of the mesa (specifically, on the contact layer 111) so as to surround the high refractive index region 106a in plan view, and the cathode electrode 109 is formed in a solid shape on a region around the mesa of the substrate 101. At this time, for example, vacuum deposition, sputtering, or the like is used for forming the electrode materials of the anode electrode 108 and the cathode electrode 109.

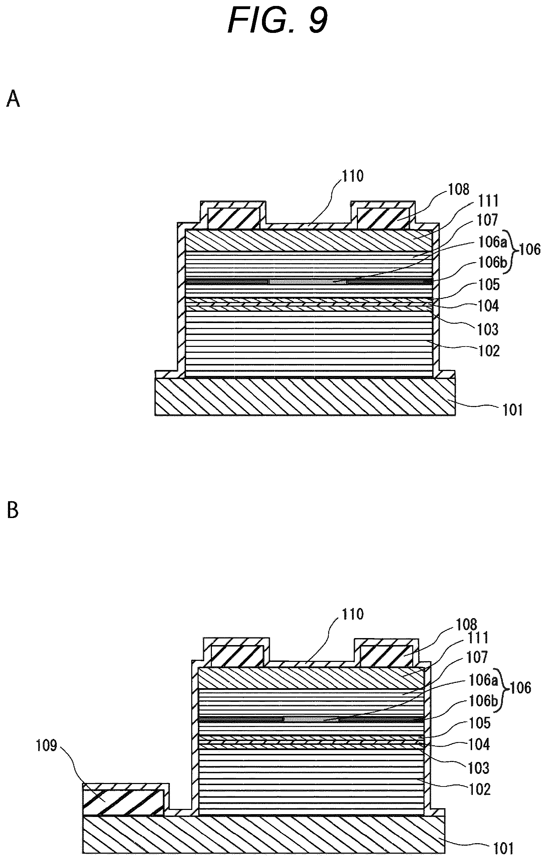

In the next step S5, the insulation film 110 is formed on the entire surface (see Figs. 9A and 9B).

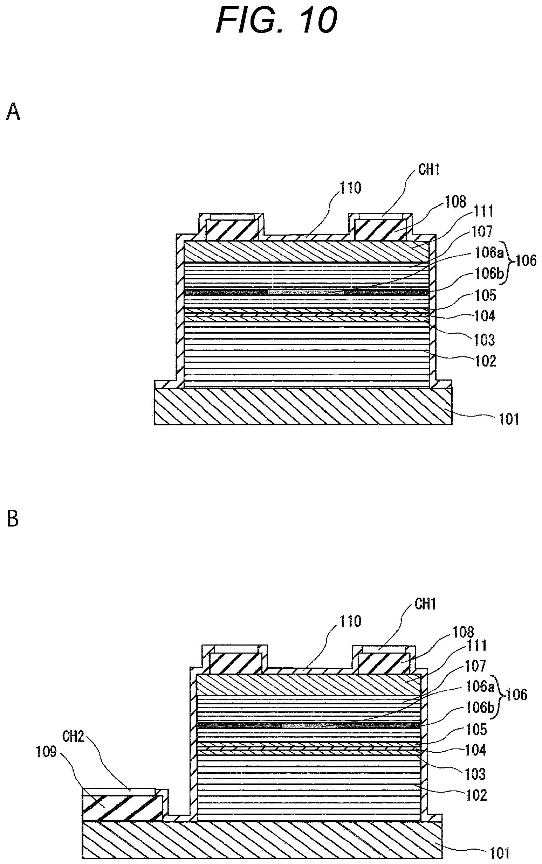

In the final step S6, the contact holes CH1 and CH2 are formed (see Figs. 10A and 10B). Specifically, by photolithography and etching, the insulation film 110 covering the upper surface of the anode electrode 108 is removed to form the contact hole CH1, and the insulation film 110 covering the upper surface of the cathode electrode 109 is removed to form the contact hole CH2.

### <<Effects of Surface Emitting Laser>>

Hereinafter, the effects of the surface emitting laser 10-1 will be described. The surface emitting laser 10-1 includes a first structure ST1 including a substrate 101 and a second structure ST2 provided on the first structure ST1. The second structure ST2 includes a first reflector 102, a second reflector 107 stacked with the first reflector 102, an active layer 104 disposed between the first and second reflectors 102 and 107, and an oxidation constriction layer 106 as an optical confinement layer disposed between a surface of the second reflector 107 on a side opposite to the active layer 104 side and the active layer 104 (for example, in the second reflector 107). The oxidation constriction layer 106 as an optical confinement layer has a high refractive index region 106a having a relatively high refractive index and a low refractive index region 106b surrounding the high refractive index region 106a and having a relatively low refractive index. Each of the second structure ST2 and the high refractive index region 106a has a longitudinal direction and a lateral direction in plan view, a first ratio r1 that is a ratio of a length in the longitudinal direction to a length in the lateral direction of the high refractive index region 106a and a second ratio r2 that is a ratio of a length in the longitudinal direction to a length in the lateral direction of the second structure ST2 are both more than 1.00 and less than 2.00, and the first ratio r1 is larger than the second ratio r2.

In the surface emitting laser 10-1, since both the first and second ratios r1 and r2 are more than 1.00 and less than 2.00 and the first ratio r1 is larger than the second ratio r2, it is possible to achieve both lateral mode stabilization and suppression of decrease in productivity.

As a result, according to the surface emitting laser 10-1, it is possible to stabilize the lateral mode while suppressing the decrease in productivity.

Hereinafter, some embodiments of a surface emitting laser according to the present technology will be described.

### <2. Surface Emitting Laser according to Example 2 of First Embodiment of Present Technology>

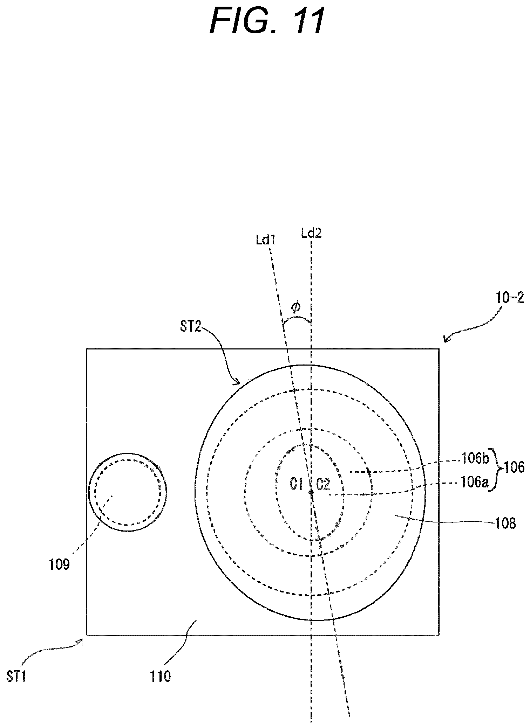

Fig. 11 is a plan view of a surface emitting laser 10-2 according to Example 2 of the first embodiment of the present technology. As illustrated in Fig. 11, the surface emitting laser 10-2 has a configuration similar to that of the surface emitting laser 10-1 according to Example 1 except that the longitudinal direction Ld1 of the high refractive index region 106a and the longitudinal direction Ld2 of the second structure ST2 form an angle φ (0 < φ ≤ 10°), and the second structure ST2 has an elliptical shape slightly distorted in plan view.

The surface emitting laser 10-2 can be manufactured by a manufacturing method substantially similar to the method for manufacturing the surface emitting laser 10-1 according to Example 1. At this time, for example, the second structure ST2 is processed into an elliptical shape slightly distorted in the longitudinal direction Ld2 and/or the lateral direction Sd2 in plan view, and the oxidation processing is performed, so that Ld1 and Ld2 can form the angle φ. Therefore, the length of the high refractive index region 106a in the longitudinal direction Ld2 of the second structure ST2 and the length of the high refractive index region 106a in the lateral direction Sd2 of the second structure ST2 can be adjusted, and the magnitude of the asymmetry of the high refractive index region 106a with respect to the second structure ST2 can be adjusted. Therefore, the degree of stabilization of the lateral mode can be adjusted.

### <3. Surface Emitting Laser according to Example 3 of First Embodiment of Present Technology>

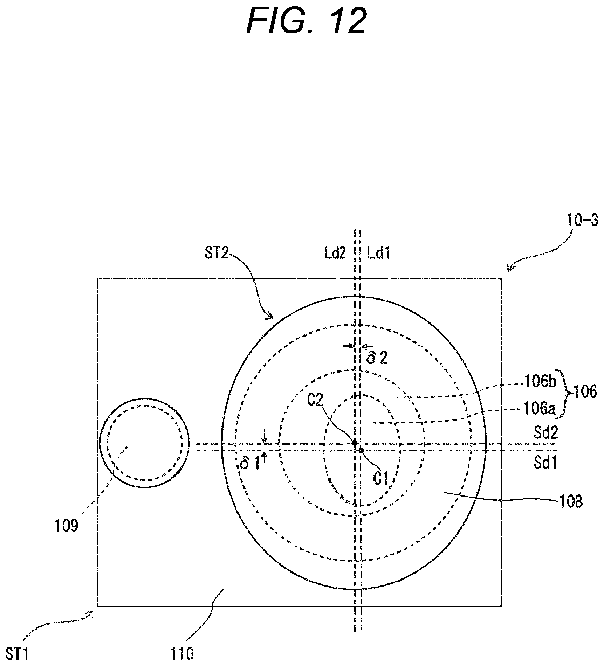

Fig. 12 is a plan view of a surface emitting laser 10-3 according to Example 3 of the first embodiment of the present technology. As illustrated in Fig. 12, the surface emitting laser 10-3 has a configuration similar to that of the surface emitting laser 10-1 according to Example 1 except that the area centroid C1 of the high refractive index region 106a does not coincide with the area centroid C2 of the second structure ST2.

The surface emitting laser 10-3 can be manufactured by a manufacturing method substantially similar to the method for manufacturing the surface emitting laser 10-1 according to Example 1. At that time, for example, an inclined substrate is used as the substrate 101, and anisotropy is imparted to the oxidation rate in the oxidation processing for forming the oxidation constriction layer 106, whereby the area centroids C1 and C2 can be shifted. At that time, it is preferable that a shift amount δ1 of the area centroid C1 with respect to the area centroid C2 in the longitudinal direction Ld2 of the second structure ST2 is larger than a shift amount δ2 of the area centroid C1 with respect to the area centroid C2 in the lateral direction Sd2 of the second structure ST2. Therefore, the asymmetry of the refractive index distribution of the low refractive index region 106b can be relatively increased in the longitudinal direction Ld2, and the stabilization of the lateral mode can be promoted.

δ1 is preferably 0.20 µm or more, more preferably 0.40 µm or more, and still more preferably 0.80 µm or more. δ2 is preferably less than 0.20 µm, more preferably 0.10 µm or less, and still more preferably 0.050 µm or less. For example, δ2 may be 0.

### <4. Surface Emitting Laser according to Example 4 of First Embodiment of Present Technology>

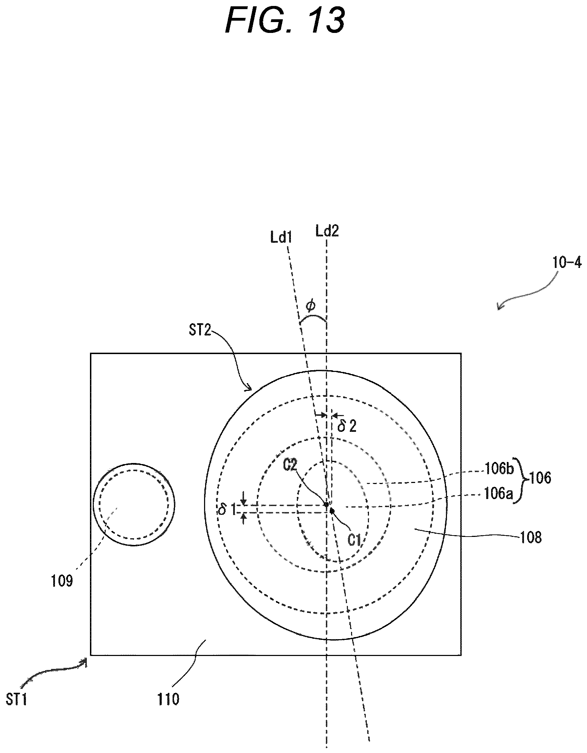

Fig. 13 is a plan view of a surface emitting laser 10-4 according to Example 4 of the first embodiment of the present technology. As illustrated in Fig. 13, the surface emitting laser 10-4 has a configuration similar to that of the surface emitting laser 10-1 according to Example 1 except that the longitudinal direction Ld1 of the high refractive index region 106a and the longitudinal direction Ld2 of the second structure ST2 form an angle φ (0 < φ ≤ 10°), and the area centroid C1 of the high refractive index region 106a and the area centroid C2 of the second structure ST2 do not coincide with each other.

The surface emitting laser 10-4 has the features of the surface emitting lasers 10-2 and 10-3 according to Examples 2 and 3, and can obtain both effects. The surface emitting laser 10-4 can be manufactured by a manufacturing method substantially similar to the method for manufacturing the surface emitting laser 10-1 according to Example 1. At that time, it is preferable to use a method combining the feature points of the methods for manufacturing the surface emitting lasers 10-2 and 10-3 according to Examples 2 and 3.

It is preferable that δ1 and δ2 of the surface emitting laser 10-4 also fall within a numerical range similar to the numerical range of δ1 and δ2 of the surface emitting laser 10-3 according to Example 3. In this case, δ2 may be 0.

### <5. Surface Emitting Laser according to Example 5 of First Embodiment of Present Technology>

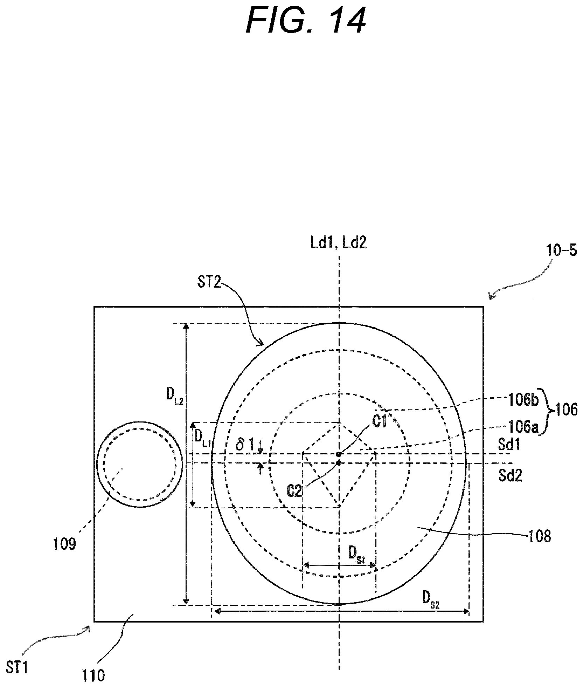

Fig. 14 is a plan view of a surface emitting laser 10-5 according to Example 5 of the first embodiment of the present technology. As illustrated in Fig. 14, the surface emitting laser 10-5 has a configuration similar to that of the surface emitting laser 10-1 according to Example 1 except that the high refractive index region 106a has a quadrangular shape (for example, a modified rhombus shape) in plan view that is symmetric in the longitudinal direction and asymmetric in the lateral direction in plan view, and the area centroid C1 of the high refractive index region 106a and the area centroid C2 of the second structure ST2 do not coincide with each other.

In the surface emitting laser 10-5, the cross section of the second structure ST2 has a modified rhombus shape in which a rhombus is distorted in the longitudinal direction, having a straight line portion and a top portion. Therefore, the surface emitting laser 10-5 is inferior in film thickness uniformity and step coverage to the surface emitting laser 10-1 according to Example 1.

In the surface emitting laser 10-5, the longitudinal directions of the second structure ST2 and the high refractive index region 106a coincide with each other, and the lateral directions do not coincide with each other. The shift amount δ1 in the longitudinal direction of the area centroid of the second structure ST2 and the high refractive index region 106a is, for example, 0.20 µm.

In the surface emitting laser 10-5, the substrate 101 is an inclined substrate whose substrate plane orientation is a plane orientation inclined toward the crystal plane (1 0 0) or the crystal plane (0 -1 -1), and the lateral direction Sd2 of the mesa structure as the second structure ST2 extends in a direction along the crystal orientation <0 1 -1>.

In the surface emitting laser 10-5, the length D_{L1} in the longitudinal direction of the high refractive index region 106a is the length of the major axis passing through the area centroid C1, and the length D_{S1} in the lateral direction of the high refractive index region 106a is the length of the minor axis passing through the area centroid C1.

The surface emitting laser 10-5 can be manufactured by a manufacturing method substantially similar to the method for manufacturing the surface emitting laser 10-1 according to Example 1. At this time, in the oxidation processing for forming the oxidation constriction layer 106, for example, the oxidized layer 106S of the mesa having the major axis length of 22 µm, the minor axis length of 20 µm, and the second ratio r2 of 1.10 is oxidized from the outer peripheral side to the center side by 6.75 µm, whereby the oxidation constriction layer 106 having a quadrangular shape (for example, a shape in which a rhombus is distorted in the longitudinal direction) in plan view having the major axis length of 8.5 µm, the minor axis length of 6.5 µm, and the first ratio r1 of 1.31 is formed. At this time, the lateral direction Sd1 of the high refractive index region 106a extends in a direction along the crystal orientation <0 1 -1> of the substrate 101, and the longitudinal direction Ld1 causes a difference in the oxidation rate of the oxidized layer 106S due to crystal anisotropy associated with substrate inclination or the like, so that the oxidation constriction layer 106 has a quadrangular shape (modified rhombus shape) that is symmetric with respect to the longitudinal direction Ld2 of the second structure ST2 and asymmetric with respect to the lateral direction Sd2 of the second structure ST2. The area centroid C1 of the high refractive index region 106a is shifted from the area centroid C2 of the second structure ST2 by δ1 (for example, 0.20 µm) in the longitudinal direction Ld2 of the second structure ST2. This shift is a shift caused by the crystal anisotropy, and asymmetry can be enhanced without changing the first and second ratios r1 and r2. On the other hand, since the anode electrode 108 has a ring shape (annular shape) centered on the area centroid C2 of the second structure ST2, it is possible to bias current injection into the oxidation constriction layer 106 in which the area centroid C1 is shifted from the area centroid C2. Therefore, the asymmetry of the oxidation constriction layer 106 can be enhanced, and the stabilization of the lateral mode can be promoted.

Note that, in the surface emitting laser 10-5, the longitudinal directions of the second structure ST2 and the high refractive index region 106a may form an angle by a method similar to that of the surface emitting laser 10-4 according to Example 4, or the area centroids C1 and C2 may be shifted in the lateral direction in addition to or instead of being shifted in the longitudinal direction. In this case, the shift amount δ2 in the lateral direction is preferably 0.10 µm or less. In the surface emitting laser 10-5, δ1 may be more than 0.20 µm. The longitudinal direction Ld2 of the second structure ST2 may extend in a direction along the crystal orientation <0 1 -1> of the substrate 101.

### <6. Surface Emitting Laser according to Example 6 of First Embodiment of Present Technology>

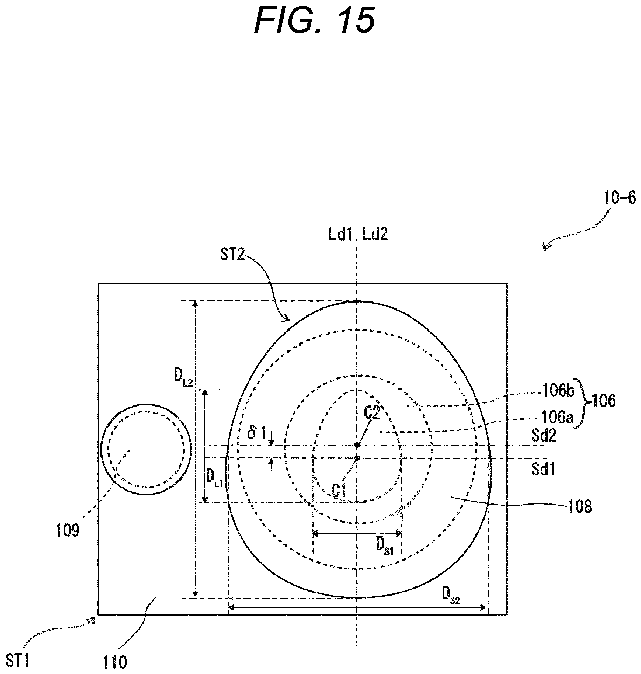

Fig. 15 is a plan view of a surface emitting laser 10-6 according to Example 6 of the first embodiment of the present technology. As illustrated in Fig. 15, the surface emitting laser 10-6 has a configuration similar to that of the surface emitting laser 10-1 according to Example 1 except that both the second structure ST2 and the high refractive index region 106a have a closed curve shape (for example, a modified elliptical shape) that is symmetric with respect to the longitudinal direction and asymmetric with respect to the lateral direction in plan view, and the area centroid C1 of the high refractive index region 106a and the area centroid C2 of the second structure ST2 do not coincide with each other.

In the surface emitting laser 10-6, the cross section of the second structure ST2 has a modified elliptical shape without a straight line portion and a top portion. Therefore, the surface emitting laser 10-6 is comparable in film thickness uniformity and step coverage to the surface emitting laser 10-1 according to Example 1.

In the surface emitting laser 10-6, the longitudinal directions of the second structure ST2 and the high refractive index region 106a coincide with each other, and the lateral directions do not coincide with each other. The shift amount δ1 in the longitudinal direction of the area centroid of the second structure ST2 and the high refractive index region 106a is, for example, 0.20 µm.

In the surface emitting laser 10-6, the substrate 101 is an inclined substrate whose substrate plane orientation is a plane orientation inclined toward the crystal plane (1 0 0) or the crystal plane (0 -1 -1), and the lateral direction Sd2 of the mesa structure as the second structure ST2 extends in a direction along the crystal orientation <0 1 -1>.

In the surface emitting laser 10-6, the length D_{L1} in the longitudinal direction of the high refractive index region 106a is the length of the major axis passing through the area centroid C1, and the length D_{S1} in the lateral direction of the high refractive index region 106a is the length of the minor axis passing through the area centroid C1.

The surface emitting laser 10-6 can be manufactured by a manufacturing method substantially similar to the method for manufacturing the surface emitting laser 10-5 according to Example 5.

According to the surface emitting laser 10-6, the effect of the surface emitting laser 10-1 according to Example 1 and the effect of the surface emitting laser 10-5 according to Example 5 are obtained.

Note that, in the surface emitting laser 10-6, the longitudinal directions of the second structure ST2 and the high refractive index region 106a may form an angle by a method similar to that of the surface emitting laser 10-4 according to Example 4, or the area centroids C1 and C2 may be shifted in the lateral direction in addition to or instead of being shifted in the longitudinal direction. In this case, the shift amount δ2 in the lateral direction is preferably 0.10 µm or less. In the surface emitting laser 10-6, δ1 may be more than 0.20 µm. The longitudinal direction Ld2 of the second structure ST2 may extend in a direction along the crystal orientation <0 1 -1> of the substrate 101.

### <7. Surface Emitting Laser according to Example 7 of First Embodiment of Present Technology>

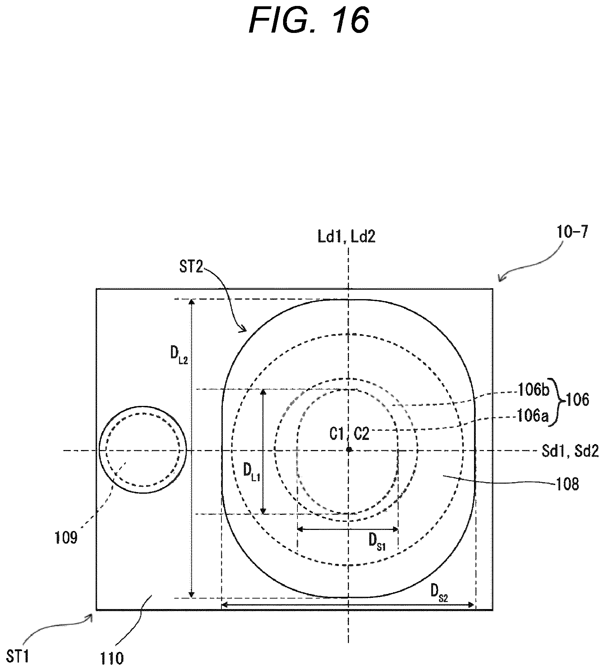

Fig. 16 is a plan view of a surface emitting laser 10-7 according to Example 7 of the first embodiment of the present technology. As illustrated in Fig. 16, the surface emitting laser 10-7 has a configuration similar to that of the surface emitting laser 10-1 according to Example 1 except that both the second structure ST2 and the high refractive index region 106a have a track shape in plan view.

The surface emitting laser 10-7 has a track shape in which the cross section of the second structure ST2 has a straight line portion and does not have a top portion. Therefore, the surface emitting laser 10-7 is slightly inferior in film thickness uniformity and step coverage to the surface emitting laser 10-1 according to Example 1.

In the surface emitting laser 10-7, the area centroid C2 of the second structure ST2 and the area centroid C1 of the high refractive index region 106a coincide with each other. In the surface emitting laser 10-7, each of the second structure ST2 and the high refractive index region 106a is symmetrical with respect to each of the longitudinal direction and the lateral direction in plan view.

In the surface emitting laser 10-7, the length D_{L1} in the longitudinal direction of the high refractive index region 106a is the length of the major axis passing through the area centroid C1, and the length D_{S1} in the lateral direction of the high refractive index region 106a is the length of the minor axis passing through the area centroid C1.

The surface emitting laser 10-7 can be manufactured by a manufacturing method substantially similar to the method for manufacturing the surface emitting laser 10-1 according to Example 1.

According to the surface emitting laser 10-7, although film thickness uniformity and step coverage are slightly poor, substantially the effects similar to those of the surface emitting laser 10-1 according to Example 1 are obtained.

Note that, in the surface emitting laser 10-7, the longitudinal directions of the second structure ST2 and the high refractive index region 106a may form an angle by a method similar to that of the surface emitting laser 10-4 according to Example 4, or the area centroids C1 and C2 may be shifted in the lateral direction and/or the longitudinal direction.

### <8. Surface Emitting Laser according to Example 8 of First Embodiment of Present Technology>

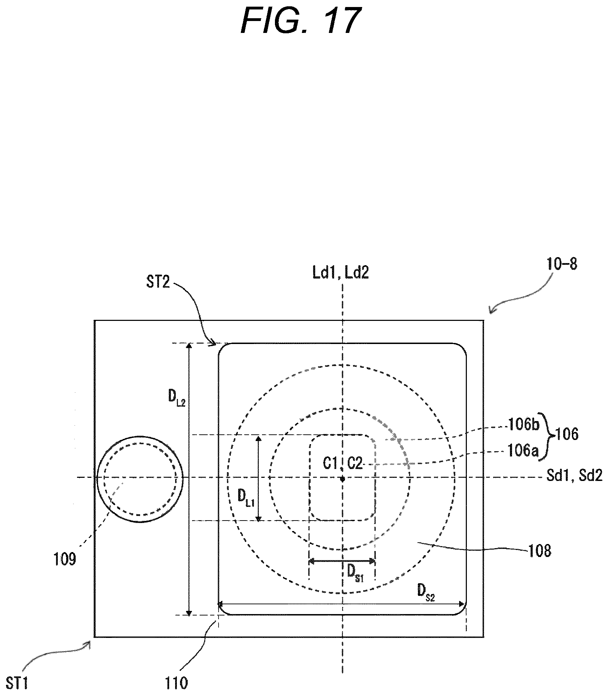

Fig. 17 is a plan view of a surface emitting laser 10-8 according to Example 8 of the first embodiment of the present technology. As illustrated in Fig. 17, the surface emitting laser 10-8 has a configuration similar to that of the surface emitting laser 10-1 according to Example 1 except that both the second structure ST2 and the high refractive index region 106a have a round corner rectangular shape (a rectangular shape with rounded corners) in plan view.

The surface emitting laser 10-8 has a round corner rectangular shape in which the cross section of the second structure ST2 has a straight line portion and does not have a top portion. Therefore, the surface emitting laser 10-8 is slightly inferior in film thickness uniformity and step coverage to the surface emitting laser 10-1 according to Example 1.

In the surface emitting laser 10-8, the area centroid C2 of the second structure ST2 and the area centroid C1 of the high refractive index region 106a coincide with each other. In the surface emitting laser 10-8, each of the second structure ST2 and the high refractive index region 106a is symmetrical with respect to each of the longitudinal direction and the lateral direction in plan view.

In the surface emitting laser 10-8, the length D_{L1} in the longitudinal direction of the high refractive index region 106a is the length of the major axis passing through the area centroid C1, and the length D_{S1} in the lateral direction of the high refractive index region 106a is the length of the minor axis passing through the area centroid C1.

The surface emitting laser 10-8 can be manufactured by a manufacturing method substantially similar to the method for manufacturing the surface emitting laser 10-1 according to Example 1.

According to the surface emitting laser 10-8, although film thickness uniformity and step coverage are slightly poor, substantially the effects similar to those of the surface emitting laser 10-1 according to Example 1 are obtained.

Note that, in the surface emitting laser 10-8, the longitudinal directions of the second structure ST2 and the high refractive index region 106a may form an angle by a method similar to that of the surface emitting laser 10-4 according to Example 4, or the area centroids C1 and C2 may be shifted in the lateral direction and/or the longitudinal direction.

### <9. Surface Emitting Laser according to Example 9 of First Embodiment of Present Technology>

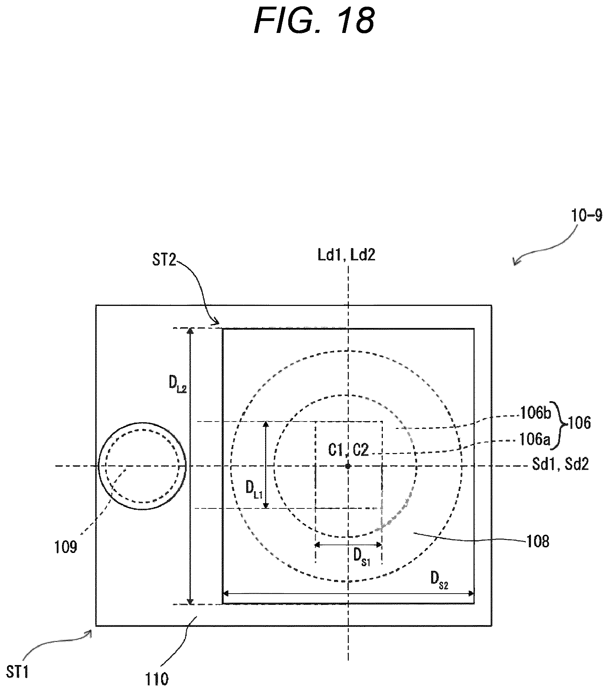

Fig. 18 is a plan view of a surface emitting laser 10-9 according to Example 9 of the first embodiment of the present technology. As illustrated in Fig. 18, the surface emitting laser 10-9 has a configuration similar to that of the surface emitting laser 10-1 according to Example 1 except that both the second structure ST2 and the high refractive index region 106a have a rectangular shape in plan view.

The surface emitting laser 10-9 has a rectangular shape in which the cross section of the second structure ST2 has a straight line portion and a top portion. Therefore, the surface emitting laser 10-9 is inferior in film thickness uniformity and step coverage to the surface emitting laser 10-1 according to Example 1. However, the surface emitting laser 10-9 is excellent in film thickness uniformity and step coverage as compared with a surface emitting laser in which the angle formed by the two sides forming the top portion is an acute angle.

In the surface emitting laser 10-9, the area centroid C2 of the second structure ST2 and the area centroid C1 of the high refractive index region 106a coincide with each other. In the surface emitting laser 10-9, each of the second structure ST2 and the high refractive index region 106a is symmetrical with respect to each of the longitudinal direction and the lateral direction in plan view.

In the surface emitting laser 10-9, the length D_{L1} in the longitudinal direction of the high refractive index region 106a is the length of the major axis passing through the area centroid C1, and the length D_{S1} in the lateral direction of the high refractive index region 106a is the length of the minor axis passing through the area centroid C1.

The surface emitting laser 10-9 can be manufactured by a manufacturing method substantially similar to the method for manufacturing the surface emitting laser 10-1 according to Example 1.

According to the surface emitting laser 10-9, although film thickness uniformity and step coverage are poor, substantially the effects similar to those of the surface emitting laser 10-1 according to Example 1 are obtained.

Note that, in the surface emitting laser 10-9, the longitudinal directions of the second structure ST2 and the high refractive index region 106a may form an angle by a method similar to that of the surface emitting laser 10-4 according to Example 4, or the area centroids C1 and C2 may be shifted in the lateral direction and/or the longitudinal direction.

### <10. Surface Emitting Laser according to Example 10 of First Embodiment of Present Technology>

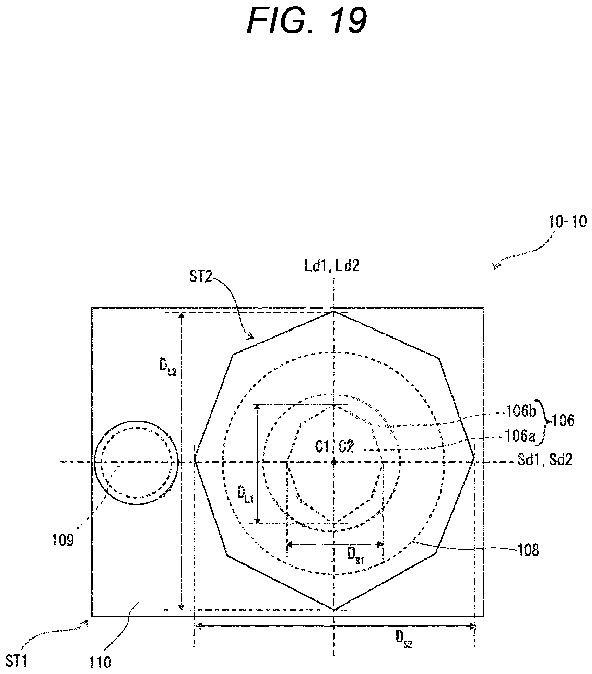

Fig. 19 is a plan view of a surface emitting laser 10-10 according to Example 10 of the first embodiment of the present technology. As illustrated in Fig. 19, the surface emitting laser 10-10 has a configuration similar to that of the surface emitting laser 10-1 according to Example 1 except that both the second structure ST2 and the high refractive index region 106a have a polygonal shape (for example, an octagonal shape) in plan view.

In the surface emitting laser 10-10, the cross section of the second structure ST2 has an octagonal shape having a straight line portion and a top portion (however, since the angle formed by the two sides forming the top portion is an obtuse angle, the influence on film thickness uniformity and step coverage is relatively small). That is, the surface emitting laser 10-10 is slightly inferior in film thickness uniformity and step coverage to the surface emitting laser 10-1 according to Example 1.

In the surface emitting laser 10-10, the area centroid C2 of the second structure ST2 and the area centroid C1 of the high refractive index region 106a coincide with each other. In the surface emitting laser 10-9, each of the second structure ST2 and the high refractive index region 106a is symmetrical with respect to each of the longitudinal direction and the lateral direction in plan view.

In the surface emitting laser 10-10, the length D_{L1} in the longitudinal direction of the high refractive index region 106a is the length of the major axis passing through the area centroid C1, and the length D_{S1} in the lateral direction of the high refractive index region 106a is the length of the minor axis passing through the area centroid C1.

The surface emitting laser 10-10 can be manufactured by a manufacturing method substantially similar to the method for manufacturing the surface emitting laser 10-1 according to Example 1.

According to the surface emitting laser 10-10, although film thickness uniformity and step coverage are slightly poor, substantially the effects similar to those of the surface emitting laser 10-1 according to Example 1 are obtained.

Note that, in the surface emitting laser 10-10, the longitudinal directions of the second structure ST2 and the high refractive index region 106a may form an angle by a method similar to that of the surface emitting laser 10-4 according to Example 4, or the area centroids C1 and C2 may be shifted in the lateral direction and/or the longitudinal direction. The second structure ST2 and the high refractive index region 106a may have a polygonal shape other than an octagon in plan view.

### <11. Surface Emitting Laser according to Example 11 of First Embodiment of Present Technology>

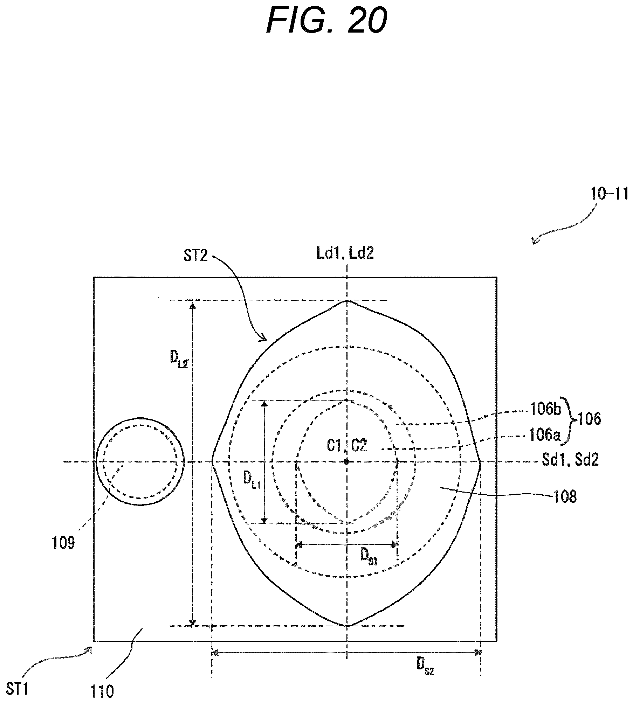

Fig. 20 is a plan view of a surface emitting laser 10-11 according to Example 11 of the first embodiment of the present technology. As illustrated in Fig. 20, the surface emitting laser 10-11 has a configuration similar to that of the surface emitting laser 10-1 according to Example 1 except that both the second structure ST2 and the high refractive index region 106a have a closed curve shape having a top portion in plan view (for example, a modified elliptical shape in which a top portion is provided in an ellipse).

In the surface emitting laser 10-11, the cross section of the second structure ST2 has a modified elliptical shape having a top portion without a straight line portion (however, since the top portion is not so sharp, the influence on film thickness uniformity and coverage is relatively small), that is, the surface emitting laser 10-11 is slightly inferior in film thickness uniformity and coverage to the surface emitting laser 10-1 according to Example 1.

In the surface emitting laser 10-11, the area centroid C2 of the second structure ST2 and the area centroid C1 of the high refractive index region 106a coincide with each other. In the surface emitting laser 10-11, each of the second structure ST2 and the high refractive index region 106a is symmetrical with respect to each of the longitudinal direction and the lateral direction in plan view.

In the surface emitting laser 10-11, the length D_{L1} in the longitudinal direction of the high refractive index region 106a is the length of the major axis passing through the area centroid C1, and the length D_{S1} in the lateral direction of the high refractive index region 106a is the length of the minor axis passing through the area centroid C1.

The surface emitting laser 10-11 can be manufactured by a manufacturing method substantially similar to the method for manufacturing the surface emitting laser 10-1 according to Example 1.

According to the surface emitting laser 10-11, although film thickness uniformity, film thickness uniformity, and step coverage are slightly poor, substantially the effects similar to those of the surface emitting laser 10-1 according to Example 1 are obtained.

Note that, in the surface emitting laser 10-11, the longitudinal directions of the second structure ST2 and the high refractive index region 106a may form an angle by a method similar to that of the surface emitting laser 10-4 according to Example 4, or the area centroids C1 and C2 may be shifted in the lateral direction and/or the longitudinal direction.

### <12. Surface Emitting Laser according to Example 1 of Second Embodiment of Present Technology>

### <<Configuration of Surface Emitting Laser>>

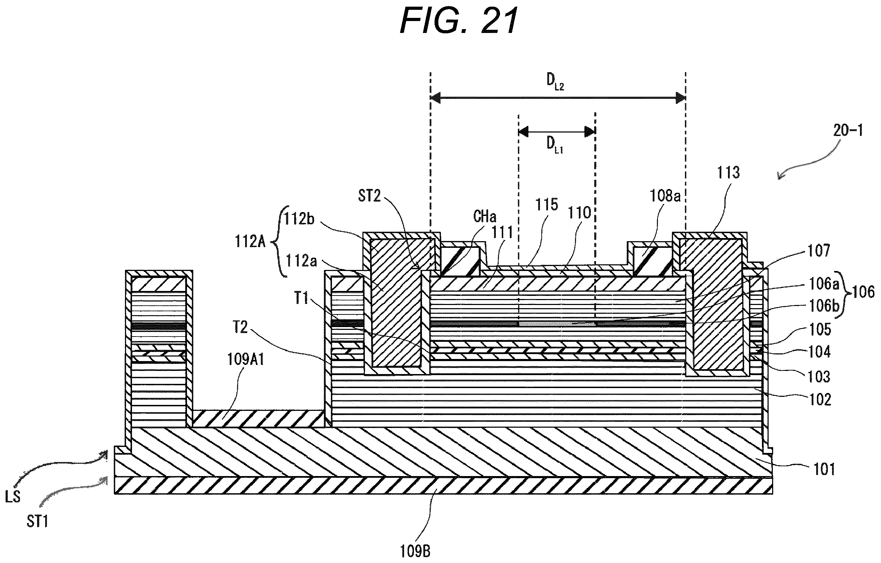

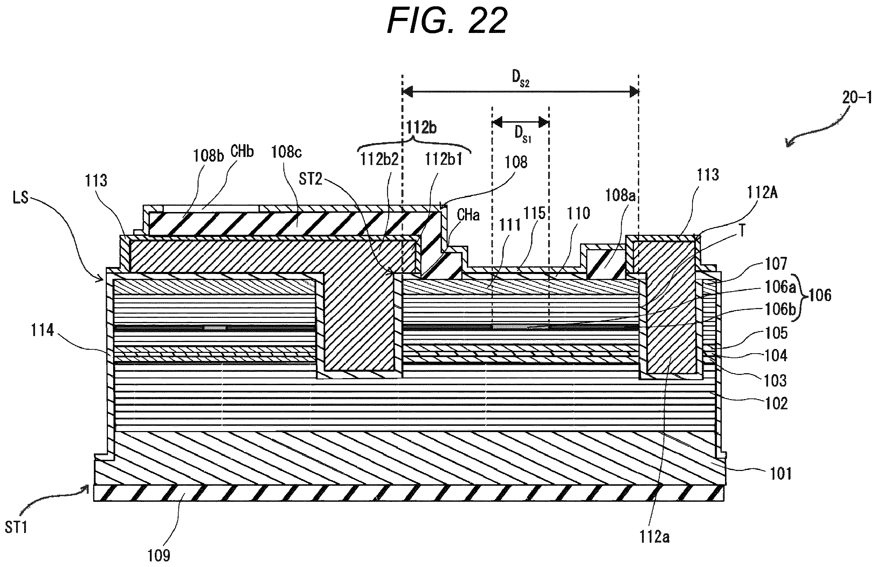

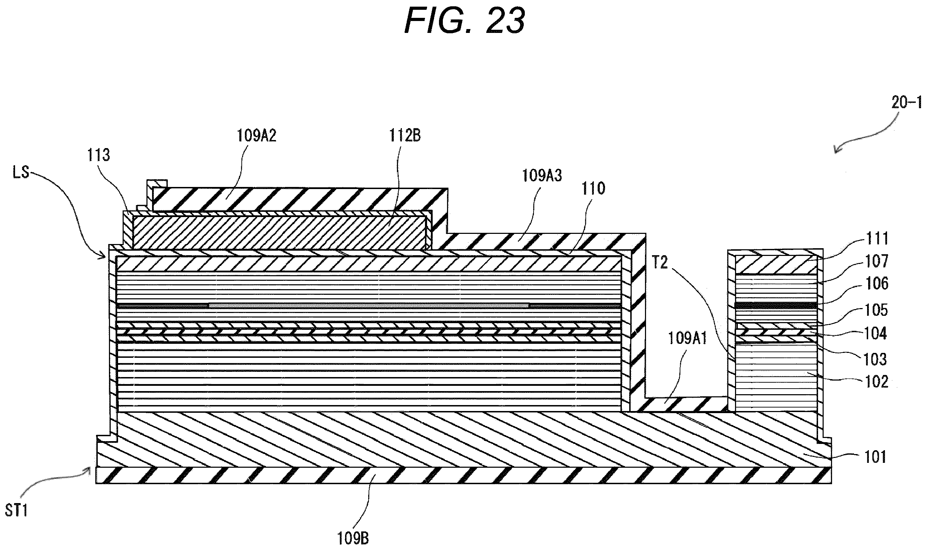

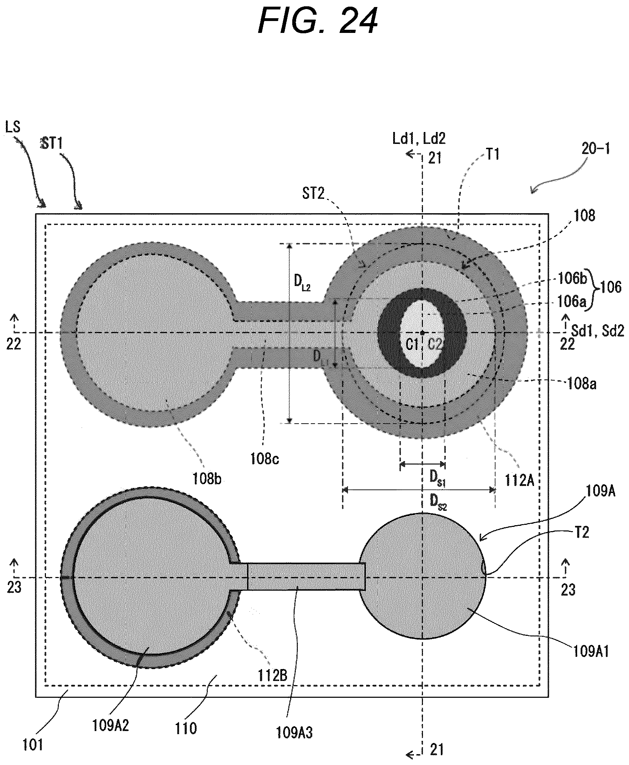

Fig. 21A is a cross-sectional view (Part 1) of a surface emitting laser 20-1 according to Example 1 of the second embodiment of the present technology. Fig. 22 is a cross-sectional view (Part 2) of a surface emitting laser 20-1 according to Example 1 of the second embodiment of the present technology. Fig. 23 is a cross-sectional view (Part 3) of a surface emitting laser 20-1 according to Example 1 of the second embodiment of the present technology. Fig. 24 is a plan view of a surface emitting laser 20-1 according to Example 1 of the second embodiment of the present technology. Fig. 21 is a cross-sectional view taken along line 21-21 in Fig. 24. Fig. 22 is a cross-sectional view taken along line 22-22 in Fig. 24. Fig. 23 is a cross-sectional view taken along line 23-23 in Fig. 24.

As illustrated in Figs. 21 to 24, the surface emitting laser 20-1 has a configuration substantially similar to that of the surface emitting laser 10-1 according to Example 1 of the first embodiment except that a low dielectric constant region 112A surrounding the second structure ST2 is provided and the configurations of the anode electrode 108 and the cathode electrode 109 are different. Hereinafter, a structure including the substrate 101, the first reflector 102, the first cladding layer 103, the active layer 104, the second cladding layer 105, the oxidation constriction layer 106, the second reflector 107, and the contact layer 111 is referred to as a "stacked structure LS".

In the surface emitting laser 20-1, the stacked structure LS includes the first and second structures ST1 and ST2. Here, the first structure ST1 includes the substrate 101 and a part (lower part) of the first reflector 102. The second structure ST2 includes the other portion (upper portion) of the first reflector 102, the first cladding layer 103, the active layer 104, the second cladding layer 105, the oxidation constriction layer 106, the second reflector 107, and the contact layer 111.

The second structure ST2 is separated into a mesa shape by a trench T1 (groove) provided on the upper surface of the stacked structure LS. The trench T1 is a circling groove having an outer peripheral surface of the second structure ST2 as an inner peripheral surface. The bottom surface of the trench T1 is preferably at least at a position lower than the oxidation constriction layer 106 (a position close to the back surface (lower surface) of the substrate 101). Here, the bottom surface of the trench T1 is in the first reflector 102. The stacked structure LS is partially covered with the insulation film 110. The insulation film 110 on the second structure ST2 is provided with a ring-shaped contact hole CHa in plan view that exposes a part of the contact layer 111.

In the surface emitting laser 20-1, the second structure ST2 is, for example, a mesa structure having an elliptical shape in plan view. In the surface emitting laser 20-1, the anode electrode 108 has a ring-shaped (annular) electrode portion 108a provided on the second structure ST2. The electrode portion 108a is provided in a ring shape in plan view so as to be in contact with the contact layer 111 in the contact hole CHa. The electrode portion 108a surrounds the light emitting region of the active layer 104 in plan view.

The low dielectric constant region 112A is a region having a dielectric constant lower than that of a semiconductor (having high insulating properties). As a material of the low dielectric constant region 112A, for example, benzocyclobutene (BCB) is used. The low dielectric constant region 112A is provided on the stacked structure LS via the insulation film 110.

The low dielectric constant region 112A includes a circling first portion 112a embedded in the trench T1, and a second portion 112b continuous with the first portion 112a and surrounding the electrode portion 108a. To supplement, the inner peripheral surface of the second portion 112b is in contact with the outer peripheral surface of the ring-shaped electrode portion 108a via an insulation film 113. That is, the inner peripheral surface of the second portion 112b is along the outer peripheral surface of the electrode portion 108a. The second portion 112b includes an inner peripheral portion 112b1 (circling portion) disposed on the second structure ST2 via the insulation film 110, and an extending portion 112b2 extending in a direction away from the second structure ST2 in a plane from the inner peripheral portion 112b1 (for example, a direction along the line 22-22) (see Fig. 22). The inner edge of the first portion 112a has an elliptical shape (for example, an elliptical shape having a major axis length of 44 µm and a minor axis length of 40 µm) along the outer peripheral surface of the second structure ST2, and the inner edge of the inner peripheral portion 112b1 of the second portion 112b has a circular shape (for example, a circular shape with a diameter of 40 µm). For this reason, in the second structure ST2, different stresses are generated in the longitudinal direction and the lateral direction (specifically, larger stress is generated in the longitudinal direction than in the lateral direction), and the effect of promoting the asymmetry of the oxidation constriction layer 106 can be obtained. Note that the ratio of the length in the longitudinal direction to the length in the lateral direction of the inner edge of the inner peripheral portion 112b1 of the second portion 112b of the low dielectric constant region 112A is not limited to 1, and is preferably more than 1.00 and 1.10 or less in short.

On the extending portion 112b2 of the low dielectric constant region 112A, a pad 108b of the anode electrode 108 is provided via the insulation film 113. The pad 108b has, for example, a substantially circular shape in plan view, and is connected to the electrode portion 108a via a connection portion 108c of the anode electrode 108. The insulation film 113 includes, for example, a material similar to that of the insulation film 110.

The anode electrode 108 is covered with an insulation film 115. The insulation film 115 is provided with a contact hole CHb for exposing the pad 108b of the anode electrode 108. The pad 108b exposed through the contact hole CHb is electrically connected to the anode side of the laser driver. The insulation film 115 includes, for example, a material similar to that of the insulation film 110.

As illustrated in Figs. 21 to 24, the surface emitting laser 20-1 includes a first cathode electrode 109A provided on the front surface (upper surface) side of the substrate 101 and a second cathode electrode 109B provided in a solid shape on the back surface (lower surface) of the substrate 101. The first cathode electrode 109A is provided to be separated from the anode electrode 108 in the direction along the line 21-21 (see Fig. 24) in plan view. The first cathode electrode 109A includes an electrode portion 109A1 disposed on the bottom surface of a trench T2 (groove) provided on the upper surface of the stacked structure LS, a pad 109A2 disposed apart from the electrode portion 109A1 in the direction along the line 23-23 (see Fig. 24) in plan view, and a connection portion 109A3 that connects the electrode portion 109A1 and the pad 109A2. The pad 109A2 is disposed on a low dielectric constant region 112B via the insulation film 113. The low dielectric constant region 112B is disposed on the contact layer 111 via the insulation film 110. The low dielectric constant region 112B includes the same material (for example, BCB) as the low dielectric constant region 112A described above. The connection portion 109A3 has one end portion connected to the electrode portion 109A1 on the bottom surface of the trench T2, an intermediate portion provided on the side surface of the trench T2 and the peripheral region of the trench T2 of the stacked structure LS via the insulation film 110, and the other end portion connected to the pad 109A2. The bottom surface of the trench T2 is preferably located at least at a position lower than the active layer 104 (a position close to the back surface (lower surface) of the substrate 101). Here, the bottom surface of the trench T2 coincides with the upper surface of the substrate 101. As an example, each of the electrode portion 109A1 and the pad 109A2 has a substantially circular shape in plan view (see Fig. 24). The pad 109A2 and the second cathode electrode 109B are electrically connected to the cathode side of the laser driver.

### <<Method for Manufacturing Surface Emitting Laser>>

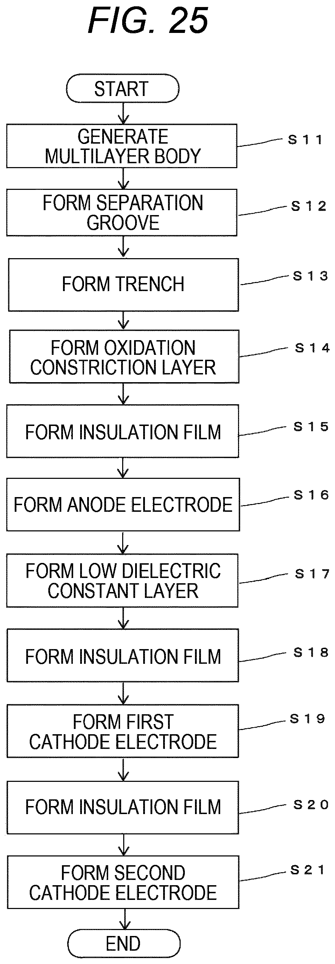

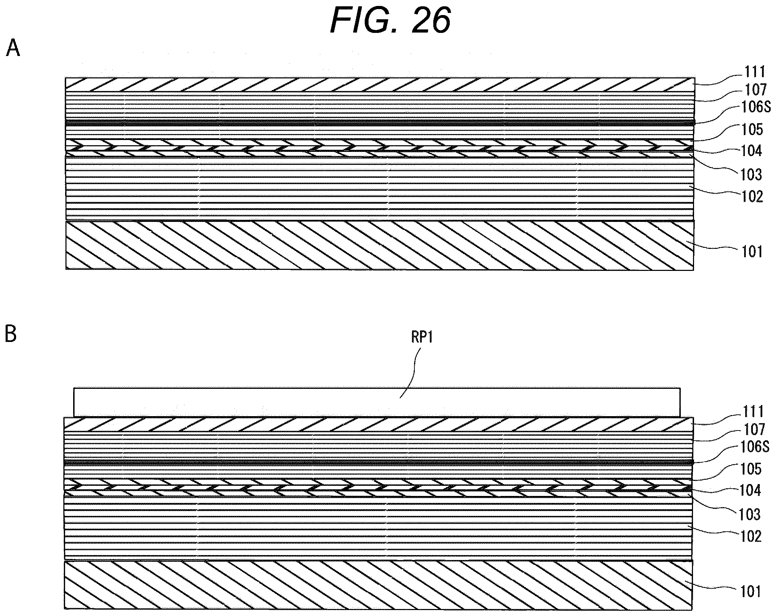

Hereinafter, a method for manufacturing the surface emitting laser 20-1 will be described with reference to the flowchart of Fig. 25 and the cross-sectional views of Figs. 26A to 35B. Figs. 26A to 35B are cross-sectional views corresponding to a cross section taken along line 21-21 in Fig. 24.

Here, as an example, multiple surface emitting lasers 20-1 are simultaneously generated on one wafer (hereinafter also referred to as a "substrate 101" for convenience) which is a base material of the substrate 101 by a semiconductor manufacturing method using a semiconductor manufacturing apparatus. Next, the multiple continuous and integrated surface emitting lasers 20-1 are separated from each other to obtain multiple chip-shaped surface emitting lasers 20-1.

In the first step S11, a multilayer body is generated (see Fig. 26A). Specifically, for example, the first reflector 102, the first cladding layer 103, the active layer 104, the second cladding layer 105, the second reflector 107 in which an oxidized layer 106S (for example, an AlAs layer or an AlGaAs layer) which is a material of the oxidation constriction layer 106 is disposed, and the contact layer 111 are stacked in this order (for example, epitaxially grown at a growth temperature of 605°C) on the substrate 101 (for example, an n-GaAs substrate) as a growth substrate by a metal organic chemical vapor deposition (MOCVD) method to generate a multilayer body. Note that, when the MOCVD is performed, for example, trimethylgallium ((CH₃)₃Ga) is used as a source gas of gallium, for example, trimethylaluminum ((CH₃)₃Al) is used as a source gas of aluminum, for example, trimethylindium ((CH₃)₃In) is used as a source gas of indium, and for example, trimethylarsenic (((CH₃)₃As) is used as a source gas of As. Furthermore, as a source gas of silicon, for example, monosilane (SiH₄) is used, and as a source gas of carbon, for example, carbon tetrabromide (CBr₄) is used.

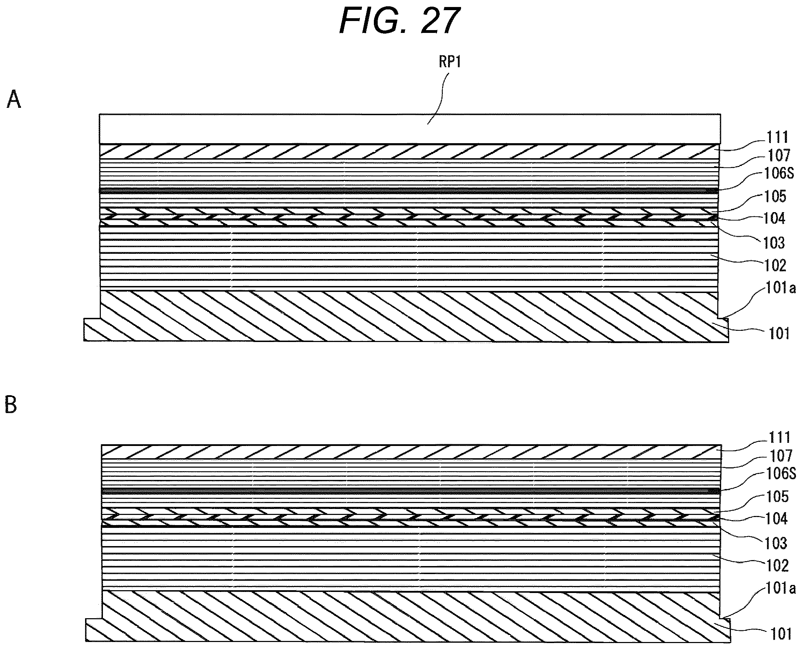

In the next step S12, a separation groove 101a is formed. The separation groove 101a is a groove for separating adjacent surface emitting lasers 20-1 generated on the wafer by dicing. First, a resist pattern RP1 that covers a portion other than a portion where the separation groove 101a is to be formed on the upper surface of the multilayer body is formed by photolithography (see Fig. 26B). Next, using the resist pattern RP1 as a mask, the multilayer body is etched by inductively coupled plasma (ICP) dry etching using, for example, Cl₂, SiCl₄, or Ar (see Fig. 27A). The etching depth at this time is set to a level until the etching bottom surface is positioned in the substrate 101. Thereafter, the resist pattern RP1 is removed by etching (see Fig. 27B).

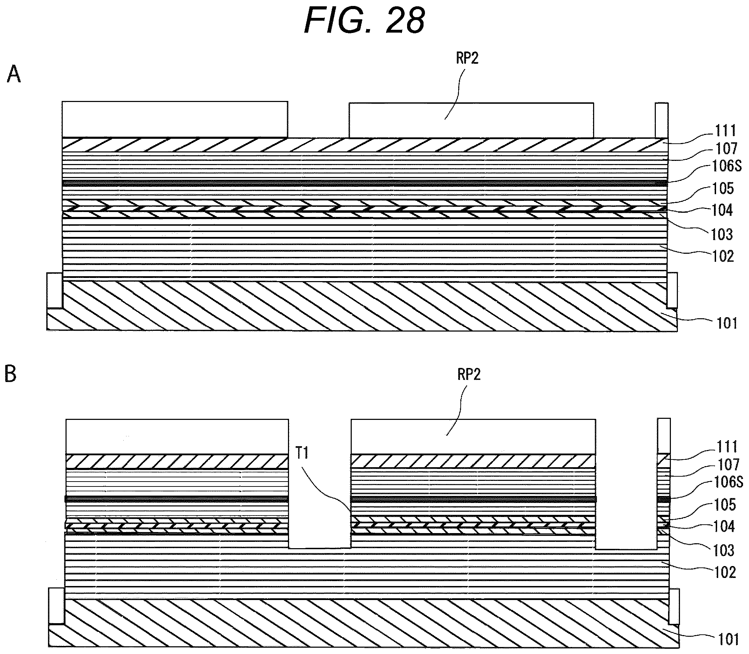

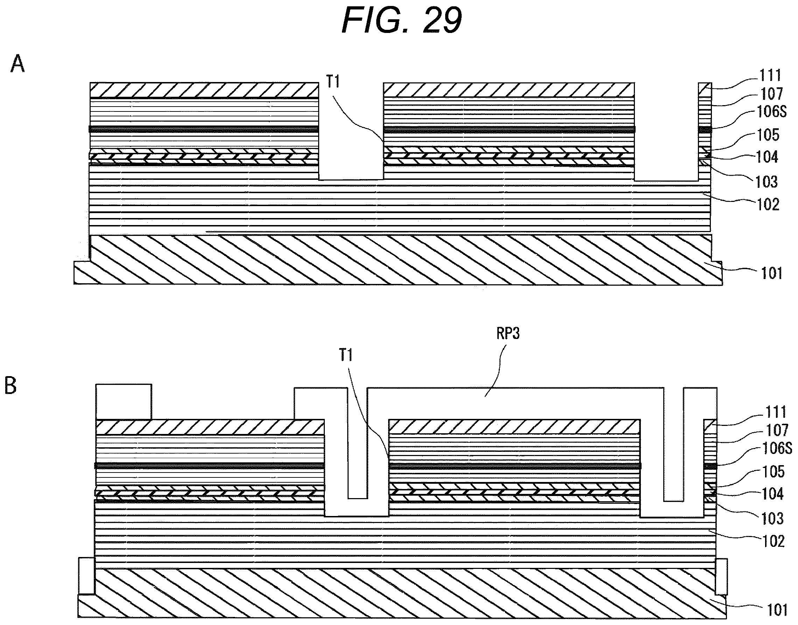

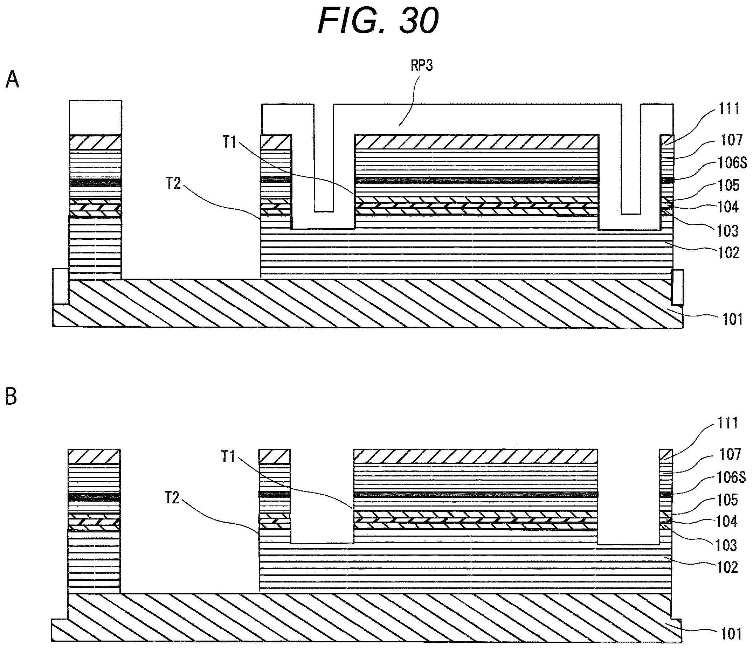

In the next step S13, the trenches T1 and T2 are formed. Specifically, first, the resist pattern RP2 that covers a portion other than a portion where the trench T1 is to be formed on the upper surface of the multilayer body is formed by photolithography (see Fig. 28A). Next, using the resist pattern RP2 as a mask, the multilayer body is etched by inductively coupled plasma (ICP) dry etching using, for example, Cl₂, SiCl₄, or Ar until the etching bottom surface is positioned in the first reflector 102, and the trench T1 having an elliptical annular shape in plan view is formed. As a result, a mesa having an elliptical shape (for example, an elliptical shape having a major axis length of 22 µm and a minor axis length of 20 µm) in plan view with the inner peripheral surface of the trench T1 as the outer peripheral surface is formed (Fig. 28B). Next, the resist pattern RP2 is removed (see Fig. 29A). Next, a resist pattern RP3 that covers a portion other than a portion where the trench T2 is to be formed on the upper surface of the multilayer body is formed by photolithography (see Fig. 29B). Next, using the resist pattern RP3 as a mask, the multilayer body is etched by inductively coupled plasma (ICP) dry etching using, for example, Cl₂, SiCl₄, or Ar until the etching bottom surface reaches the upper surface of the substrate 101 to form a trench T2 having a circular shape in plan view (see Fig. 30A). Finally, the resist pattern RP3 is removed (see Fig. 30B). Note that the trench T1 may be formed after the trench T2 is formed.

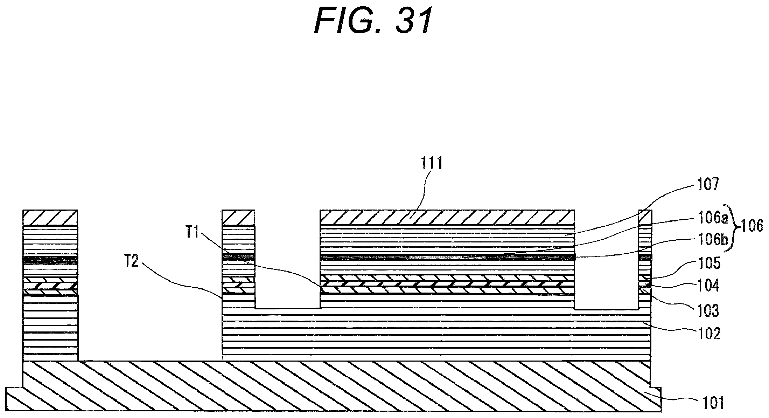

In the next step S14, the oxidation constriction layer 106 as an optical confinement layer is formed (see Fig. 31). Specifically, the mesa having an elliptical shape in plan view formed in step S13 is exposed to a high-temperature water vapor atmosphere, and the oxidized layer 106S is oxidized by a predetermined distance (for example, 6.75 µm) from the outer peripheral side toward the center side. As a result, the oxidation constriction layer 106 in which the non-oxidized region having an elliptical shape (for example, an elliptical shape having a major axis length of 8.5 µm and a minor axis length of 6.5 µm) in plan view as the high refractive index region 106a is surrounded by the oxidized region as the low refractive index region 106b is formed.

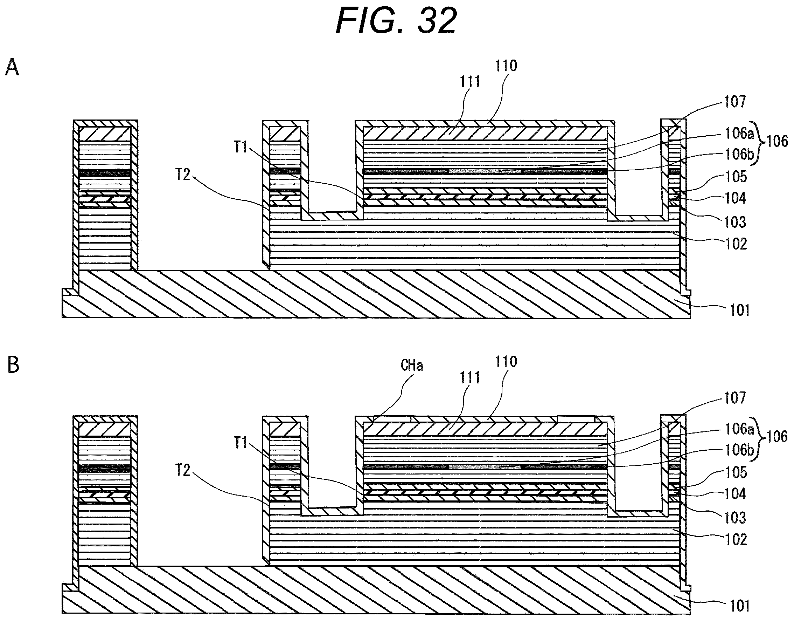

In the next step S15, a thin insulation film 110 is formed on the entire surface (see Fig. 32A).

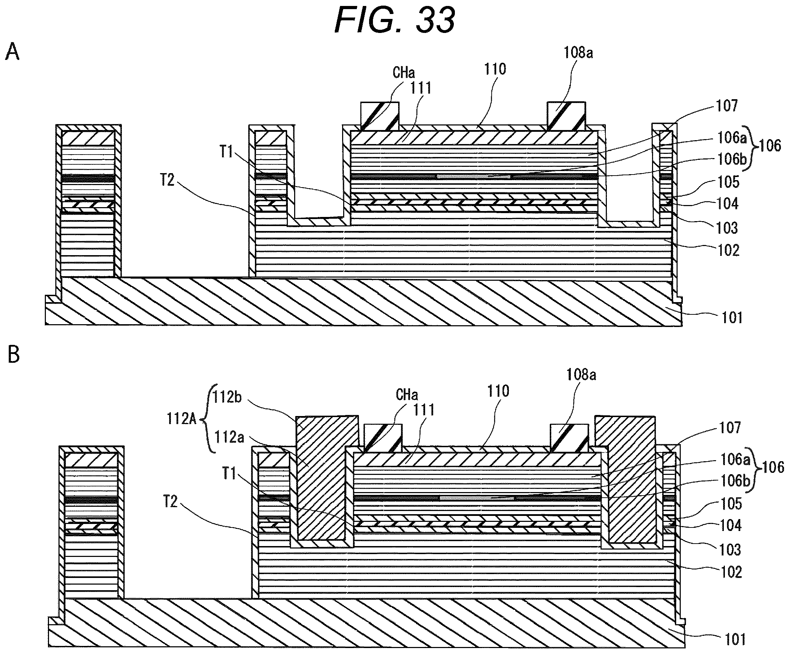

In the next step S16, the anode electrode 108 is formed. Specifically, first, a part of the insulation film 110 is removed by photolithography and etching to form a ring-shaped contact hole CHa in plan view (see Fig. 32B). Next, for example, by a lift-off method, the anode electrode 108 is formed such that the electrode portion 108a has a ring shape (for example, an inner diameter is 12.6 µm and an outer diameter is 18.0 µm) (see Fig. 33A). For example, vacuum deposition, sputtering, or the like is used to form a film of the electrode material of the anode electrode 108.

In the next step S17, the low dielectric constant regions 112A and 112B are formed (see Fig. 33B). Specifically, first, a thick film of BCB, which is a low dielectric constant material, is formed on the entire surface. Next, unnecessary portions of the BCB film are removed by photolithography and etching. As a result, the low dielectric constant region 112A is formed in which the inner peripheral surface of the first portion 112a is along the outer peripheral surface of the second structure ST2 having an elliptical shape in plan view and the inner peripheral surface of the second portion 112b (the inner edge of the inner peripheral portion 112b1) is along the outer peripheral surface of the ring-shaped electrode portion 108a, and the low dielectric constant region 112B is formed.

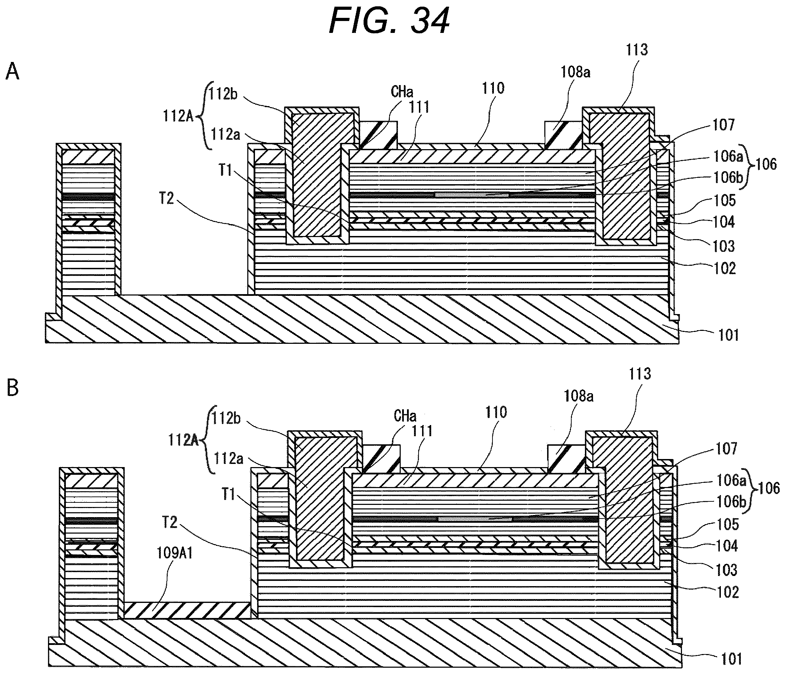

In the next step S18, the insulation film 113 is formed (see Fig. 34A). Specifically, first, the insulation film 113 is formed on the entire surface. Next, the insulation film 113 other than the insulation film 113 covering the low dielectric constant regions 112A and 112B is removed by photolithography and etching.

In the final step S19, the first cathode electrode 109A is formed (see Fig. 34B). Specifically, the first cathode electrode 109A is formed such that the electrode portion 109A1 has a circular shape on the bottom surface of the trench T2 (see Fig. 34B). At this time, for example, vacuum deposition, sputtering, or the like is used to form a film of the electrode material of the first cathode electrode 109A.

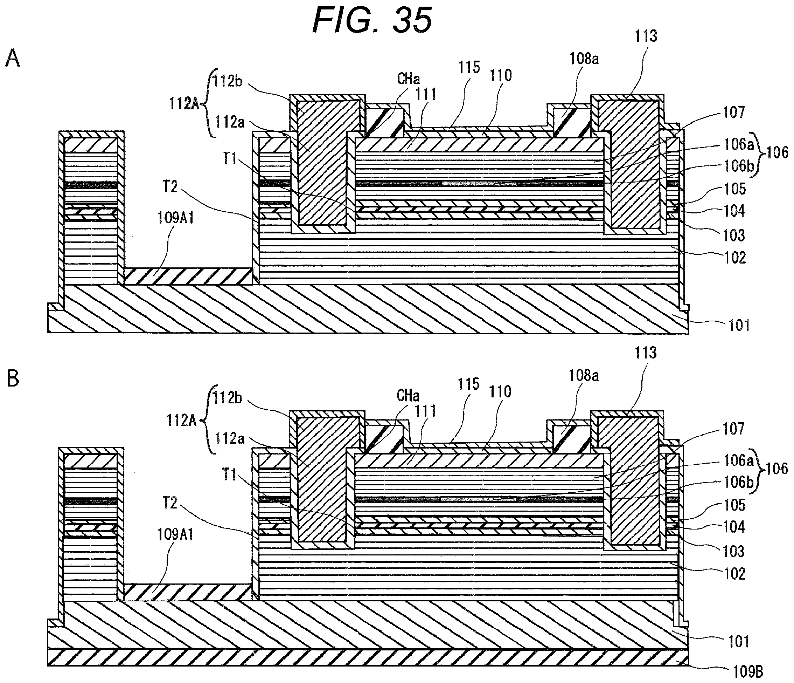

In the next step S20, the insulation film 115 is formed (see Fig. 35A). Specifically, first, the insulation film 115 is formed on the entire surface. Next, at least the insulation film 115 covering the pad 108b of the anode electrode 108 and the insulation film 115 covering the pad 109A2 of the first cathode electrode 109A are removed by photolithography and etching.

In the final step S21, the second cathode electrode 109B is formed (see Fig. 35B). Specifically, the second cathode electrode 109B is formed in a solid shape on the back surface of the substrate 101 by, for example, a lift-off method. At this time, for example, vacuum deposition, sputtering, or the like is used to form a film of the electrode material of the second cathode electrode 109B.

Note that the order of steps S15 and S16 may be substantially reversed. That is, after the anode electrode 108 is formed on the mesa, the insulation film 110 may be formed on the entire surface, and a portion of the insulation film 110 covering the anode electrode 108 may be removed by photolithography and etching.

### <13. Surface Emitting Laser according to Example 2 of Second Embodiment of Present Technology>

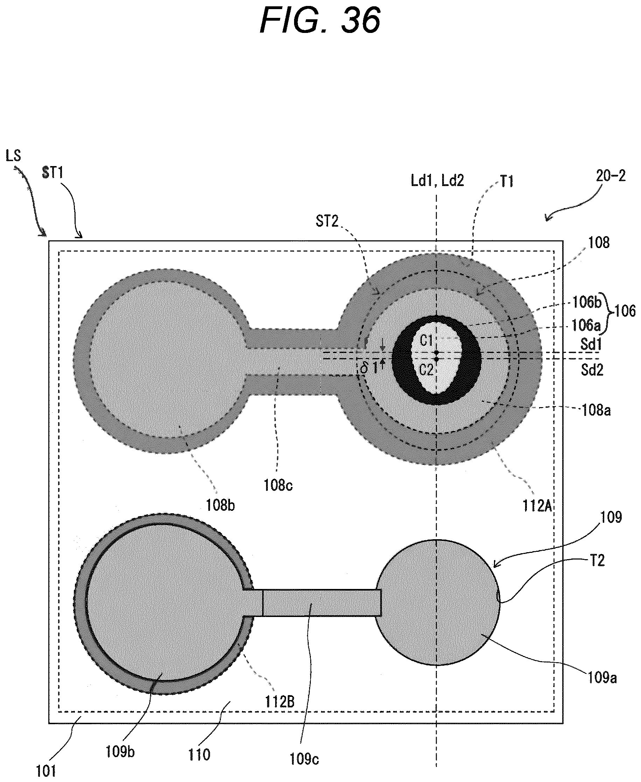

Fig. 36 is a plan view of a surface emitting laser 20-2 according to Example 2 of the second embodiment of the present technology.

As illustrated in Fig. 36, the surface emitting laser 20-2 has a configuration similar to that of the surface emitting laser 20-1 according to Example 1 except that the high refractive index region 106a has a closed curve shape (for example, a modified elliptical shape) similar to that of the surface emitting laser 10-6 according to Example 6 of the first embodiment (see Fig. 15).

In the surface emitting laser 20-2, the longitudinal directions of the high refractive index region 106a and the second structure ST2 coincide with each other, and the lateral directions are shifted. That is, the area centroid C1 of the high refractive index region 106a and the area centroid C2 of the second structure ST2 are shifted by δ1 (for example, 0.20 µm or more) in the longitudinal direction.

The surface emitting laser 20-2 can be manufactured by a control method in which the feature point of the method for manufacturing the surface emitting laser 10-6 according to Example 6 of the first embodiment is applied to the method for manufacturing the surface emitting laser 20-1 according to Example 1.

According to the surface emitting laser 20-2, in addition to the effect of the surface emitting laser 20-1, the effect of the surface emitting laser 10-6 can be obtained.

### <14. Surface Emitting Laser according to Example 3 of Second Embodiment of Present Technology>

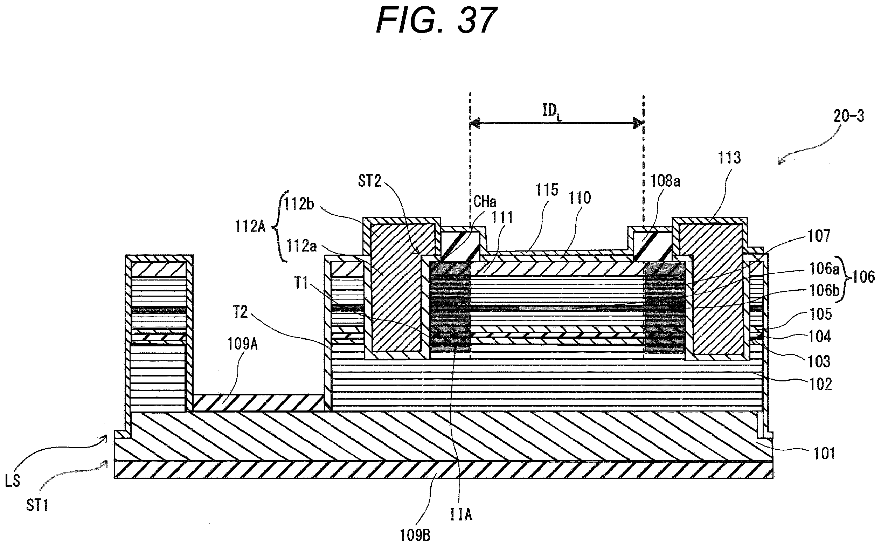

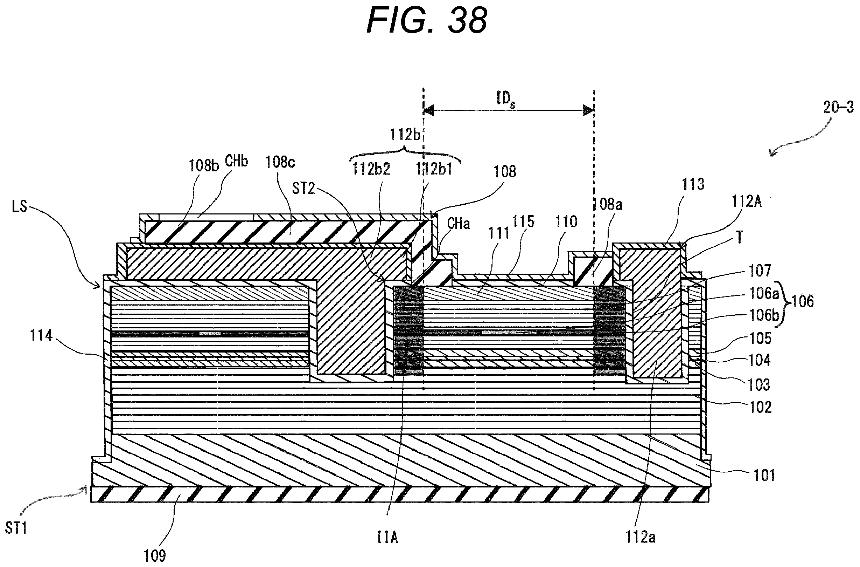

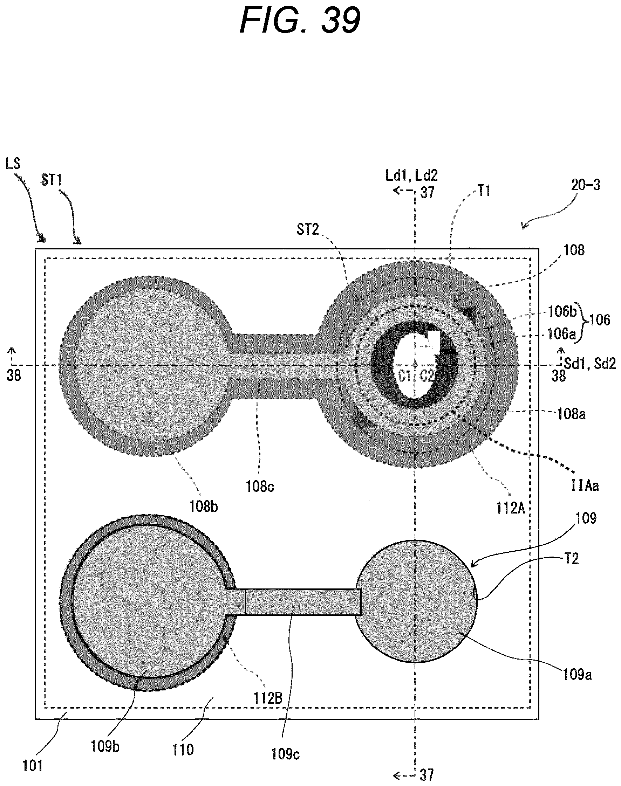

Fig. 37 is a cross-sectional view (Part 1) of a surface emitting laser 20-3 according to Example 3 of the second embodiment of the present technology. Fig. 38 is a cross-sectional view (Part 2) of the surface emitting laser 20-3 according to Example 3 of the second embodiment of the present technology. Fig. 39 is a plan view of the surface emitting laser 20-3 according to Example 3 of the second embodiment of the present technology. Fig. 37 is a cross-sectional view taken along line 37-37 in Fig. 39. Fig. 38 is a cross-sectional view taken along line 38-38 in Fig. 39.

The surface emitting laser 20-3 has a configuration similar to that of the surface emitting laser 20-1 according to Example 1 except that an ion implantation region IIA (a transparent gray region in Figs. 37 and 38) as a high resistance region surrounding the high refractive index region 106a is provided in the second structure ST2. Note that the ion implantation region IIA may be provided in the first structure ST1 in addition to the second structure ST2.

In the ion implantation region IIA, an inner edge IIAa has a substantially circular shape in plan view (see Fig. 39). Therefore, it is easy to control the position of the inner edge at the time of performing ion implantation. Strictly speaking, the inner edge IIAa of the ion implantation region IIA has a longitudinal direction and a lateral direction in plan view. In this case, the ratio of a length ID_{L} in the longitudinal direction to a length IDs in the lateral direction of the inner edge of the ion implantation region IIA is preferably more than 1.00 and 1.10 or less. The outer edge of the ion implantation region IIA has, for example, a substantially elliptical shape in plan view which coincides with the outer edge of the second structure ST2. Examples of the ion species used for the ion implantation region IIA include H and B.

The ion implantation region IIA has a refractive index lower than that of a region on the inner diameter side (non-ion implantation region), and has an optical confinement effect. Since the inner edge IIAa of the ion implantation region IIA has shape anisotropy in the longitudinal direction and the lateral direction in plan view, anisotropy occurs in the refractive index distribution, and the lateral mode can be further stabilized.

In plan view, the center of the inner edge IIAa of the ion implantation region IIA coincides with the center of the electrode portion 108a of the anode electrode 108. The length in the longitudinal direction and the length in the lateral direction of the inner edge IIAa of the ion implantation region IIA are longer than the inner diameter of the electrode portion 108a of the anode electrode 108. Therefore, a contact portion of the contact layer 111 with the anode electrode 108 can be a non-ion implantation region, and it is possible to suppress an increase in resistance of at least a part of the contact portion.

The surface emitting laser 20-3 can be manufactured by a control method in which an ion implantation process is incorporated in the method for manufacturing the surface emitting laser 20-1 according to Example 1.

According to the surface emitting laser 20-3, in addition to the effect of the surface emitting laser 20-1, the lateral mode can be further stabilized.

### <15. Surface Emitting Laser according to Example 4 of Second Embodiment of Present Technology>

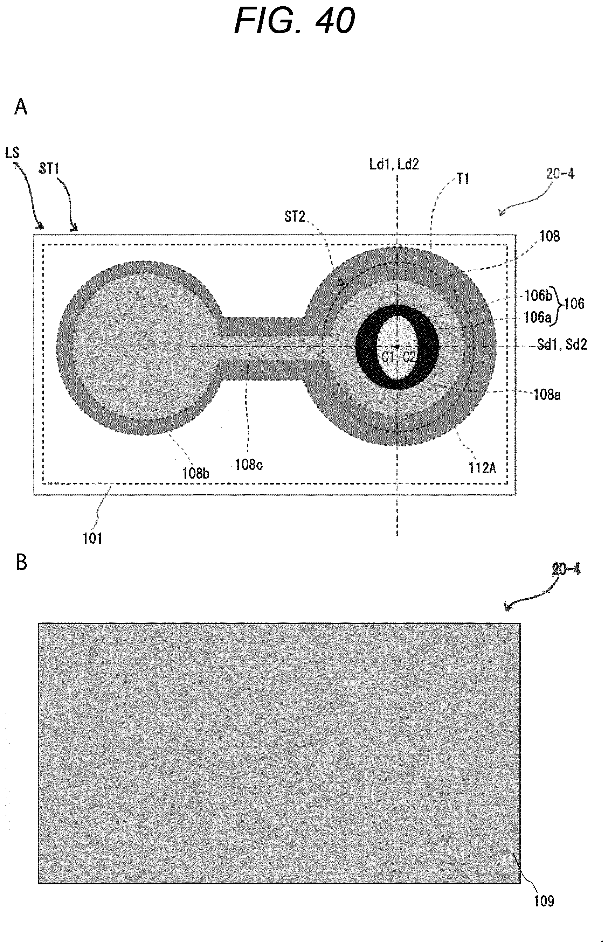

Fig. 40A is a plan view of a surface emitting laser 20-4 according to Example 4 of the second embodiment of the present technology. Fig. 40B is a bottom view of the surface emitting laser 20-4 according to Example 4 of the second embodiment of the present technology.

As illustrated in Figs. 40A and 40B, the surface emitting laser 20-4 has a configuration similar to that of the surface emitting laser 20-1 according to Example 1 except that the cathode electrode 109 is provided in a solid shape only on the back surface (lower surface) of the substrate 101.

The surface emitting laser 20-4 can be manufactured by a manufacturing method compliant to the method for manufacturing the surface emitting laser 20-1 according to Example 1.

According to the surface emitting laser 20-4, since the cathode electrode is not provided on the upper surface side of the substrate 101, the I-V characteristic is poor, but the manufacturing is easy.

### <16. Modifications of Present Technology>

The present technology is not limited to each of the embodiments and examples described above, and various modifications can be made.

### (Surface Emitting Laser according to First Modification of First Embodiment of Present Technology)

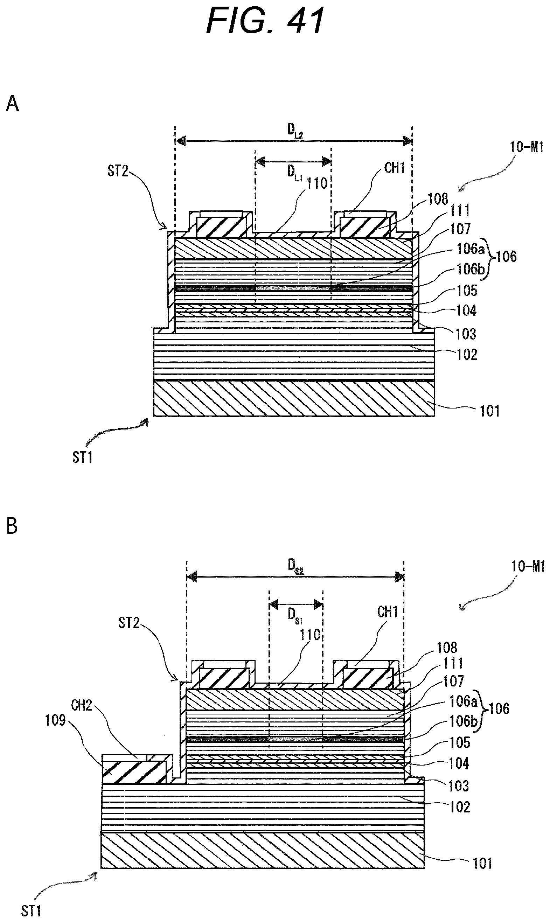

Fig. 41A is a cross-sectional view (Part 1) of a surface emitting laser 10-M1 according to a first modification of the first embodiment of the present technology. Fig. 41B is a cross-sectional view (Part 2) of the surface emitting laser 10-M1 according to the first modification of the first embodiment of the present technology. Fig. 41A is a cross-sectional view corresponding to Fig. 1A, and Fig. 41B is a cross-sectional view corresponding to Fig. 1B (the same applies to the following modification).

As illustrated in Figs. 41A and 41B, the surface emitting laser 10-M1 has a configuration similar to that of any of the surface emitting lasers 10-1 to 10-11 according to Example 1 to 11 of the first embodiment except that the bottom surface of the mesa structure as the second structure ST2 is located in the first reflector 102 and the cathode electrode 109 is provided on the region of the first reflector 102 around the mesa structure. In the surface emitting laser 10-M1, a non-doped semiconductor substrate (for example, i-GaAs substrate) can also be used as the substrate 101.

### (Surface Emitting Laser according to Second Modification of First Embodiment of Present Technology)

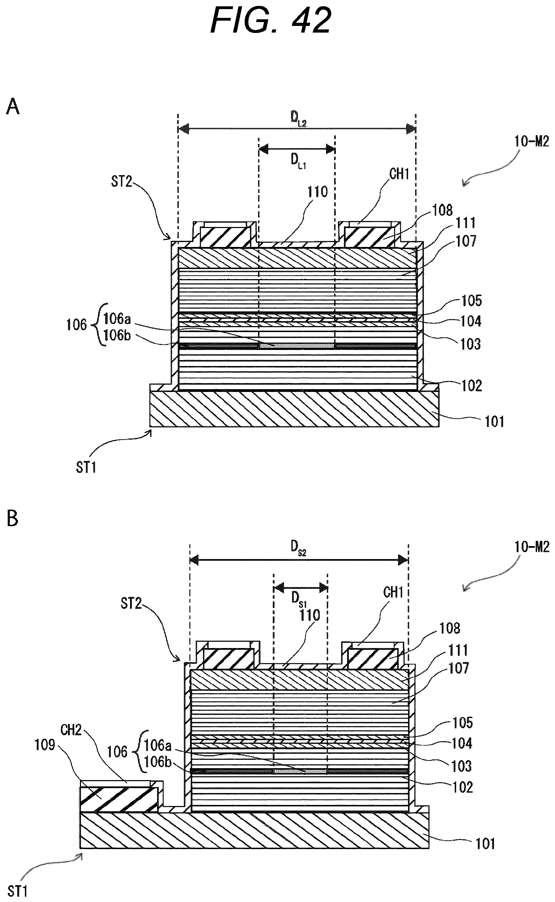

Fig. 42A is a cross-sectional view (Part 1) of a surface emitting laser 10-M2 according to a second modification of the first embodiment of the present technology. Fig. 42B is a cross-sectional view (Part 2) of the surface emitting laser 10-M2 according to the second modification of the first embodiment of the present technology.

As illustrated in Figs. 42A and 42B, the surface emitting laser 10-M2 has a configuration similar to that of any of the surface emitting lasers 10-1 to 10-11 according to Examples 1 to 11 of the first embodiment except that the oxidation constriction layer 106 is disposed in the first reflector 102.

### (Surface Emitting Laser according to Third Modification of First Embodiment of Present Technology)

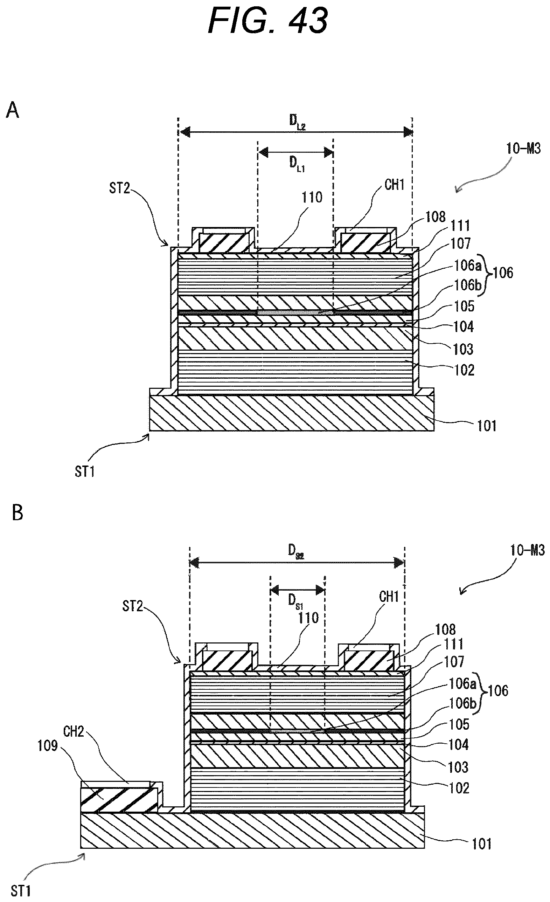

Fig. 43A is a cross-sectional view (Part 1) of a surface emitting laser 10-M3 according to a third modification of the first embodiment of the present technology. Fig. 43B is a cross-sectional view (Part 2) of the surface emitting laser 10-M3 according to the third modification of the first embodiment of the present technology.

As illustrated in Figs. 43A and 43B, the surface emitting laser 10-M3 has a configuration similar to that of any of the surface emitting lasers 10-1 to 10-11 according to Examples 1 to 11 of the first embodiment except that the oxidation constriction layer 106 is disposed in the second cladding layer 105. Note that the oxidation constriction layer 106 may be disposed in the first cladding layer 103 instead of being disposed in the second cladding layer 105.

### (Surface Emitting Laser according to Fourth Modification of First Embodiment of Present Technology)

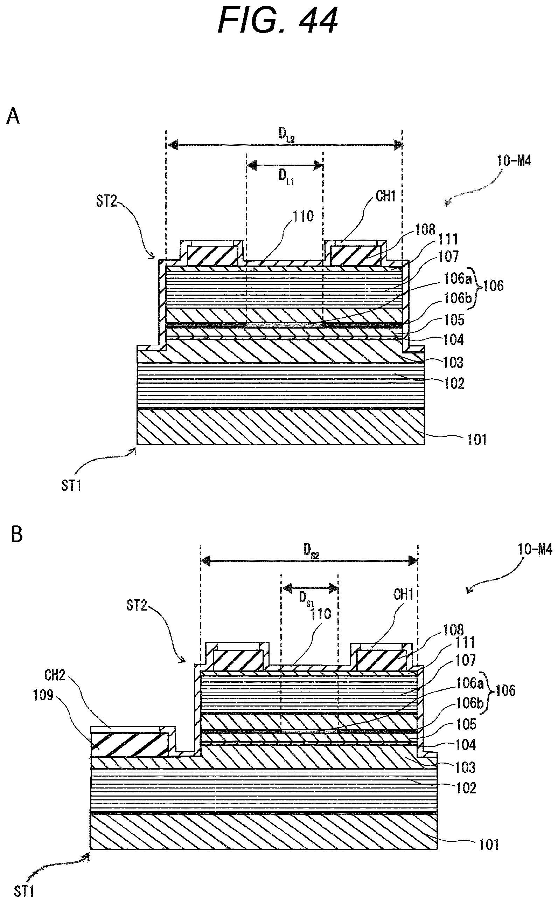

Fig. 44A is a cross-sectional view (Part 1) of a surface emitting laser 10-M4 according to a fourth modification of the first embodiment of the present technology. Fig. 44B is a cross-sectional view (Part 2) of the surface emitting laser 10-M4 according to the fourth modification of the first embodiment of the present technology.

As illustrated in Figs. 44A and 44B, the surface emitting laser 10-M4 has a configuration similar to that of any of the surface emitting lasers 10-1 to 10-11 according to Examples 1 to 11 of the first embodiment except that the oxidation constriction layer 106 is disposed in the second cladding layer 105, the bottom surface of the mesa structure as the second structure ST2 is located in the first cladding layer 103, and the cathode electrode 109 is installed on the region of the first cladding layer 103 around the mesa structure.

### (Surface Emitting Laser according to Fifth Modification of First Embodiment of Present Technology)

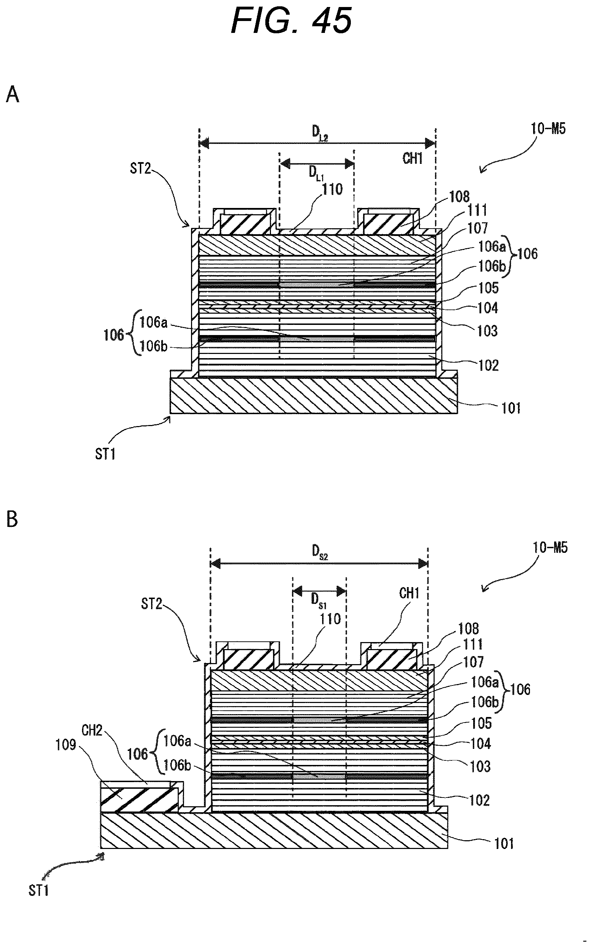

Fig. 45A is a cross-sectional view (Part 1) of a surface emitting laser 10-M5 according to a fifth modification of the first embodiment of the present technology. Fig. 45B is a cross-sectional view (Part 2) of the surface emitting laser 10-M5 according to the fifth modification of the first embodiment of the present technology.

As illustrated in Figs. 45A and 45B, the surface emitting laser 10-M5 has a configuration similar to that of any of the surface emitting lasers 10-1 to 10-11 according to Examples 1 to 11 of the first embodiment except that the oxidation constriction layer 106 is disposed in both the second reflector 102 and the first reflector 102. Note that the oxidation constriction layer 106 may be disposed in both the second cladding layer 105 and the first cladding layer 103.

### (Surface Emitting Laser according to Sixth Modification of First Embodiment of Present Technology)

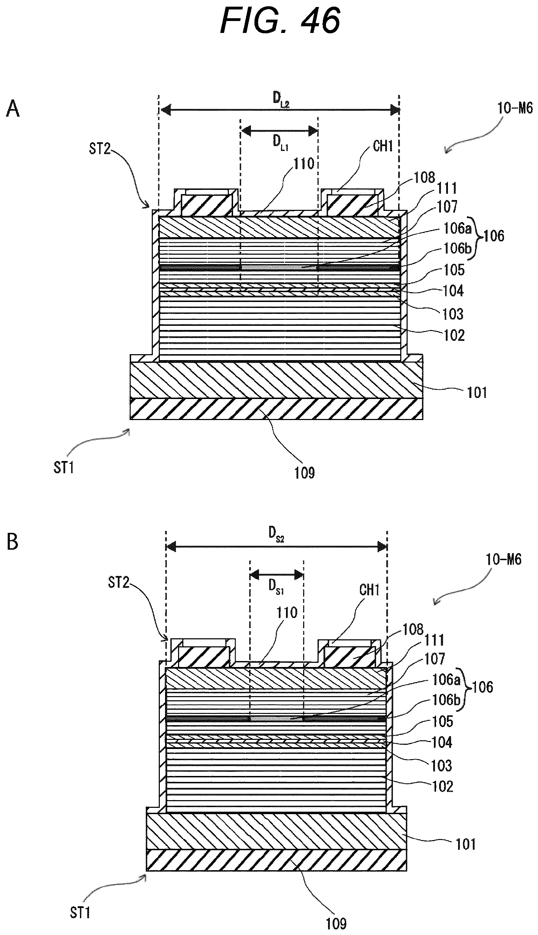

Fig. 46A is a cross-sectional view (Part 1) of a surface emitting laser 10-M6 according to a sixth modification of the first embodiment of the present technology. Fig. 46B is a cross-sectional view (Part 2) of the surface emitting laser 10-M6 according to the sixth modification of the first embodiment of the present technology.

As illustrated in Figs. 46A and 46B, the surface emitting laser 10-M6 has a configuration similar to that of any of the surface emitting lasers 10-1 to 10-11 according to Examples 1 to 11 of the first embodiment except that the cathode electrode 109 is provided on the back surface (lower surface) of the substrate 101.

### (Surface Emitting Laser according to Seventh Modification of First Embodiment of Present Technology)

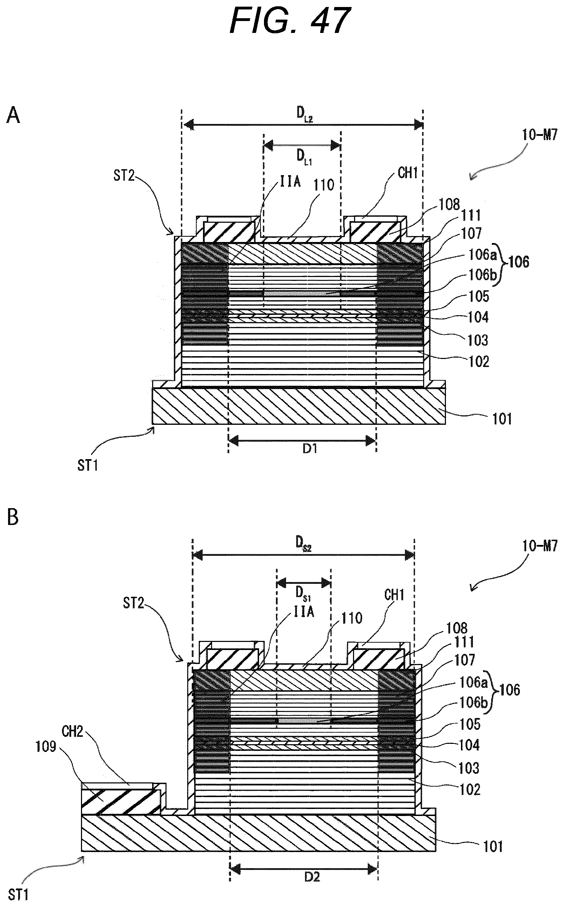

Fig. 47A is a cross-sectional view (Part 1) of a surface emitting laser 10-M7 according to a seventh modification of the first embodiment of the present technology. Fig. 47B is a cross-sectional view (Part 2) of the surface emitting laser 10-M7 according to the seventh modification of the first embodiment of the present technology.

As illustrated in Figs. 47A and 47B, the surface emitting laser 10-M7 has a configuration similar to that of any of the surface emitting lasers 10-1 to 10-11 according to Examples 1 to 11 of the first embodiment except that the ion implantation region IIA as a high resistance region is provided in the second structure ST2 similarly to the surface emitting laser 20-3 according to Example 3 of the second embodiment.

Also in the surface emitting laser 10-M7, the ratio of the length D1 in the longitudinal direction to the length D2 in the lateral direction of the inner edge of the ion implantation region IIA is preferably more than 1.00 and 1.10 or less.

### (Surface Emitting Laser according to Eighth Modification of First Embodiment of Present Technology)

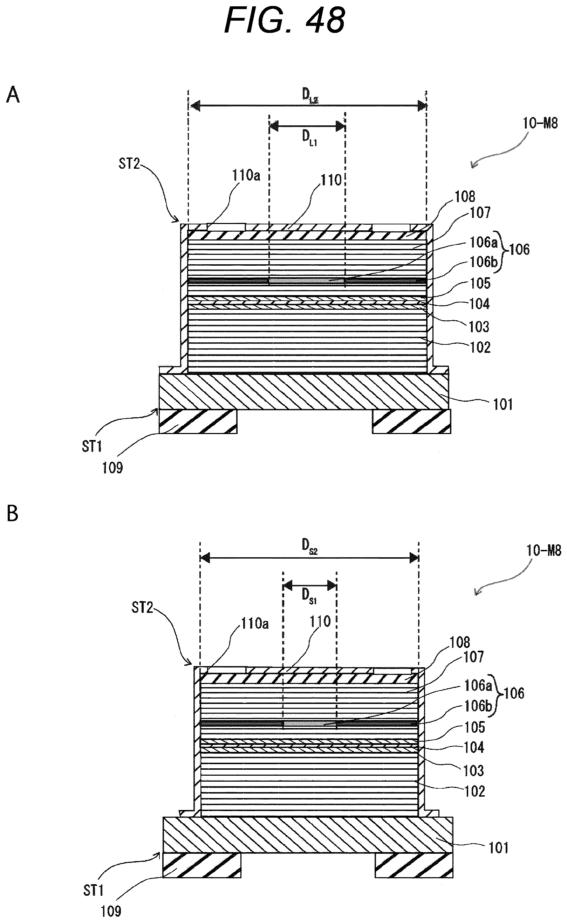

Fig. 48A is a cross-sectional view (Part 1) of a surface emitting laser 10-M8 according to an eighth modification of the first embodiment of the present technology. Fig. 48B is a cross-sectional view (Part 2) of the surface emitting laser 10-M8 according to the eighth modification of the first embodiment of the present technology.

As illustrated in Figs. 48A and 48B, the surface emitting laser 10-M8 has a configuration similar to that of any of the surface emitting lasers 10-1 to 10-11 according to Examples 1 to 11 of the first embodiment except that the anode electrode 108 is provided in a solid shape on the second structure ST2, the cathode electrode 109 is provided in a ring form on the back surface (lower surface) of the substrate 101, and the contact layer 111 is not provided.

In the surface emitting laser 10-M8, the reflectivity of the second reflector 107 is set to be slightly greater than the reflectivity of the first reflector 102. That is, the surface emitting laser 10-M8 is a back-surface emitting type of surface emitting laser that emits light to the back surface side (lower surface side) of the substrate 101. Note that, in the surface emitting laser 10-M8, a highly doped semiconductor layer (for example, a highly doped GaAs layer) as a contact layer may be disposed between the second reflector 107 and the anode electrode 108 and/or between the substrate 101 and the cathode electrode.

### (Surface Emitting Laser Array according to Ninth Modification of First Embodiment of Present Technology)

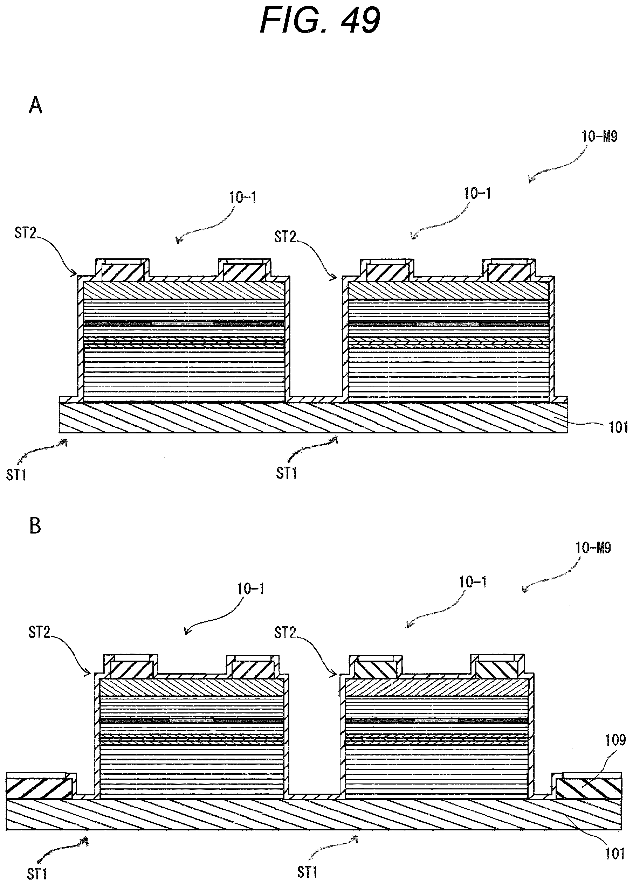

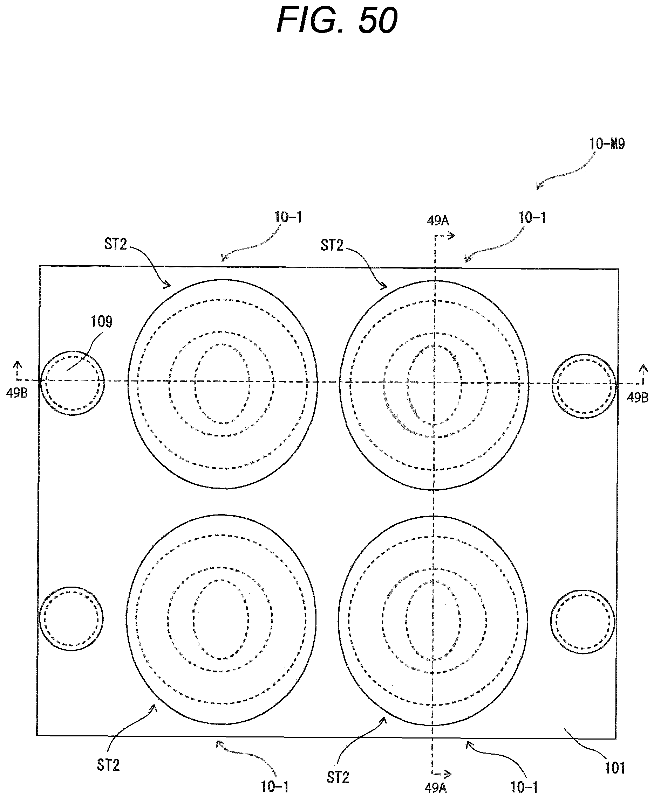

Fig. 49A is a cross-sectional view (Part 1) of a surface emitting laser array 10-M9 according to a ninth modification of the first embodiment of the present technology. Fig. 49B is a cross-sectional view (Part 2) of the surface emitting laser array 10-M9 according to the ninth modification of the first embodiment of the present technology. Fig. 50 is a plan view of the surface emitting laser array 10-M9 according to the ninth modification of the first embodiment of the present technology. Fig. 49A is a cross-sectional view taken along line 49A-49A in Fig. 50. Fig. 49B is a cross-sectional view taken along line 49B-49B in Fig. 50.

As illustrated in Figs. 49A, 49B, and 50, the surface emitting laser array 10-M9 includes a plurality of (for example, four) surface emitting lasers 10-1 arranged in a two-dimensional array (for example, matrix arrangement). In the surface emitting laser array 10-M9, the first structure ST1 of each of the surface emitting lasers 10-1 shares the substrate 101.

The number and arrangement of the surface emitting lasers 10-1 in the surface emitting laser array 10-M9 can be appropriately changed. For example, the number of surface emitting lasers 10-1 may be 2, 3, or 5 or more. The arrangement of the plurality of surface emitting lasers 10-1 may be one-dimensional arrangement. A plurality of surface emitting lasers 10-2 to 10-11 and 10-M1 to 10-M8 may be arranged one-dimensionally or two-dimensionally to form the surface emitting laser array.

### (Surface Emitting Laser according to First Modification of Second Embodiment of Present Technology)

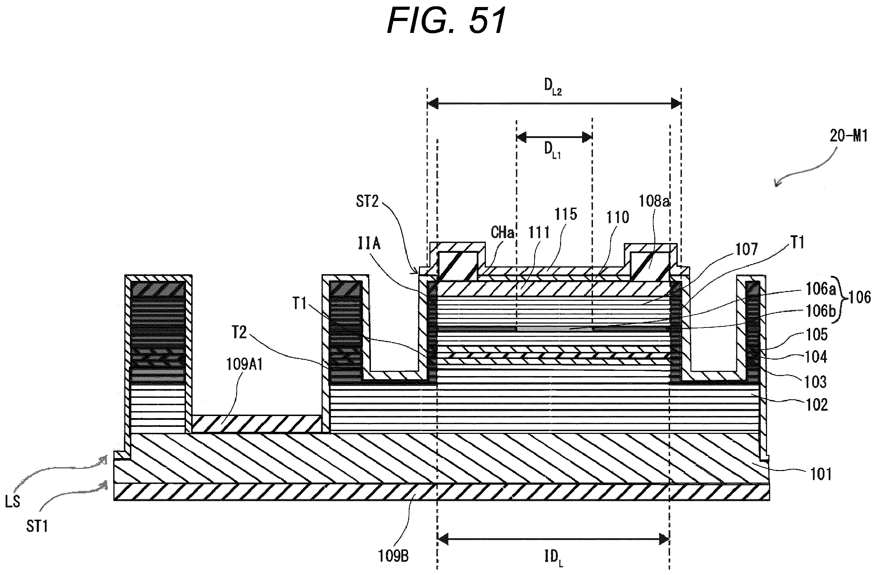

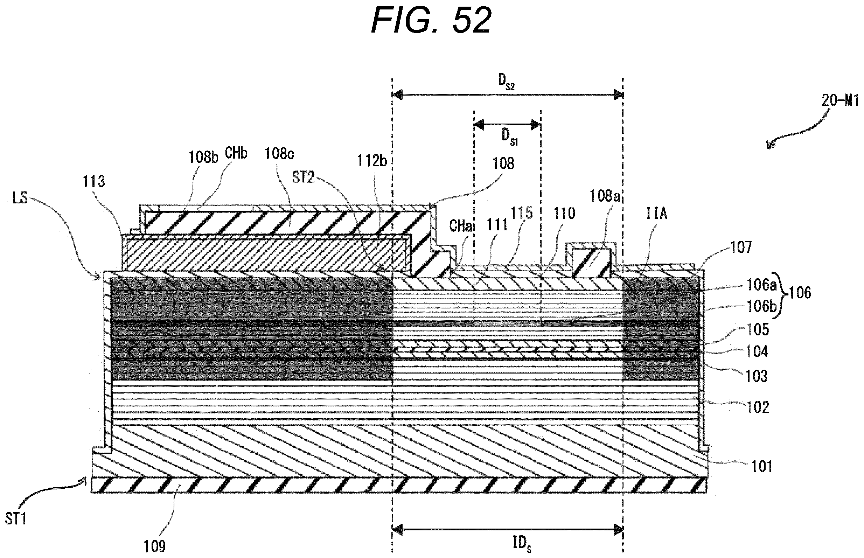

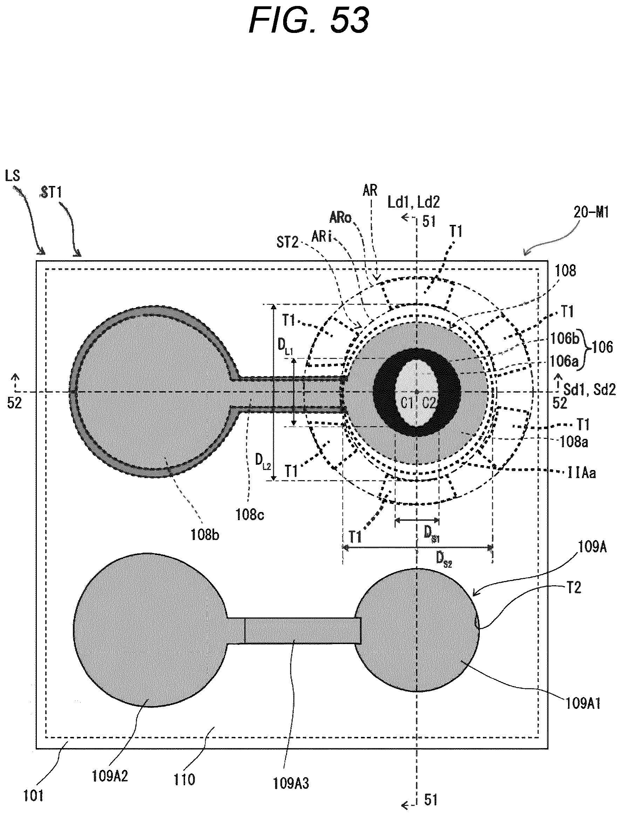

Fig. 51 is a cross-sectional view (Part 1) of a surface emitting laser 20-M1 according to a first modification of the second embodiment of the present technology. Fig. 52 is a cross-sectional view (Part 2) of the surface emitting laser 20-M1 according to the first modification of the second embodiment of the present technology. Fig. 53 is a plan view of the surface emitting laser 20-M1 according to the first modification of the second embodiment of the present technology. Fig. 51 is a cross-sectional view taken along line 51-51 in Fig. 53. Fig. 52 is a cross-sectional view taken along line 52-52 in Fig. 53.

### <<Configuration of Surface Emitting Laser>>

As illustrated in Figs. 51 to 53, the surface emitting laser 20-M1 has a configuration substantially similar to that of the surface emitting laser 20-3 according to Example 3 of the second embodiment except that the second structure ST2 is not a mesa structure.

In the surface emitting laser 20-M1, as illustrated in Fig. 53, a plurality of (for example, six) trenches T1 (grooves) is provided to be separated (for example, at substantially equal intervals) along the outer periphery of the second structure ST2 having an elliptical shape in plan view, for example. Each trench T1 exists in an arc shape in an annular virtual region AR (an annular virtual region surrounded by a two-dot chain line in Fig. 53) existing on the outer peripheral side of the second structure ST2 in plan view. The inner peripheral surface of each trench T1 constitutes a part of the outer peripheral surface of the second structure ST2. Note that the number and shape of the trenches T1 can be changed as appropriate.

In the surface emitting laser 20-M1, two trenches T1 are provided so as to sandwich the second structure ST2 in the longitudinal direction Ld2 (see Figs. 51 and 53). That is, the length D_{L2} of the second structure ST2 in the longitudinal direction Ld2 is defined by the inner peripheral surfaces of two trenches T1 facing each other in the longitudinal direction Ld2. Moreover, in the surface emitting laser 20-M1, two trenches T1 are provided so as to sandwich the second structure ST2 in each of two directions intersecting both the longitudinal direction Ld2 and the lateral direction Sd2 and intersecting each other (see Fig. 53).

The inner edge IIAa of the ion implantation region IIA has, for example, an elliptical shape in plan view. In the inner edge IIAa, the major axis direction coincides with the longitudinal direction Ld2, and the minor axis direction coincides with the lateral direction Sd2. A ratio of the major axis length ID_{L} to the minor axis length ID_{S} (= D_{S2}) of the inner edge IIAa is preferably more than 1.00 and 1.10 or less. The ion implantation region IIA has a refractive index lower than that of a region on the inner diameter side (non-ion implantation region), and has an optical confinement effect. Since the inner edge IIAa of the ion implantation region IIA has shape anisotropy in the longitudinal direction and the lateral direction in plan view, anisotropy occurs in the refractive index distribution, and the lateral mode can be further stabilized. Examples of the ion species used for the ion implantation region IIA include H and B.

In the surface emitting laser 20-M1, the length D_{S2} of the second structure ST2 in the lateral direction Sd2 is defined by the inner edge IIAa of the ion implantation region IIA (see Figs. 52 and 53). That is, the length D_{S2} of the second structure ST2 in the lateral direction Sd2 coincides with the minor axis length ID_{S} of the inner edge IIAa of the ion implantation region IIA.

In the surface emitting laser 20-M1, the first ratio r1 (D_{L1}/D_{S1}) and the second ratio rr2 (D_{L2}/Dₛ₂) preferably have values similar to those of the surface emitting laser 10-1 according to Example 1 of the first embodiment.

A ratio ro of the major axis length to the minor axis length of an outer edge ARo of the annular region AR is preferably more than 1.00 and 1.10 or less.

A ratio ri of the major axis length to the minor axis length of an inner edge ARi of the annular region AR is preferably 1.05 or more and 1.50 or less.

In particular, it is preferable that ri > ro. Therefore, in the second structure ST2, different stresses are generated in the longitudinal direction and the lateral direction (specifically, larger stress is generated in the longitudinal direction than in the lateral direction), and the effect of promoting the asymmetry of the oxidation constriction layer 106 can be obtained.

Here, in each trench T1, the first portion 112a of the low dielectric constant region 112A may not be provided (see Fig. 51), but may be provided. The second portion 112b of the low dielectric constant region 112A does not have a circling portion (see Fig. 52), but may have a circling portion.

### <<Method for Manufacturing Surface Emitting Laser>>

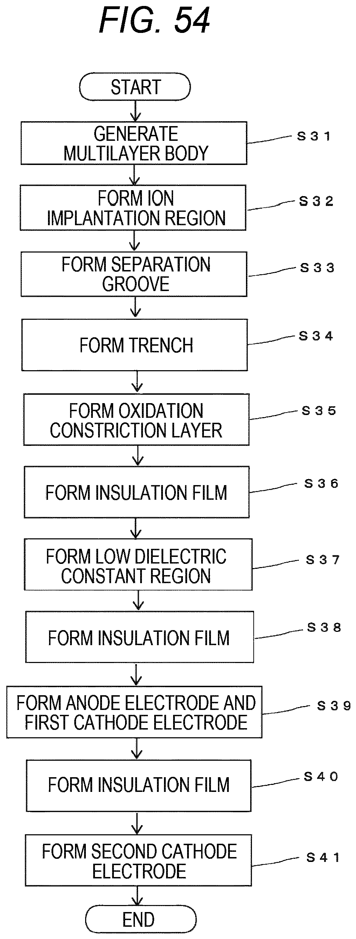

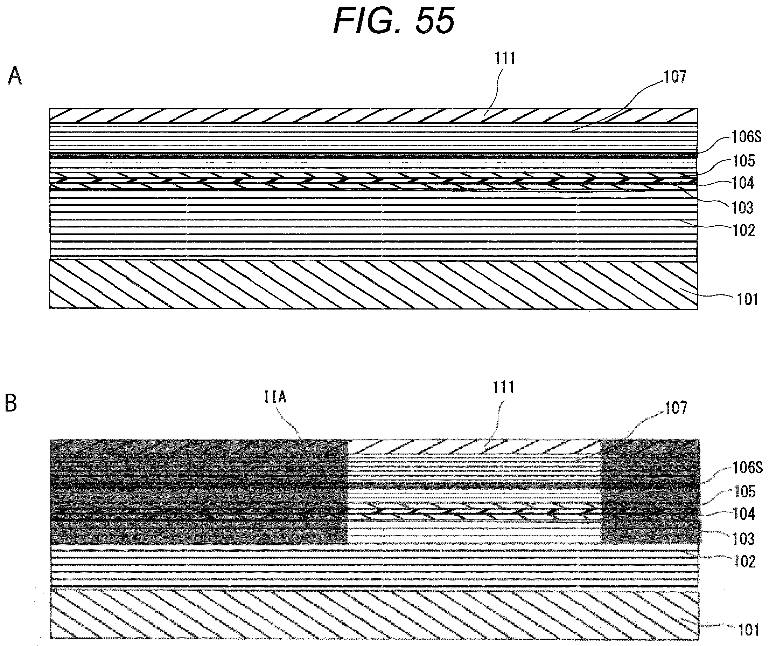

Hereinafter, a method for manufacturing the surface emitting laser 20-M1 will be described with reference to the flowchart of Fig. 54 and the cross-sectional views of Figs. 55A to 60B. Figs. 55A to 60B are cross-sectional views corresponding to a cross section taken along line 51-51 in Fig. 53.

Here, as an example, multiple surface emitting lasers 20-M1 are simultaneously generated on one wafer (hereinafter also referred to as a "substrate 101" for convenience) which is a base material of the substrate 101 by a semiconductor manufacturing method using a semiconductor manufacturing apparatus. Next, the multiple continuous and integrated surface emitting lasers 20-M1 are separated from each other to obtain multiple chip-shaped surface emitting lasers 20-M1.

In the first step S31, a multilayer body is generated (see Fig. 55A). Specifically, for example, the first reflector 102, the first cladding layer 103, the active layer 104, the second cladding layer 105, the second reflector 107 in which an oxidized layer 106S (for example, an AlAs layer or an AlGaAs layer) which is a material of the oxidation constriction layer 106 is disposed, and the contact layer 111 are stacked in this order (for example, epitaxially grown at a growth temperature of 605°C) on the substrate 101 (for example, an n-GaAs substrate) as a growth substrate by a metal organic chemical vapor deposition (MOCVD) method to generate a multilayer body. Note that, when the MOCVD is performed, for example, trimethylgallium ((CH₃)₃Ga) is used as a source gas of gallium, for example, trimethylaluminum ((CH₃)₃Al) is used as a source gas of aluminum, for example, trimethylindium ((CH₃)₃In) is used as a source gas of indium, and for example, trimethylarsenic (((CH₃)₃As) is used as a source gas of As. Furthermore, as a source gas of silicon, for example, monosilane (SiH₄) is used, and as a source gas of carbon, for example, carbon tetrabromide (CBr₄) is used.

In the next step S32, the ion implantation region IIA is formed (see Fig. 55B). Specifically, a resist pattern covering a region other than a region where the ion implantation region IIA is to be formed on the upper surface (front surface on the contact layer 111 side) of the multilayer body is formed, and ion implantation is performed using the resist pattern as a mask. The implantation depth of the ion implantation at this time is set to a level, for example, until the ions reach the inside of the first reflector 102.

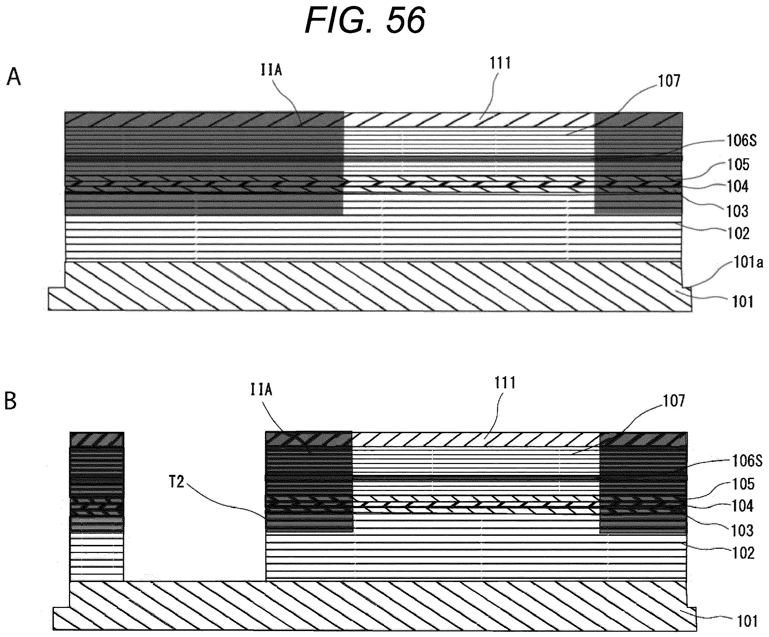

In the next step S33, the separation groove 101a is formed (see Fig. 56A). The separation groove 101a is a groove for separating adjacent surface emitting lasers 20-M1 generated on the wafer by dicing. First, a resist pattern that covers a portion other than a portion where the separation groove 101a is to be formed on the upper surface of the multilayer body is formed by photolithography. Next, using the resist pattern as a mask, the multilayer body is etched by inductively coupled plasma (ICP) dry etching using, for example, Cl₂, SiCl₄, or Ar. The etching depth at this time is set to a level until the etching bottom surface is positioned in the substrate 101. Thereafter, the resist pattern is removed by etching.

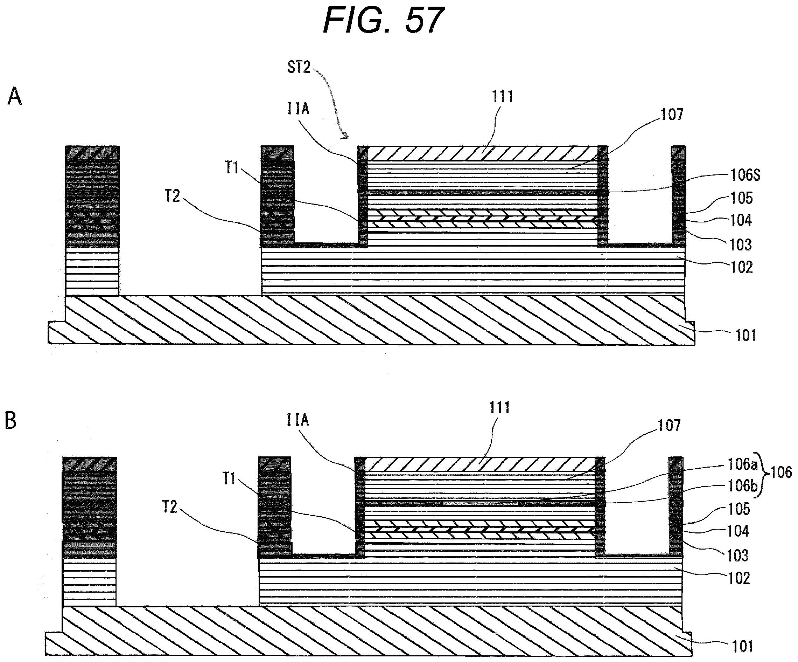

In the next step S34, the trenches T1 and T2 are formed. Specifically, first, the resist pattern that covers a portion other than a portion where the trench T2 is to be formed on the upper surface of the multilayer body is formed by photolithography. Next, using the resist pattern as a mask, the multilayer body is etched by inductively coupled plasma (ICP) dry etching using, for example, Cl₂, SiCl₄, or Ar until the etching bottom surface reaches the upper surface of the substrate 101 to form a trench T2 having a circular shape in plan view. Next, the resist pattern is removed (see Fig. 56B). Next, a resist pattern that covers a portion other than a portion where the trench T1 is to be formed on the upper surface of the multilayer body is formed by photolithography. Next, using the resist pattern as a mask, the multilayer body is etched by inductively coupled plasma (ICP) dry etching using, for example, Cl₂, SiCl₄, or Ar until the etching bottom surface is positioned in the first reflector 102, and a plurality of (for example, six) trenches T1 having an arc shape in plan view is formed. As a result, the second structure ST2 having an elliptical shape (for example, an elliptical shape having a major axis length of 22 µm and a minor axis length of 20 µm) in plan view in which the inner peripheral surface of each trench T1 is a part of the outer peripheral surface is formed. Next, the resist pattern is removed (see Fig. 57A). Note that the trench T2 may be formed after each trench T1 is formed.

In the next step S35, the oxidation constriction layer 106 as an optical confinement layer is formed (see Fig. 57B). Specifically, the second structure ST2 having an elliptical shape in plan view formed in step S34 is exposed to a high-temperature water vapor atmosphere, and the oxidized layer 106S is oxidized by a predetermined distance (for example, 6.75 µm) from the outer peripheral side toward the center side. As a result, the oxidation constriction layer 106 in which the non-oxidized region having an elliptical shape (for example, an elliptical shape having a major axis length of 8.5 µm and a minor axis length of 6.5 µm) in plan view as the high refractive index region 106a is surrounded by the oxidized region as the low refractive index region 106b is formed.

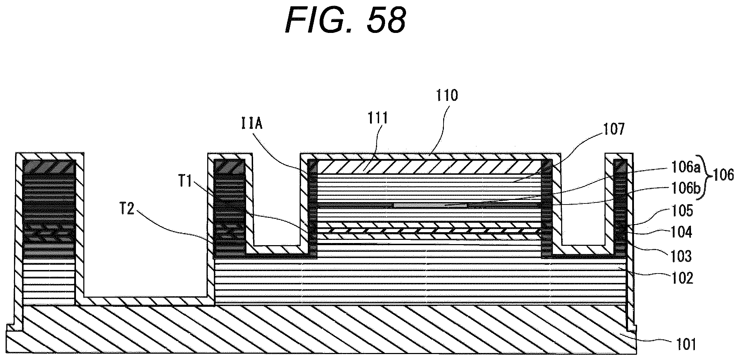

In the next step S36, a thin insulation film 110 is formed on the entire surface (see Fig. 58).

In the next step S37, the second portion 112b of the low dielectric constant region 112A is formed (see Fig. 52). Specifically, first, a thick film of BCB, which is a low dielectric constant material, is formed on the entire surface. Next, unnecessary portions of the BCB film are removed by photolithography and etching. As a result, the second portion 112b is formed.

In the next step S38, the insulation film 113 is formed (see Fig. 52). Specifically, first, the insulation film 113 is formed on the entire surface. Next, the insulation film 113 other than the insulation film 113 covering the second portion 112b of the low dielectric constant region 112A is removed by photolithography and etching.

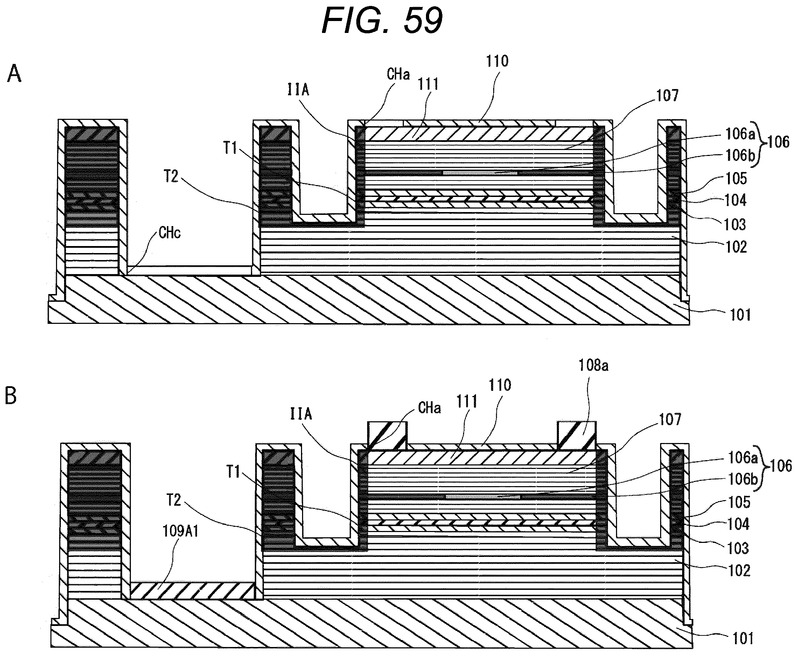

In the next step S39, the anode electrode 108 and the first cathode electrode 109A1 are formed. Specifically, first, a part of the insulation film 110 is removed by photolithography and etching to form a ring-shaped contact hole CHa in plan view and a contact hole CHc for installing the first cathode electrode 109A1 (see Fig. 59A). Next, for example, by a lift-off method, the anode electrode 108 is formed in the contact hole CHa such that the electrode portion 108a has a ring shape (for example, an inner diameter is 12.6 µm and an outer diameter is 18.0 µm), and the first cathode electrode 109A1 is formed in the contact hole CHc (see Fig. 59B). For forming the electrode materials of the anode electrode 108 and the first cathode electrode 109A1, for example, vacuum vapor deposition, sputtering, or the like is used.

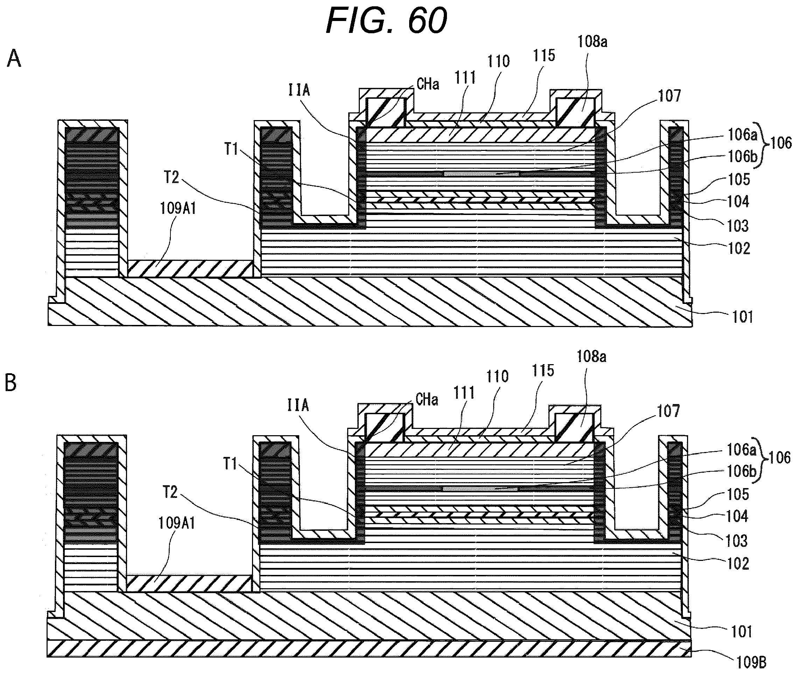

In the next step S40, the insulation film 115 is formed (see Fig. 60A). Specifically, first, the insulation film 115 is formed on the entire surface. Next, at least the insulation film 115 covering the pad 108b of the anode electrode 108 and the insulation film 115 covering the pad 109A2 of the first cathode electrode 109A are removed by photolithography and etching (see Fig. 53).

In the next step S41, the second cathode electrode 109B is formed (see Fig. 60B). Specifically, the second cathode electrode 109B is formed in a solid shape on the back surface of the substrate 101 by, for example, a lift-off method. At this time, for example, vacuum deposition, sputtering, or the like is used to form a film of the electrode material of the second cathode electrode 109B.

<<Effects of Surface Emitting Laser>>

According to the surface emitting laser 20-M1, the effects substantially similar to those of the surface emitting laser 20-3 according to Example 3 of the second embodiment can be obtained.

Note that, in the surface emitting laser 20-M1, the length D_{L2} in the longitudinal direction Ld2 of the second structure ST2 may be defined by the inner edge IIAa of the ion implantation region IIA, and the length D_{S2} in the lateral direction Sd2 of the second structure ST2 may be defined by the inner peripheral surfaces of the two trenches T1 facing each other.

In the surface emitting laser 20-M1, each of the length D_{L2} in the longitudinal direction Ld2 and the length D_{S2} in the lateral direction Sd2 of the second structure ST2 may be defined by the inner peripheral surfaces of the two trenches T1 facing each other. In this case, the ion implantation region IIA may not be provided.

### (Surface Emitting Laser according to Second Modification of Second Embodiment of Present Technology)

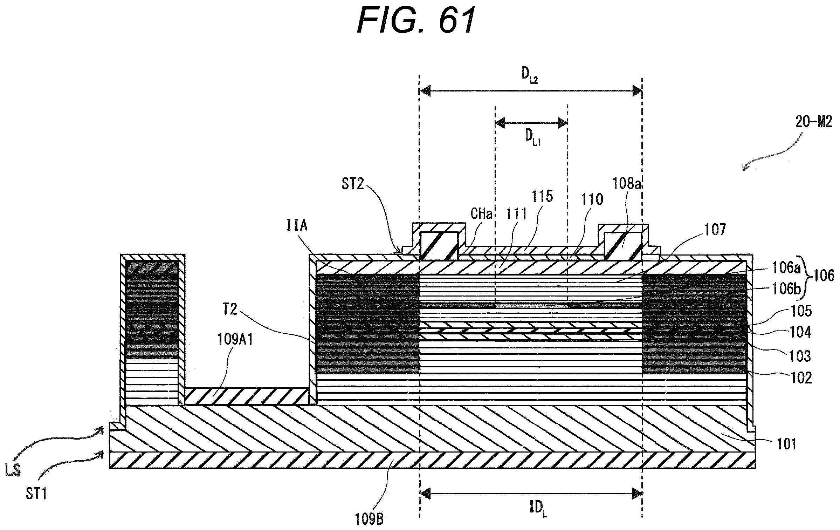

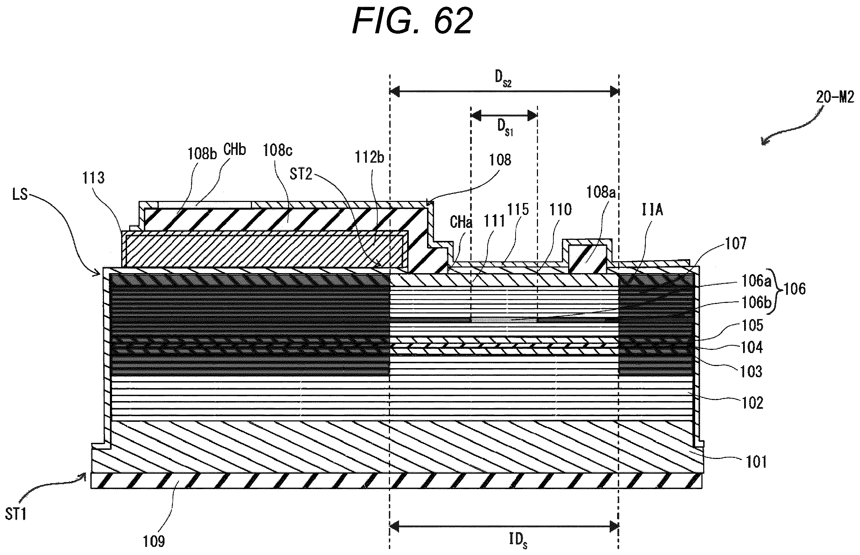

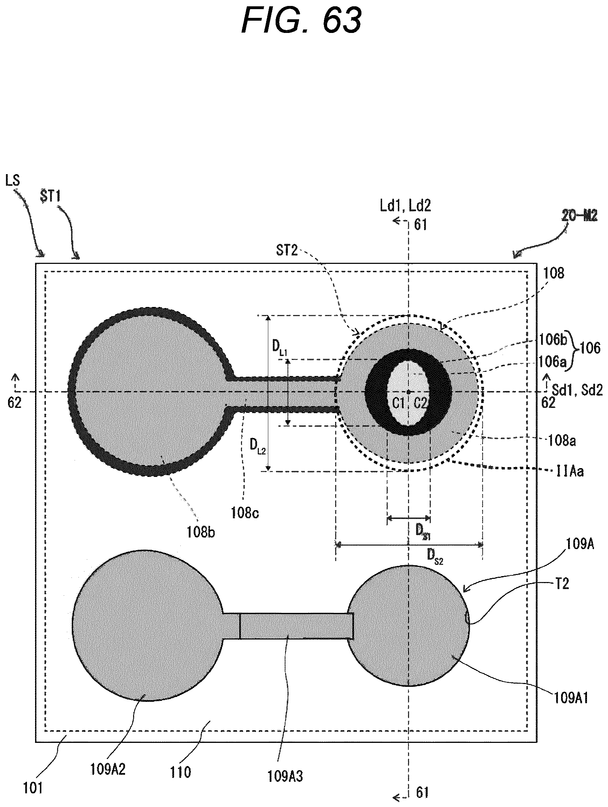

Fig. 61 is a cross-sectional view (Part 1) of a surface emitting laser 20-M2 according to the second modification of the second embodiment of the present technology. Fig. 62 is a cross-sectional view (Part 2) of the surface emitting laser 20-M2 according to the second modification of the second embodiment of the present technology. Fig. 63 is a plan view of the surface emitting laser 20-M2 according to the second modification of the second embodiment of the present technology. Fig. 61 is a cross-sectional view taken along line 61-61 in Fig. 63. Fig. 62 is a cross-sectional view taken along line 62-62 in Fig. 63.

As illustrated in Figs. 61 to 63, the surface emitting laser 20-M2 has substantially a configuration similar to that of the surface emitting laser 20-M1 according to the first modification of the second embodiment except that the trench T1 (groove) is not provided.

In the surface emitting laser 20-M2, the length D_{L2} in the longitudinal direction Ld2 and the length D_{S2} in the lateral direction Sd2 of the second structure ST2 are defined by the inner edge IIAa of the ion implantation region IIA (see Figs. 61, 62, and 63). That is, the length D_{L2} of the second structure ST2 in the longitudinal direction Ld2 coincides with the major axis length ID_{L} of the inner edge IIAa of the ion implantation region IIA. The length D_{S2} of the second structure ST2 in the lateral direction Sd2 coincides with the minor axis length ID_{S} of the inner edge IIAa of the ion implantation region IIA.

In the surface emitting laser 20-M2, the first ratio r1 (D_{L1}/D_{S1}) and the second ratio rr2 (D_{L2}/D_{S2}) preferably have values similar to those of the surface emitting laser 10-1 according to Example 1 of the first embodiment.

The surface emitting laser 20-M2 can be manufactured by a manufacturing method similar to the method for manufacturing the surface emitting laser 20-M1 according to the first modification except that the trench T1 is not formed.

According to the surface emitting laser 20-M2, the effect substantially similar to that of the surface emitting laser 20-M1 according to the first modification can be obtained.

### (Surface Emitting Laser according to Third Modification of Second Embodiment of Present Technology)

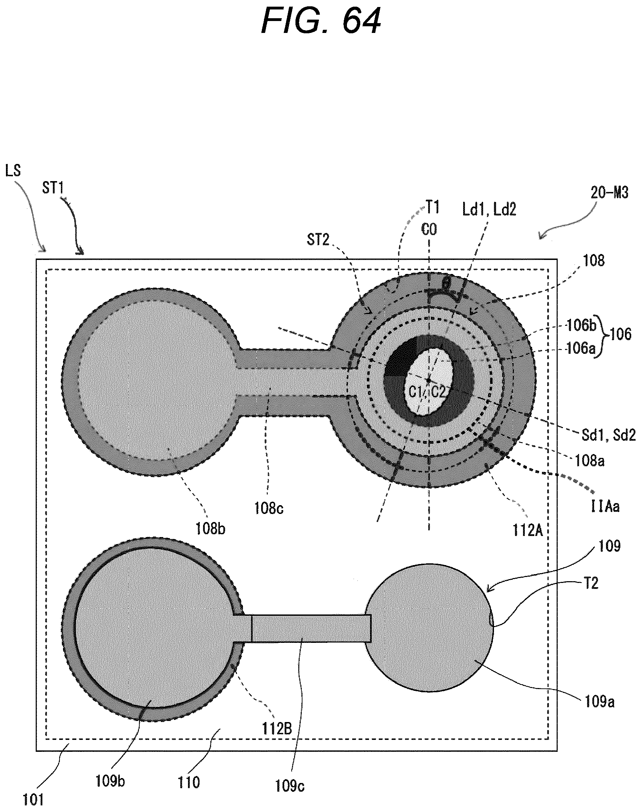

Fig. 64 is a plan view of a surface emitting laser 20-M3 according to a third modification of the second embodiment of the present technology.

As illustrated in Fig. 64, the surface emitting laser 20-M3 has a configuration similar to that of the surface emitting laser 20-3 according to Example 3 of the second embodiment except that the longitudinal direction and the lateral direction of the second structure ST2 do not coincide with a crystal orientation CO of the substrate 101 in plan view.

In the surface emitting laser 20-M3, in plan view, the longitudinal direction Ld2 of the mesa structure as the second structure ST2 and the longitudinal direction Ld1 of the high refractive index region 106a are rotated (inclined) by an angle θ (0 < θ ≤ 90°) with respect to the crystal orientation CO of the substrate 101. In other words, in the surface emitting laser 20-M3, the lateral direction Sd2 of the mesa structure as the second structure ST2 and the lateral direction Sd1 of the high refractive index region 106a are rotated (inclined) by an angle (90° - θ) with respect to the crystal orientation CO of the substrate 101 in plan view.

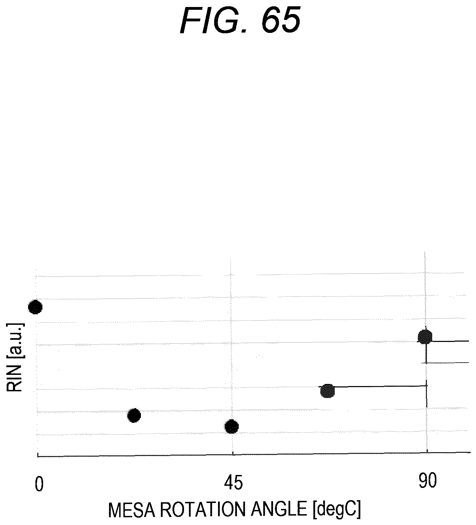

Fig. 65 is a graph illustrating a relationship between a mesa rotation angle (θ), which is a rotation angle with respect to the crystal orientation CO, of the mesa structure as the second structure ST2 and relative intensity noise (RIN) in plan view. As can be seen from Fig. 65, RIN is smaller in a case where the mesa rotation angle (θ) is larger than 0° in the range of 0° to 90° than a case where the mesa rotation angle (θ) is 0° (minimum at 45°). Therefore, in the surface emitting laser 20-M3, since 0 < θ ≤ 90°, RIN can be made smaller than that in the case of θ = 0.

Furthermore, in the surface emitting lasers 20-1 and 20-2 according to Examples 1 and 2 of the second embodiment and the surface emitting lasers 20-M1 and 20-M2 according to the first and second modifications of the second embodiment, 0 < θ ≤ 90° may be set similarly to the surface emitting laser 20-M3. Therefore, RIN can be reduced.

### (Other Modifications of Present Technology)

The present technology may also include modifications as follows.

For example, the surface emitting laser according to the present technology is a GaAs-based surface emitting laser, but in short, a group III-V compound mainconductor can be used as a material. For example, the present technology can also be applied to an InP-based surface emitting laser and a GaN-based surface emitting laser.

The optical confinement layer of the surface emitting laser according to the present technology is not limited to the oxidation constriction layer, and for example, it is possible to use a general layer in which a high refractive index region such as a buried tunnel junction (BTJ) or a layer in which a semiconductor is surrounded by a dielectric (for example, SiO₂) having a refractive index lower than that of the semiconductor is surrounded by a low refractive index region.

The high resistance region of the surface emitting laser according to the present technology is not limited to the ion implantation region, and may be, for example, a QWI, a buried tunnel junction, or the like that provides a bandgap energy difference between the inside and the outside of the aperture by Ga hole diffusion to confine carriers.

The material of the low dielectric constant region of the surface emitting laser according to the present technology is not limited to BCB, and may be polyimide or the like.

For example, at least one of the first and second reflectors of the surface emitting laser according to the present technology may include multiple constituent layers including different materials and stacked on each other. Specifically, the first and second reflectors may be a hybrid mirror including a semiconductor multilayer film reflector and a dielectric multilayer film reflector, a hybrid mirror including a semiconductor multilayer film reflector and a metal reflector, a hybrid mirror including a dielectric multilayer film reflector and a metal reflector, or a hybrid mirror including a semiconductor multilayer film reflector, a dielectric multilayer film reflector, and a metal reflector.

For example, the substrate 101 may be a Si substrate, a Ge substrate, a GaN substrate, an InP substrate, or the like. In any case, the semiconductor layer stacked on the substrate 101 is preferably appropriately selected so as to be lattice-matched with the material of the substrate 101. The surface emitting laser according to the present technology can use a material having any oscillation wavelength included in the wavelength band of 200 to 2000 nm.

In the surface emitting laser according to each of the above examples and modifications, the contact layer 111 is not essential.

The conductivity types (n-type and p-type) of the first and second structures ST1 and ST2 of the surface emitting lasers of the above examples and modifications may be interchanged.

Some of the configurations of the surface emitting lasers of the examples and modifications described above may be combined within a range in which they do not contradict each other.

In each example and each modification described above, the material, conductivity type, thickness, width, numerical value, shape, size, and the like of each layer constituting the surface emitting laser can be appropriately changed within a range functioning as the surface emitting laser.

Furthermore, the present technology may also adopt the following configurations.
(1) A surface emitting laser including:
   a first structure including a substrate; and
   a second structure provided on the first structure, in which
   the second structure includes:
      at least a part of a first reflector;
      a second reflector stacked with the first reflector;
      an active layer disposed between the first and second reflectors; and
      an optical confinement layer disposed between a surface of the first reflector on a side opposite to the active layer side and the active layer and/or between a surface of the second reflector on a side opposite to the active layer side and the active layer,
      the optical confinement layer has a high refractive index region having a relatively high refractive index and a low refractive index region having a relatively low refractive index and surrounding the high refractive index region,
      each of the second structure and the high refractive index region has a longitudinal direction and a lateral direction in plan view,
      a first ratio that is a ratio of a length in a longitudinal direction to a length in a lateral direction of the high refractive index region and a second ratio that is a ratio of a length in a longitudinal direction to a length in a lateral direction of the second structure are both more than 1.00 and less than 2.00, and
      the first ratio is larger than the second ratio.
(2) The surface emitting laser according to (1), in which the first ratio is 1.75 or less.
(3) The surface emitting laser according to (1) or (2), in which the first ratio is 1.15 or more.
(4) The surface emitting laser according to any one of (1) to (3), in which the first ratio is 1.15 or more and 1.75 or less.
(5) The surface emitting laser according to any one of (1) to (4), in which the second ratio is 1.50 or less.
(6) The surface emitting laser according to any one of (1) to (5), in which the second ratio is 1.05 or more.
(7) The surface emitting laser according to any one of (1) to (6), in which the second ratio is 1.05 or more and 1.50 or less.
(8) The surface emitting laser according to any one of (1) to (7), in which the high refractive index region has a symmetrical shape with respect to each of a longitudinal direction and a lateral direction of the high refractive index region in plan view.
(9) The surface emitting laser according to any one of (1) to (8), in which the second structure has a symmetrical shape with respect to each of a longitudinal direction and a lateral direction of the second structure in plan view.
(10) The surface emitting laser according to any one of (1) to (9), in which a longitudinal direction or a lateral direction of the second structure is parallel to a crystal orientation <0 1 -1> of the substrate.
(11) The surface emitting laser according to any one of (1) to (10), in which area centroids of the second structure and the high refractive index region do not coincide with each other.
(12) The surface emitting laser according to any one of (1) to (11), in which a first shift amount that is a shift amount of area centroids of the second structure and the high refractive index region in a longitudinal direction of the second structure is larger than a second shift amount that is a shift amount of area centroids of the second structure and the high refractive index region in the lateral direction of the second structure.
(13) The surface emitting laser according to (12), in which the first shift amount is 0.20 µm or more, and the second shift amount is 0.10 µm or less.
(14) The surface emitting laser according to any one of (1) to (13), in which a cross section of the second structure does not have a straight line portion and/or a top portion.
(15) The surface emitting laser according to any one of (1) to (14), in which an angle formed by the second structure and the high refractive index region in a longitudinal direction in plan view is 10° or less.
(16) The surface emitting laser according to any one of (1) to (15), in which a high resistance region surrounding the high refractive index region is provided in the second structure and/or the first structure.
(17) An inner edge of the high resistance region may have a longitudinal direction and a lateral direction in plan view, and a ratio of a length in a longitudinal direction to a length in a lateral direction of the inner edge may be more than 1.00 and 1.10 or less.
(18) The surface emitting laser according to any one of (1) to (17), further including: a low dielectric constant region surrounding the second structure.
(19) The surface emitting laser according to (18), in which the low dielectric constant region includes: a circumferential-shaped first portion surrounding the second structure; and a second portion having a circling portion disposed on the second structure, an inner edge of the circling portion has a longitudinal direction and a lateral direction in plan view, and a ratio of a length in a longitudinal direction to a length in a lateral direction of the inner edge is more than 1.00 and 1.10 or less.
(20) The surface emitting laser according to any one of (1) to (19), in which the optical confinement layer is an oxidation constriction layer.
(21) The surface emitting laser according to any one of (1) to (20), in which the second structure is a mesa structure.
(22) The surface emitting laser according to any one of (1) to (20), in which each of the first and second structures is a part of a stacked structure, and a length in a longitudinal direction and/or a length in a lateral direction of the second structure is defined by a plurality of grooves provided in the stacked structure.
(23) The surface emitting laser according to any one of (1) to (20), in which each of the first and second structures is a part of a stacked structure, and a length in a longitudinal direction and/or a length in a lateral direction of the second structure is defined by an inner edge of an ion implantation region provided in the stacked structure.
(24) The surface emitting laser according to any one of (1) to (23), in which a longitudinal direction and a lateral direction of the second structure do not coincide with a crystal orientation of the substrate in plan view.
(25) A surface emitting laser array including a plurality of the surface emitting lasers according to any one of (1) to (24).
(26) An electronic device including the surface emitting laser according to any one of (1) to (24).
(27) An electronic device including the surface emitting laser array according to (25).

### REFERENCE SIGNS LIST

10-1 to 10-11, 20-1 to 20-3, 10-M1 to 10-M8 Surface emitting laser
101 Substrate
102 First reflector
104 Active layer
106 Oxidation constriction layer (optical confinement layer)
106a High refractive index region
106b Low refractive index region
107 Second reflector
108 Anode electrode
109 Cathode electrode
112 Low dielectric constant region
ST1 First structure
ST2 Second structure
D_{L1} Length of high refractive index region in longitudinal direction
D_{S1} Length of high refractive index region in lateral direction
D_{L2} Length in longitudinal direction of second structure ST2
D_{S2} Length in lateral direction of second structure ST2
IIA Ion implantation region (high resistance region)

## Claims

1. A surface emitting laser, comprising:
a first structure including a substrate; and
a second structure provided on the first structure, wherein
the second structure includes:
at least a part of a first reflector;
a second reflector stacked with the first reflector;
an active layer disposed between the first and second reflectors; and
an optical confinement layer disposed between a surface of the first reflector on a side opposite to the active layer side and the active layer and/or between a surface of the second reflector on a side opposite to the active layer side and the active layer,
the optical confinement layer has a high refractive index region having a relatively high refractive index and a low refractive index region having a relatively low refractive index and surrounding the high refractive index region,
each of the second structure and the high refractive index region has a longitudinal direction and a lateral direction in plan view,
a first ratio that is a ratio of a length in a longitudinal direction to a length in a lateral direction of the high refractive index region and a second ratio that is a ratio of a length in a longitudinal direction to a length in a lateral direction of the second structure are both more than 1.00 and less than 2.00, and
the first ratio is larger than the second ratio.

2. The surface emitting laser according to claim 1, wherein the first ratio is 1.75 or less.

3. The surface emitting laser according to claim 1, wherein the first ratio is 1.15 or more.

4. The surface emitting laser according to claim 1, wherein the first ratio is 1.15 or more and 1.75 or less.

5. The surface emitting laser according to claim 1, wherein the second ratio is 1.50 or less.

6. The surface emitting laser according to claim 1, wherein the second ratio is 1.05 or more.

7. The surface emitting laser according to claim 1, wherein the second ratio is 1.05 or more and 1.50 or less.

8. The surface emitting laser according to claim 1, wherein the high refractive index region has a symmetrical shape with respect to each of a longitudinal direction and a lateral direction of the high refractive index region in plan view.

9. The surface emitting laser according to claim 1, wherein the second structure has a symmetrical shape with respect to each of a longitudinal direction and a lateral direction of the second structure in plan view.

10. The surface emitting laser according to claim 1, wherein a longitudinal direction or a lateral direction of the second structure extends in a direction along a crystal orientation <0 1 -1> of the substrate.

11. The surface emitting laser according to claim 1, wherein area centroids of the second structure and the high refractive index region do not coincide with each other.

12. The surface emitting laser according to claim 11, wherein a first shift amount that is a shift amount of area centroids of the second structure and the high refractive index region in a longitudinal direction of the second structure is larger than a second shift amount that is a shift amount of area centroids of the second structure and the high refractive index region in the lateral direction of the second structure.

13. The surface emitting laser according to claim 12, wherein the first shift amount is 0.20 µm or more, and the second shift amount is 0.10 µm or less.

14. The surface emitting laser according to claim 1, wherein a cross section of the second structure does not have a straight line portion and/or a top portion.

15. The surface emitting laser according to claim 1, wherein an angle formed by the second structure and the high refractive index region in a longitudinal direction in plan view is 10° or less.

16. The surface emitting laser according to claim 1, wherein a high resistance region surrounding the high refractive index region is provided in the second structure and/or the first structure.

17. The surface emitting laser according to claim 16, wherein
an inner edge of the high resistance region has a longitudinal direction and a lateral direction in plan view, and
a ratio of a length in a longitudinal direction to a length in a lateral direction of the inner edge is more than 1.00 and 1.10 or less.

18. The surface emitting laser according to claim 1, further comprising: a low dielectric constant region surrounding the second structure.

19. The surface emitting laser according to claim 18, wherein
the low dielectric constant region includes:
a circumferential-shaped first portion surrounding the second structure; and
a second portion having a circling portion disposed on the second structure,
an inner edge of the circling portion has a longitudinal direction and a lateral direction in plan view, and
a ratio of a length in a longitudinal direction to a length in a lateral direction of the inner edge is more than 1.00 and 1.10 or less.

20. The surface emitting laser according to claim 1, wherein the optical confinement layer is an oxidation constriction layer.

21. The surface emitting laser according to claim 1, wherein each of the first and second structures is a part of a stacked structure, and a length in a longitudinal direction and/or a length in a lateral direction of the second structure is defined by a plurality of grooves provided in the stacked structure.

22. The surface emitting laser according to claim 1, wherein each of the first and second structures is a part of a stacked structure, and a length in a longitudinal direction and/or a length in a lateral direction of the second structure is defined by an inner edge of an ion implantation region provided in the stacked structure.

23. The surface emitting laser according to claim 1, wherein a longitudinal direction and a lateral direction of the second structure do not coincide with a crystal orientation of the substrate in plan view.
